# EUROPEAN PATENT APPLICATION

(11) **EP 4 404 709 A1**
(43) Date of publication of application: **24.07.2024**
(21) Application number: 23193863.0
(22) Date of filing: 29.08.2023
(51) Int. Cl.: H10B 12/00

(54) **SEMICONDUCTOR DEVICE**

(30) Priority: 17.01.2023 KR 20230006828
(71) Applicant: Samsung Electronics Co., Ltd., Suwon-si, Gyeonggi-do 16677 (KR)
(72) Inventor: LEE, Kiseok, Suwon-si, Gyeonggi-do 16677 (KR); KIM, Keunnam, Suwon-si, Gyeonggi-do 16677 (KR); KIM, Hui-Jung, Suwon-si, Gyeonggi-do 16677 (KR)
(74) Representative: Kuhnen & Wacker Patent- und Rechtsanwaltsbüro PartG mbB

(57) **Abstract**

A semiconductor device including: a device isolation part on a substrate to define first to fourth active regions, the device isolation part interposed between the first and second active regions and the third and fourth active regions; first and second word lines crossing the first and second active regions and adjacent to each other; a first impurity region in the first active region between the first and second word lines; a second impurity region in the first active region at one side of the first word line and spaced apart from the first impurity region; a first conductive pad contacting the first impurity region; a second conductive pad contacting the second impurity region; a bit line on the first conductive pad; a storage node contact on the second conductive pad; and a landing pad on the storage node contact.

## Description

### CROSS-REFERENCE TO RELATED APPLICATION

This U.S. non-provisional patent application claims priority under 35 U.S.C. § 119 to Korean Patent Application No. 10-2023-0006828, filed on January 17, 2023, in the Korean Intellectual Property Office, the disclosure of which is incorporated by reference herein in its entirety.

### Technical Field

The present disclosure relates to a semiconductor device.

### Discussion of Related Art

Semiconductor devices, due to their compact size, multifunctionality, and low-cost, are widely used in the electronics industry. However, as this industry has evolved, semiconductor devices have become highly integrated. Critical dimensions of semiconductor device patterns have been progressively reduced to achieve higher levels of integration. The creation of these fine patterns has necessitated the use of new and more expensive exposure techniques, making it challenging to further integrate the semiconductor devices. Thus, various research efforts are underway to develop new integration techniques.

### SUMMARY

An embodiment of the present disclosure provides a semiconductor device with improved reliability.

A semiconductor device according to some embodiments of the present disclosure includes a device isolation part disposed on a substrate to define first, second, third and fourth active regions sequentially arranged in a clockwise direction, the first to fourth active regions extending in a first direction, and the device isolation part extending in a second direction intersecting the first direction and being interposed between the first and second active regions and the third and fourth active regions; first and second word lines crossing the first and second active regions in the second direction and being adjacent to each other in a third direction intersecting the first and second directions; a first impurity region disposed in the first active region between the first and second word lines; a second impurity region disposed in the first active region at one side of the first word line and spaced apart from the first impurity region; a first conductive pad in contact with the first impurity region; a second conductive pad in contact with the second impurity region; a bit line disposed on the first conductive pad and extending in the third direction; a storage node contact structure disposed on the second conductive pad; and a landing pad disposed on the storage node contact structure.

A semiconductor device according to some embodiments of the present disclosure includes a device isolation part disposed on a substrate to define an active region, the active region being lengthwise in a first direction; first and second word lines crossing the active region in a second direction intersecting the first direction and being adjacent to each other in a third direction intersecting the first and second directions; a first impurity region disposed in the active region between the first and second word lines; a second impurity region disposed in the active region at one side of the first word line and spaced apart from the first impurity region; a first conductive pad in contact with the first impurity region; a second conductive pad in contact with the second impurity region; a bit line disposed on the first conductive pad and extending in the third direction; a storage node contact structure on the second conductive pad; and a landing pad on the storage node contact structure, wherein the storage node contact structure includes: a first contact contacting the second conductive pad and having a first width; and a second contact disposed on the first contact and having a second width greater than the first width.

A semiconductor device according to some embodiments of the present disclosure includes a device isolation part disposed on the substrate to define first, second, third and fourth active regions sequentially arranged in a clockwise direction, the first to fourth active regions being lengthwise in a first direction, and the device isolation part extending a second direction intersecting the first direction and being interposed between the first and second active regions and the third and fourth active regions; first and second word lines crossing the first and second active regions in the second direction and being adjacent to each other in a third direction intersecting the first and second directions; a gate insulating layer interposed between the first word line and the substrate; a first impurity region disposed in the first active region between the first and second word lines; a second impurity region disposed in the first active region at one side of the first word line and spaced apart from the first impurity region; a first conductive pad in contact with the first impurity region; a second conductive pad in contact with the second impurity region; a bit line disposed on the first conductive pad and extending in the third direction; a bit line capping pattern on the bit line; a first bit line spacer covering sidewalls of the bit line capping pattern and sidewalls of the bit line; a second bit line spacer covering a lower sidewall of the first bit line spacer and exposing an upper sidewall of the first bit line spacer; a storage node contact structure on the second conductive pad; and a landing pad on the storage node contact structure, wherein the storage node contact structure includes: a first contact contacting the second conductive pad and having a first width; and a second contact disposed on the first contact and having a second width greater than the first width, wherein the first contact is spaced apart from the first bit line spacer, and wherein the second contact is in contact with an upper end of the second bit line spacer and the first bit line spacer.

### BRIEF DESCRIPTION OF THE DRAWINGS

Example embodiments of the present disclosure will be more clearly understood from the following brief description taken in conjunction with the accompanying drawings. The accompanying drawings represent non-limiting, example embodiments as described herein.
FIG. 1A is a plan view of a semiconductor device according to embodiments of the present disclosure.
FIG. 1B is an enlarged view of portion 'P1' of FIG. 1A.
FIG. 2A is a cross-sectional view of FIG. 1A taken along line A-A'.
FIG. 2B is a cross-sectional view of FIG. 1A taken along line B-B'.
FIG. 2C is a cross-sectional view of FIG. 1A taken along line C-C'.
FIG. 2D is a cross-sectional view of FIG. 1A taken along line D-D'.
FIG. 2E is a cross-sectional view of FIG. 1A taken along line E-E'.
FIG. 2F is a cross-sectional view of FIG. 1A taken along line F-F'.
FIGS. 3A, 4A, 5A, 6A, 7A, 8A, 9A, 10A, 11A, 12A, 13A, 14A and FIG. 15 are plan views sequentially illustrating a process of manufacturing the semiconductor device of FIG. 1A.
FIGS. 3B, 4B, 5B, 6B, 7B, 8B, 9B, 10B, 11B, 12B and FIG. 14B are cross-sectional views sequentially illustrating a process of manufacturing the semiconductor device of FIGS. 2A and 2B.
FIGS. 3C, 4C, 5C, 6C, 7C, 8C, 9C, 10C, 11C, 12C and FIG. 14C are cross-sectional views sequentially illustrating a process of manufacturing the semiconductor device of FIGS. 2C and 2D.
FIGS. 3D, 4D, 5D, 6D, 7D, 8D, 9D, 10D, 11D, 12D, FIG. 13B, and FIG. 14D are cross-sectional views sequentially illustrating a process of manufacturing the semiconductor device of FIGS. 2E and 2F.
FIG. 16A is a plan view of a semiconductor device according to embodiments of the present disclosure.
FIG. 16B is a plan view illustrating an arrangement of active regions of FIG. 16A.
FIGS. 17A and 17B are plan views illustrating a method of manufacturing a semiconductor device having the active region of FIG. 16B.
FIG. 18 is a cross-sectional view of FIG. 17B taken along lines D-D' and E-E'.
FIG. 19 is a plan view of a semiconductor device according to embodiments of the present disclosure.
FIG. 20 is a cross-sectional view of FIG. 19 taken along line F-F'.
FIGS. 21A and 21B are cross-sectional views of FIG. 1A taken along line F-F' according to embodiments of the present disclosure.
FIG. 22A is a plan view of a semiconductor device according to embodiments of the present disclosure.
FIG. 22B includes cross-sectional views of FIG. 22A taken along lines A-A' and B-B'.
FIG. 22C includes cross-sectional views of FIG. 22A taken along line C-C' and line D-D'.
FIG. 22D includes cross-sectional views of FIG. 22A taken along lines E-E' and F-F'.
FIG. 23 is an enlarged view of portion 'P1' of FIG. 22A.
FIGS. 24A, 25A, 26A and 27A are plan views sequentially illustrating a process of manufacturing the semiconductor device of FIG. 22A.
FIGS. 24B, 25B, 26B and 27B are cross-sectional views sequentially illustrating a process of manufacturing the semiconductor device of FIG. 22B.
FIGS. 24C, 25C, 26C and 27C are cross-sectional views sequentially illustrating a process of manufacturing the semiconductor device of FIG. 22C.
FIGS. 24D, 25D, 26D and 27D are cross-sectional views sequentially illustrating a process of manufacturing the semiconductor device of FIG. 22D.
FIG. 28A is a plan view of a semiconductor device according to embodiments of the present disclosure.
FIG. 28B includes cross-sectional views of FIG. 28A taken along lines A-A' and B-B'.
FIG. 28C includes cross-sectional views of FIG. 28A taken along lines C-C' and D-D'.
FIG. 28D includes cross-sectional views of FIG. 28A taken along lines E-E' and F-F'.
FIG. 29 is an enlarged view of 'P1' portion 'P1' of FIG. 28A.
FIGS. 30A, 31A, 32A, 33A and 34A are plan views sequentially illustrating a process of manufacturing the semiconductor device of FIG. 28A.
FIGS. 30B, 31B, 32B, 33B and 34B are cross-sectional views sequentially illustrating a process of manufacturing the semiconductor device of FIG. 28B.
FIGS. 30C, 31C, 32C, 33C and 34C are cross-sectional views sequentially illustrating a process of manufacturing the semiconductor device of FIG. 28C.
FIGS. 30D, 31D, 32D, 33D and 34D are cross-sectional views sequentially illustrating a process of manufacturing the semiconductor device of FIG. 28D.

### DETAILED DESCRIPTION OF THE EMBODIMENTS

Hereinafter, embodiments of the present disclosure will be described in more detail with reference to the accompanying drawings.

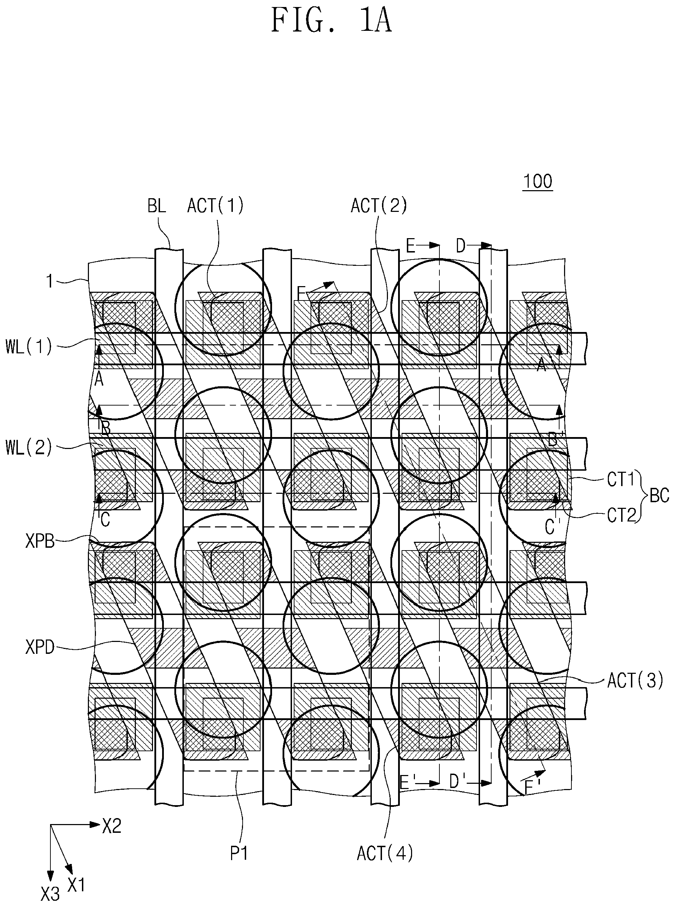

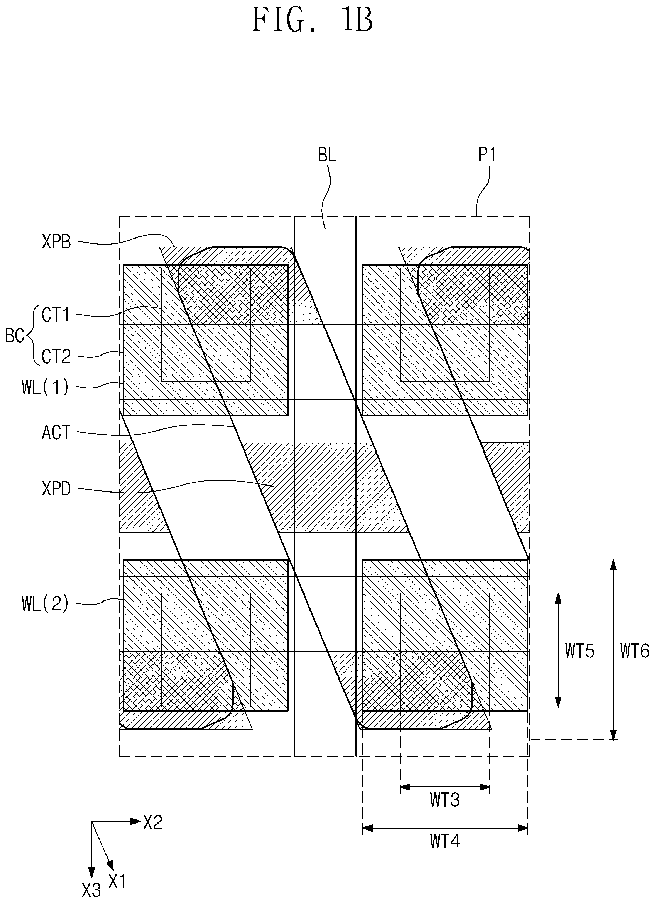

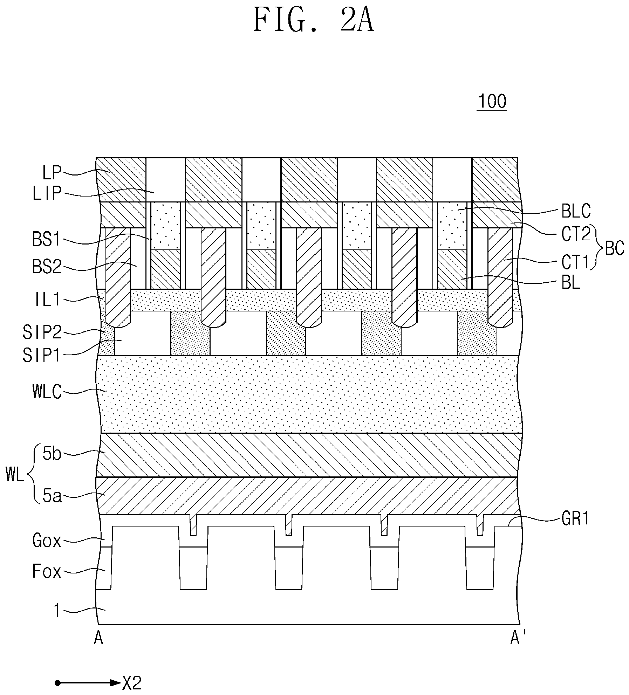

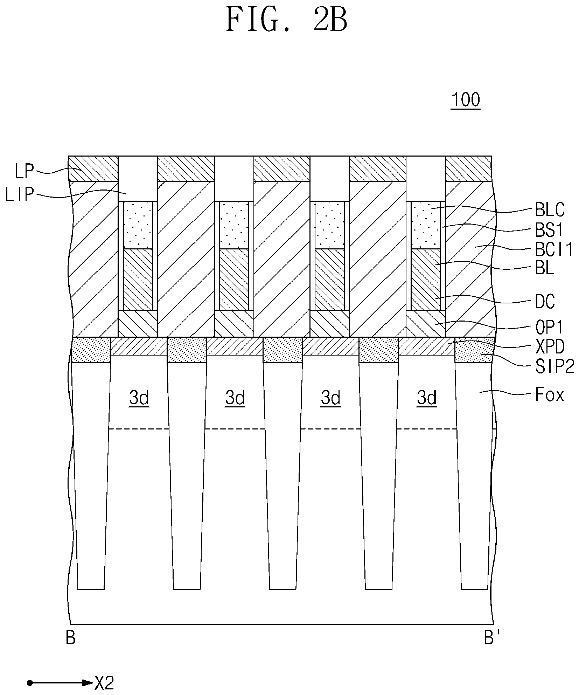

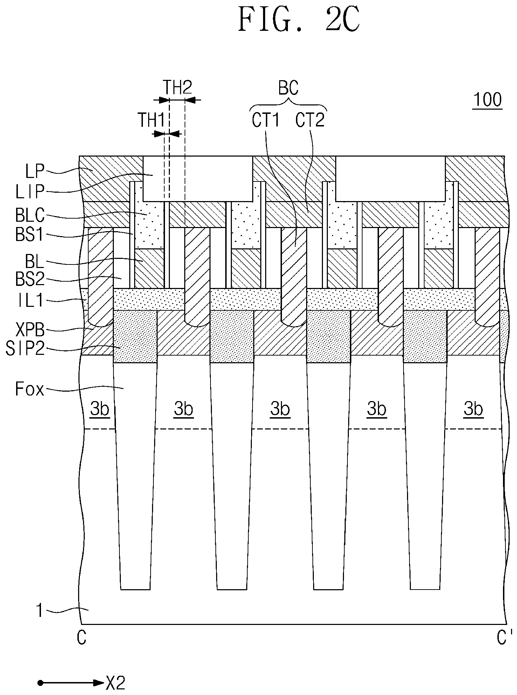

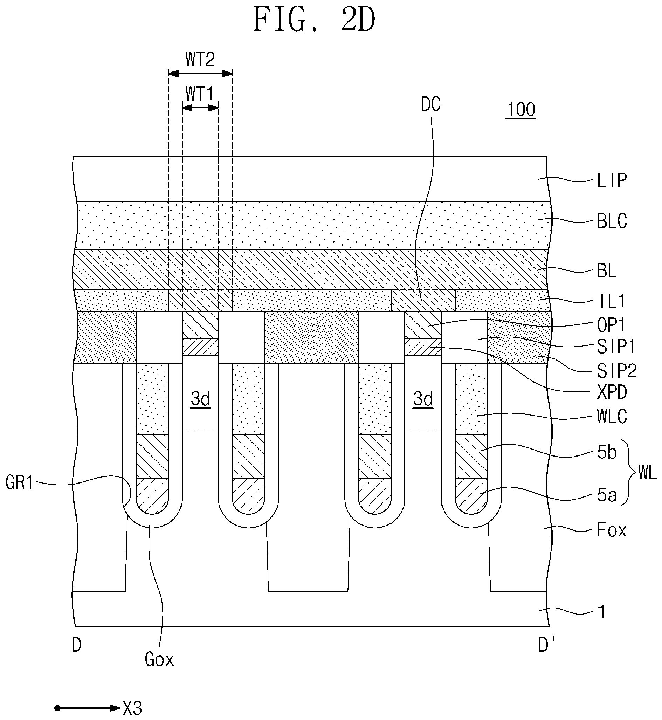

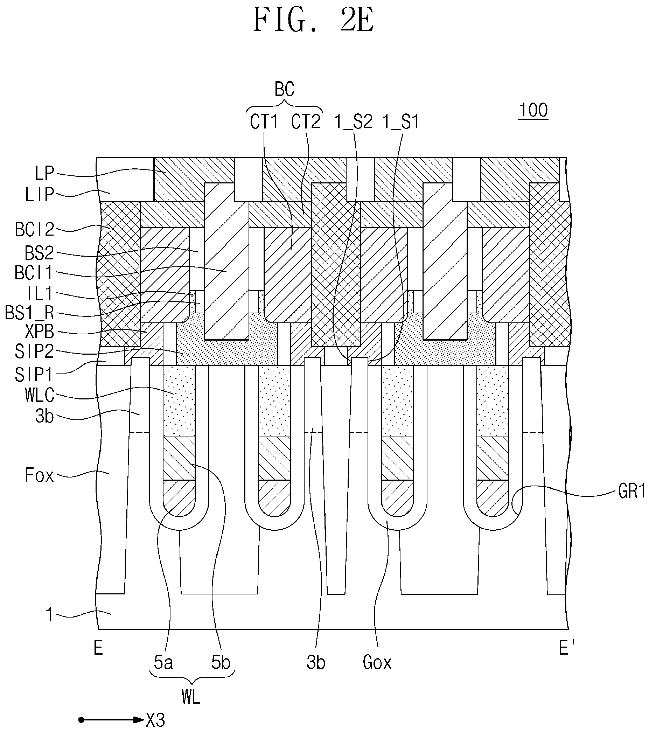

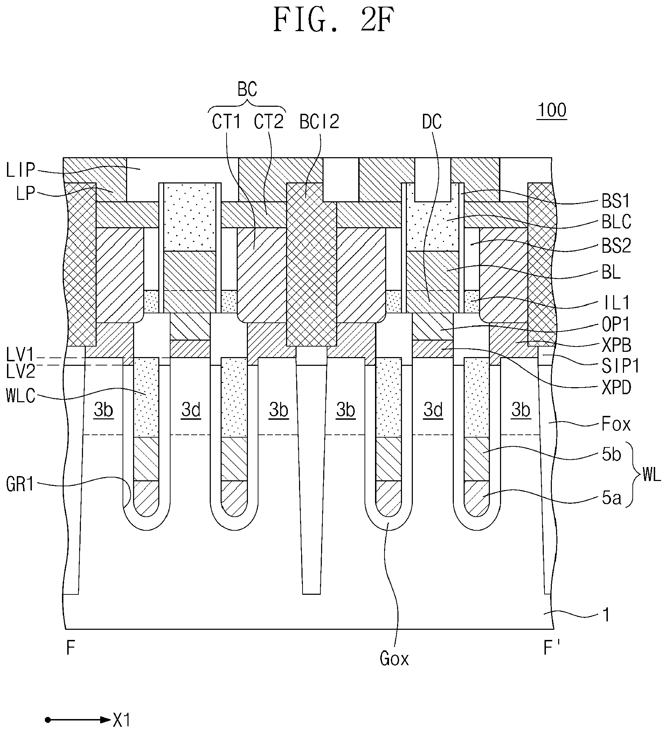

FIG. 1A is a plan view of a semiconductor device according to embodiments of the present disclosure. FIG. 1B is an enlarged view of portion 'P1' of FIG. 1A. FIG. 2A is a cross-sectional view of FIG. 1A taken along line A-A'. FIG. 2B is a cross-sectional view of FIG. 1A taken along line B-B'. FIG. 2C is a cross-sectional view of FIG. 1A taken along line C-C'. FIG. 2D is a cross-sectional view of FIG. 1A taken along line D-D'. FIG. 2E is a cross-sectional view of FIG. 1A taken along line E-E'. FIG. 2F is a cross-sectional view of FIG. 1A taken along line F-F'.

Referring to FIGS. 1A, 1B, and 2A to 2F, in the semiconductor device 100 according to the present embodiment, device isolation parts Fox may be disposed on a substrate 1 to define active regions ACT. The semiconductor device 100 may be a semiconductor memory device. Each of the active regions ACT may have an isolated shape. When viewed in a plan view, the active regions ACT may respectively correspond to portions of the substrate 1 surrounded by the device isolation part Fox. Each of the active regions ACT may have a bar shape elongated in a first direction X1 when viewed in a plan view, and ends of the active regions ACT may be rounded. For example, ends of the active regions ACT may be curved or have slanted portions. The substrate 1 may include a semiconductor material. The active regions ACT may be arranged parallel to each other in the first direction X1. Each of the device isolation parts Fox may include a single layer or multilayer structure of at least one of silicon oxide, silicon oxynitride, and silicon nitride, for example. An upper surface of the device isolation part Fox may be lower than an upper surface of the substrate 1, and thus the upper sidewall of the substrate 1 may be exposed.

The active regions ACT may include first to fourth active regions ACT(1) to ACT(4) sequentially arranged in a clockwise direction. The first and second active regions ACT(1) and ACT(2) may be spaced apart from each other in a second direction X2 crossing the first direction X1. The third and fourth active regions ACT(3) and ACT(4) may be spaced apart from each other in the second direction X2. The first and fourth active regions ACT(1) and ACT(4) may be spaced apart from each other in the first direction X1. The second and third active regions ACT(2) and ACT(3) may be spaced apart from each other in the first direction X1. The device isolation part Fox may extend in the second direction X2 and may be interposed between the first and second active regions ACT(1) and ACT(2) and the third and fourth active regions ACT(3) and ACT(4).

Word lines WL may cross the active regions ACT in the second direction X2. The word lines WL may be disposed in grooves GR1 formed in the device isolation part Fox and the active regions ACT. The word lines WL may be spaced apart from each other in a third direction X3 crossing both the first and second directions X1 and X2.

Each of the word lines WL may include a first word line pattern 5a and a second word line pattern 5b sequentially stacked. Each of the first word line pattern 5a and the second word line pattern 5b may include a conductive material.

The first word line pattern 5a may be formed of a first conductive material. The second word line pattern 5b may be formed of a second conductive material. A second work function of the second conductive material may be greater than a first work function of the first conductive material. When the word line WL is turned off due to a difference in work function, an electric field may decrease around the second word line pattern 5b adjacent to first and second impurity regions 3d and 3b. As a result, leakage current may be reduced during an OFF operation. In addition, when the word line WL is turned ON due to the difference in work function, an inversion around the second word line pattern 5b may be improved to increase an ON current. Accordingly, ON/OFF controllability of the word line WL may be improved. The first work function may be, for example, 4.2 eV or less, and the second work function may be, for example, 4.4 eV or more. The first conductive material may be one of TiN, Mo, W, Cu, Al, TaN, Ru, and Ir. The second conductive material may be polysilicon or silicon germanium doped with an impurity (phosphorus or boron).

A gate insulating layer Gox may be disposed between each of the word lines WL and the substrate 1 and between the word lines WL and the device isolation part Fox. Bottoms of the grooves GR1 may be relatively deep within the device isolation part Fox and relatively shallow within the active regions ACT. The bottom surfaces of the word lines WL may be curved. The gate insulating layer Gox may include at least one of a thermal oxide, silicon nitride, silicon oxynitride, and a high dielectric material. For example, the gate insulating layer Gox may include a thermal oxide.

The word lines WL may include first and second word lines WL(1) and WL(2) adjacent to each other. A first impurity region 3d may be disposed in each of the active regions ACT between the first and second word lines WL(1) and WL(2), and a pair of second impurity regions 3b may be respectively disposed in both edge regions of each of the active regions ACT. The first and second impurity regions 3d and 3b may be doped with, for example, N-type impurities. The first impurity region 3d may correspond to a common drain region and the second impurity regions 3b may correspond to a source region. One of the word lines WL and the first and second impurity regions 3d and 3b adjacent thereto may constitute a transistor. The word lines WL may be disposed in the grooves GR1, and a channel length of a channel region under the word lines WL may be increased within a limited plane area. Therefore, a short-channel effect and the like may be minimized.

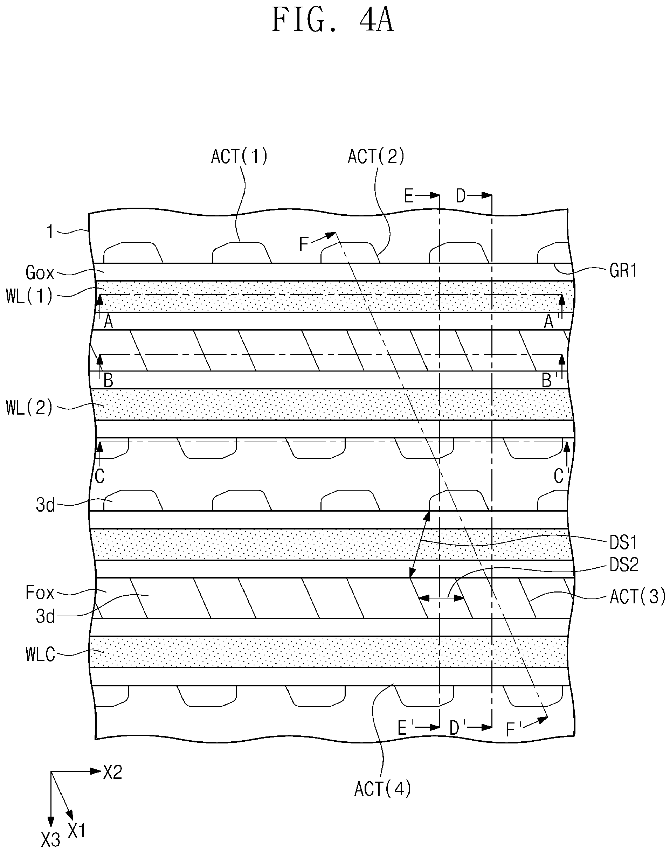

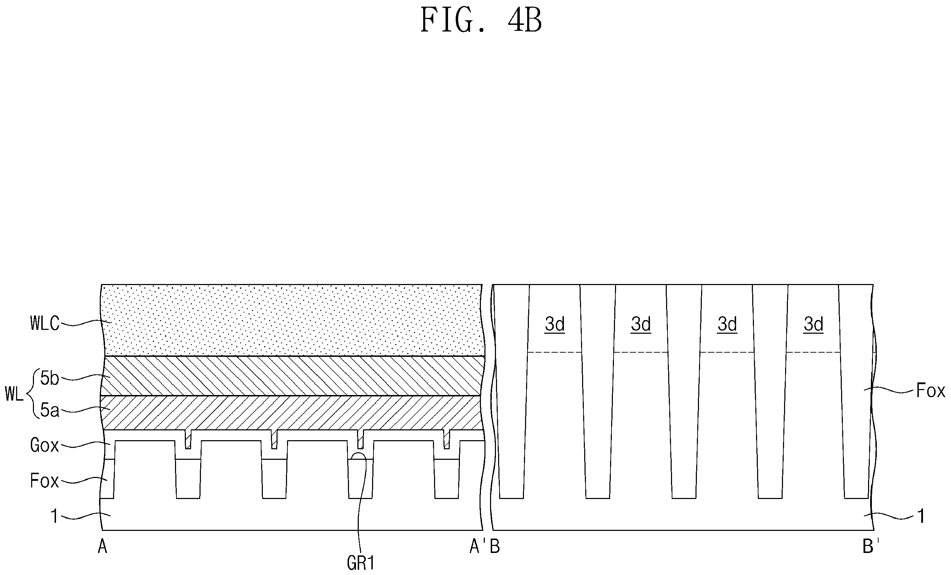

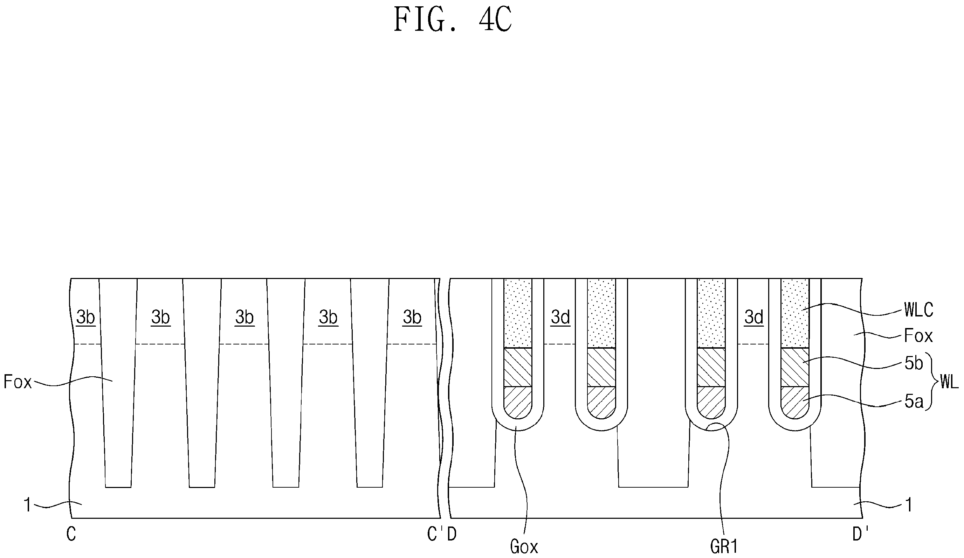

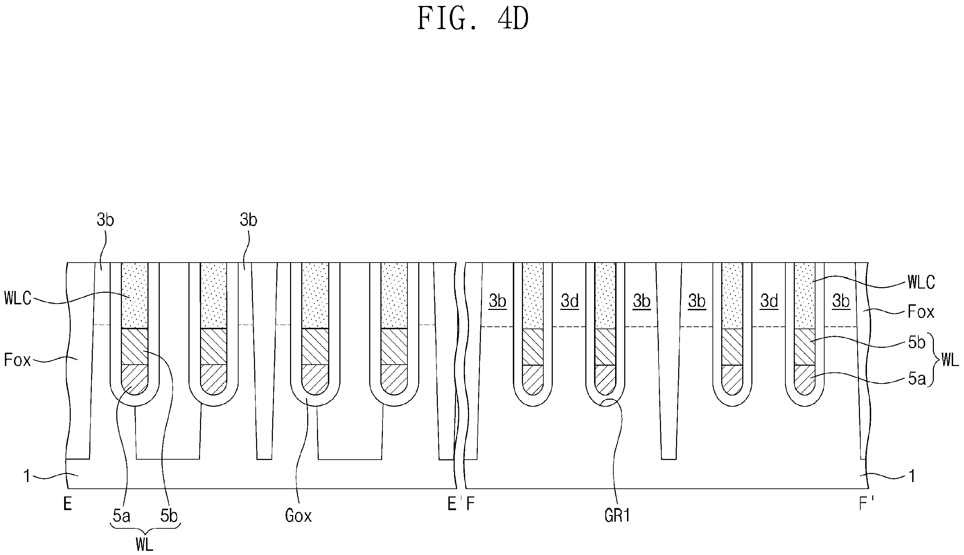

Referring to FIG. 4A, in the semiconductor device 100 according to an embodiment of the present disclosure, a first distance DS1 between a first impurity region 3d disposed in one active region (e.g., a fourth active region ACT(4)) and a second impurity region 3b disposed adjacent thereto and disposed in another active region (e.g., the third active region ACT(3)) is greater than a second distance DS2 between the first impurity regions 3d adjacent to each other in the second direction X2. Accordingly, a short circuit between the first impurity region 3d and the second impurity region 3b adjacent thereto may be prevented. In the semiconductor device 100 according to an embodiment of the present invention, the position/arrangement of the active regions has an improved misalignment margin compared to that of the prior art. In addition, when forming mask patterns used to form active regions, process difficulty may be reduced and scalability may be maximized, thereby reducing process defects and improving the reliability of a semiconductor device.

A word line capping pattern WLC may be disposed on each of the word lines WL. The word line capping patterns WLC may have a line shape extending in a length direction of the word lines WL, and may cover entire upper surfaces of the word lines WL. The word line capping patterns WLC may fill the grooves GR1 on the word lines WL. The word line capping pattern WLC may be formed of, for example, a silicon nitride layer. The gate insulating layer Gox may be interposed between the word line capping pattern WLC and the substrate 1. In FIG. 2F, an upper surface of the gate insulating layer Gox may be lower than the upper surface of the word line capping pattern WLC and the upper surface of the substrate 1, and an upper sidewall of the word line capping pattern WLC and an upper sidewall of the substrate 1 may be exposed. In other words, an upper portion of the word line capping pattern WLC may protrude from the upper surface of the gate insulating layer Gox to be exposed.

A first conductive pad XPD may be disposed on the first impurity region 3d. Second conductive pads XPB may be disposed on the second impurity regions 3b. The first conductive pad XPD and the second conductive pad XPB may each include polysilicon doped with the same impurity at the same concentration. In FIG. 2F, a first level LV1 at a lower end of the first conductive pad XPD may be higher than a second level LV2 at a lower end of the second conductive pad XPB. In other words, a portion of the second conductive pad XPB may be closed to the substrate 1 than the first conductive pad XPD. The second conductive pad XPB may cover an upper sidewall of the substrate 1. The second conductive pad XPB may overlap the gate insulating layer Gox.

In FIG. 2E, one of the second conductive pads XPB may cover first and second sidewalls 1_S1 and 1_S2 of the substrate 1 that are opposite to each other. As a result, a contact area between the second conductive pad XPB and the substrate 1 may increase, and contact resistance therebetween may decrease, thereby improving the reliability of the semiconductor device 100.

In FIG. 1B, each of the first conductive pad XPD and the second conductive pad XPB may have a trapezoidal shape having four corners when viewed in a plan view. A part of the second conductive pad XPB may protrude outside the active region ACT to cover the device isolation part Fox. A planar area of the second conductive pad XPB is larger than a planar area of the second impurity regions 3b. As a result, a misalignment margin between the second conductive pad XPB and a storage node contact structure BC to be described later may be improved. As a result, reliability of the semiconductor device 100 may be improved.

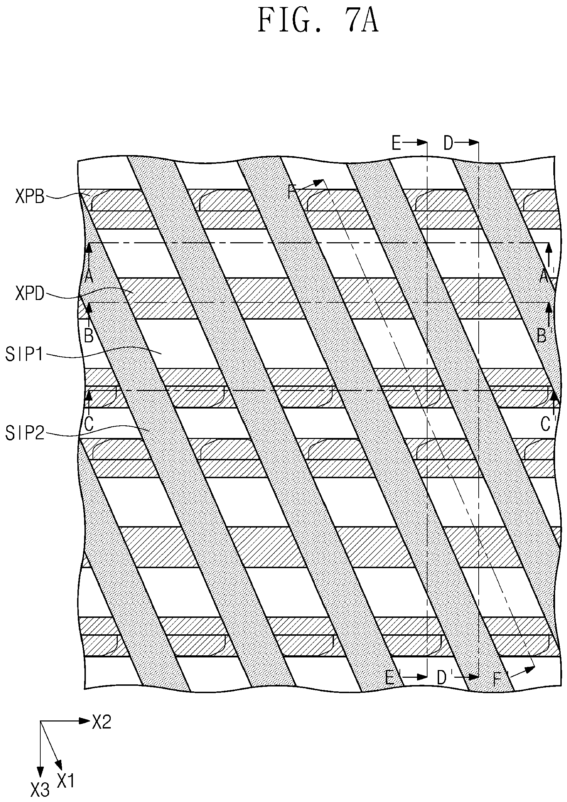

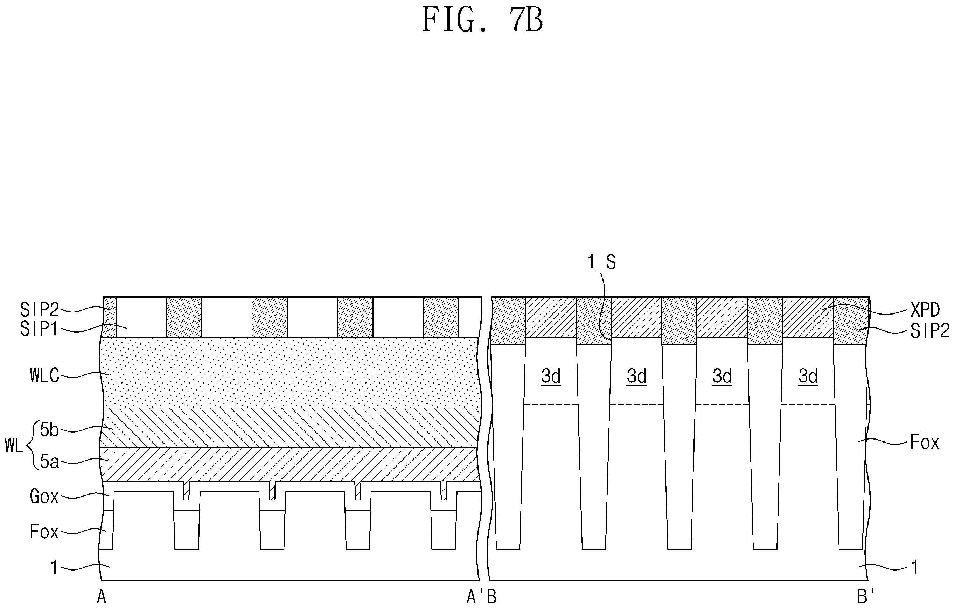

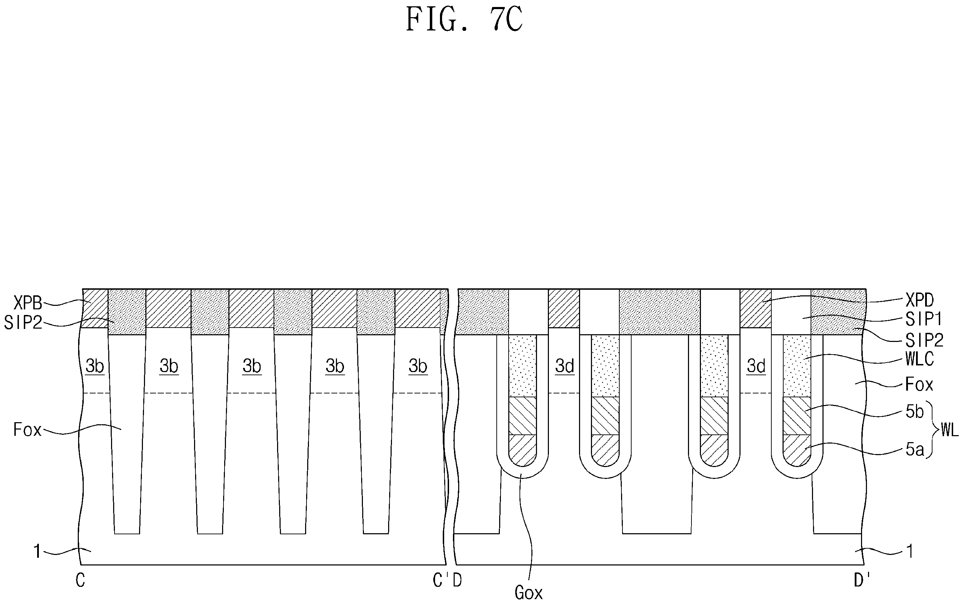

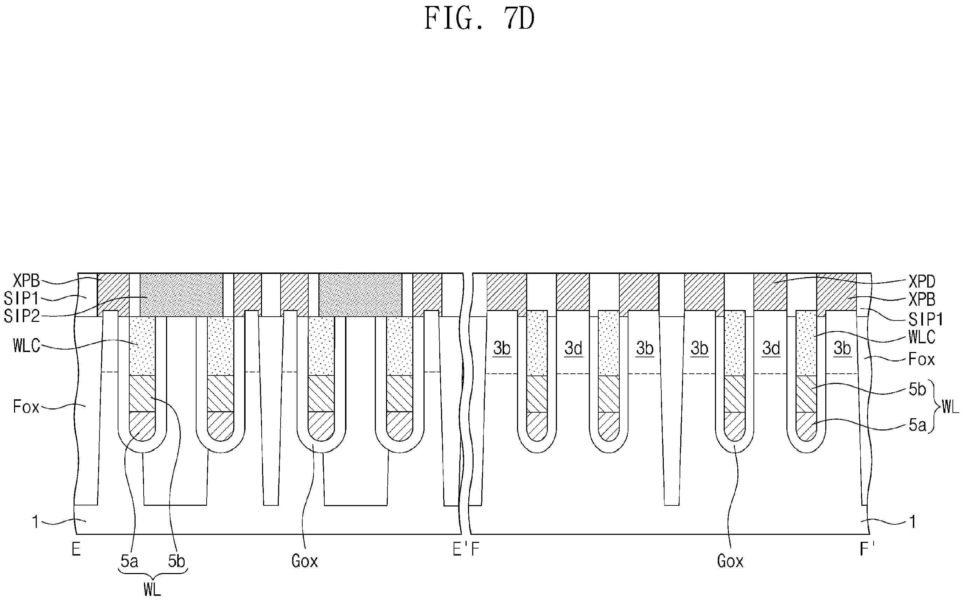

In FIG. 2F, a first pad separation pattern SIP1 may be interposed between the first conductive pad XPD and the second conductive pad XPB in the first direction X1. The first conductive pads XPD and second conductive pads XPB may be provided in plural. In the cross section of FIG. 2A, the first conductive pads XPD and second conductive pads XPB may be alternately disposed in the second direction X2. Referring to FIG. 2B, a second pad separation pattern SIP2 may be interposed between the first conductive pads XPD in the second direction X2. Each of the first pad separation patterns SIP1 may have a trapezoidal shape when viewed in a plan view, as shown in FIG. 7A. Each of the second pad separation patterns SIP2 may have a line shape extending in the first direction X1 when viewed in a plan view, as shown in FIG. 7A. The first pad separation pattern SIP1 and the second pad separation pattern SIP2 may each include the same or different insulating materials. Each of the first pad separation pattern SIP1 and the second pad separation pattern SIP2 may have a single-layer or multi-layer structure of at least one material selected from silicon oxide, silicon nitride, and silicon oxynitride.

Lower ends of the first conductive pads XPD and the second conductive pads XPB may be lower than the upper surface of the substrate 1 as shown in FIG. 2F. A first ohmic pattern OP1 may be disposed on the first conductive pad XPD. The first ohmic pattern OP1 may include, for example, a metal silicide such as cobalt silicide or titanium silicide. An upper surface of the first ohmic pattern OP1 may be coplanar with upper surfaces of the first pad separation pattern SIP1 and the second pad separation pattern SIP2 (see FIG. 2D). Upper surfaces of the second conductive pads XPB may be coplanar with upper surfaces of the first pad separation pattern SIP1 and the second pad separation pattern SIP2 (see FIG. 2C).

The first conductive pads XPD, the second conductive pads XPB, the first pad separation pattern SIP1, and the second pad separation pattern SIP2 may be covered with a first interlayer insulating layer IL 1. The first interlayer insulating layer IL1 may have a single layer or multilayer structure of at least one material selected from silicon oxide, silicon nitride, and silicon oxynitride.

Bit lines BL are disposed on the first interlayer insulating layer IL1. The bit lines BL may extend in the third direction X3 and may be spaced apart from each other in the second direction X2. The bit lines BL may cross the word line capping patterns WLC and word lines WL. The bit line BL may include metal. The bit line BL may include at least one material selected from aluminum, tungsten, titanium, and ruthenium.

A bit line contact DC may be disposed between the bit lines BL and the first ohmic pattern OP1. The bit line contact DC may correspond to a portion of the bit line BL protruding downward. Accordingly, the bit line contact DC may include the same material as the bit line BL. There may be no boundary between the bit line contact DC and the bit line BL. As such, the bit line BL may be in direct contact with the first ohmic pattern OP1. Referring to FIG. 2D, the first ohmic pattern OP1 or the first conductive pad XPD has a first width WT1 in the third direction X3. The bit line contact DC may have a second width WT2 greater than the first width WT1 in the third direction X3.

In the present embodiment, both the bit line BL and the bit line contact DC may include metal, and electrical resistance may be reduced, thereby improving an operating speed of the semiconductor device 100 and the operation of the semiconductor device 100 at low power. When the bit line BL and/or the bit line contact DC includes polysilicon and a voltage is applied to the bit line BL and/or the bit line contact DC, a depletion phenomenon associated with the polysilicon may occur. This can lead to a reduction in the electrical path causing an issue known as bit line necking. Bit line necking refers to an electrical disconnection phenomenon that arises due to increased electrical resistance. However, in the present embodiment, both the bit line BL and the bit line contact DC may include metal, and thus, the bit line necking may not occur.

A bit line capping pattern BLC may be disposed on the bit line BL. The bit line capping pattern BLC may have a structure of at least one single layer or a multilayer selected from silicon oxide, silicon nitride, and silicon oxynitride. Sidewalls of the bit line BL and the bit line capping pattern BLC may be covered with a first bit line spacer BS1. A sidewall of the first bit line spacer BS1 may be covered with the second bit line spacer BS2. Each of the first bit line spacer BS1 and the second bit line spacer BS2 may have a structure of at least one single layer or multiple layers selected from silicon oxide, silicon nitride, and silicon oxynitride.

Referring to FIG. 2C, the first bit line spacer BS1 may include silicon nitride. The second bit line spacer BS2 may include silicon oxide. In this case, the first bit line spacer BS1 may have a first thickness TH1. The second bit line spacer BS2 may have a second thickness TH2 greater than the first thickness TH1. Silicon oxide has a smaller permittivity than silicon nitride. As a result, a ratio of silicon oxide having a relatively low permittivity between the bit line BL and a storage node contact structure BC may increase, and as a result, interference between the bit line BL and the storage node contact structure BC may be reduced. Accordingly, bit line to buried contact disturbance (BBD) characteristics may be improved, and the reliability of the semiconductor device 100 may be improved.

As illustrated in FIGS. 2C and 2F, an upper end of the second bit line spacer BS2 is lower than an upper end of the first bit line spacer BS1, and an upper sidewall of the first bit line spacer BS1 is exposed. In FIG. 2F, the first interlayer insulating layer IL1 may be interposed between the second bit line spacer BS2 and the first pad separation pattern SIP1 and may be in contact with a sidewall of the first bit line spacer B S1. The first interlayer insulating layer IL1 may also be in contact with storage node contact structure BC.

Storage node contact structures BC may be disposed between the bit lines BL. The storage node contact structures BC may vertically overlap the second conductive pads XPB. Each of the storage node contact structures BC may include a first contact CT1 and a second contact CT2 sequentially stacked. The first contact CT1 and the second contact CT2 may each include polysilicon doped with impurities, metal silicide, and/or metal. As shown in FIG. 2C, the first contact CT1 may pass through the first interlayer insulating layer IL1 and may be in contact with the second conductive pad XPB. A portion of the first contact CT1 may be inserted into the second conductive pad XPB. A lower surface of the first contact CT1 may be rounded. As a result, a contact area between the first contact CT1 and the second conductive pad XPB may increase, thereby reducing electrical resistance and improving the reliability of the semiconductor device 100.

The storage node contact structure BC may have a 'T' shape structure. The second contact CT2 may cover an upper surface of the second bit line spacer BS2. A width of the second contact CT2 may be greater than that of the first contact CT1. For example, in FIG. 1B, in the second direction X2, the first contact CT1 may have a third width WT3 and the second contact CT2 may have a fourth width WT4. In the second direction X3, the first contact CT1 may have a fifth width WT5, and the second contact CT2 may have a sixth width WT6. The fourth width WT4 may be greater than the third width WT3. The sixth width WT6 may be greater than the fifth width WT5. Accordingly, a misalignment margin between the second contact CT2 and a landing pad LP to be described later may be increased, thereby improving the reliability of the semiconductor device 100.

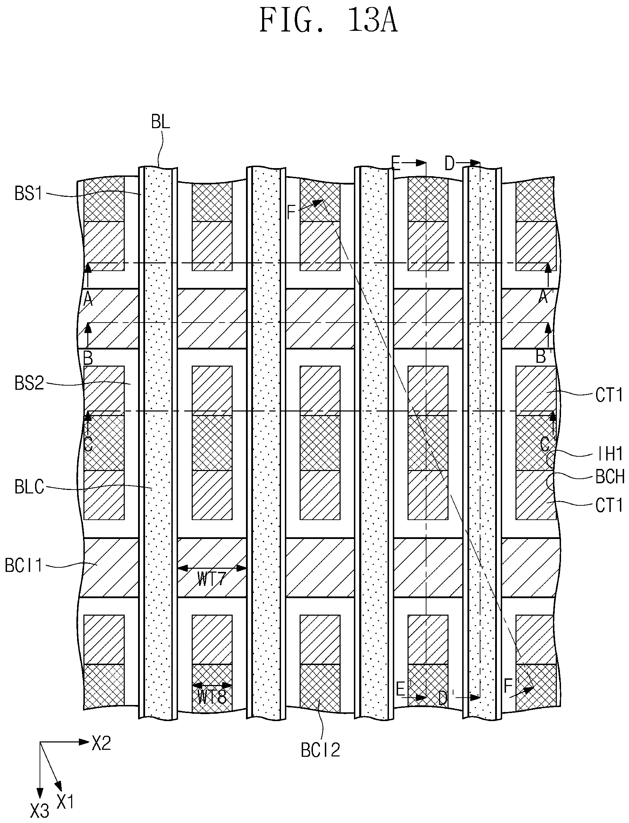

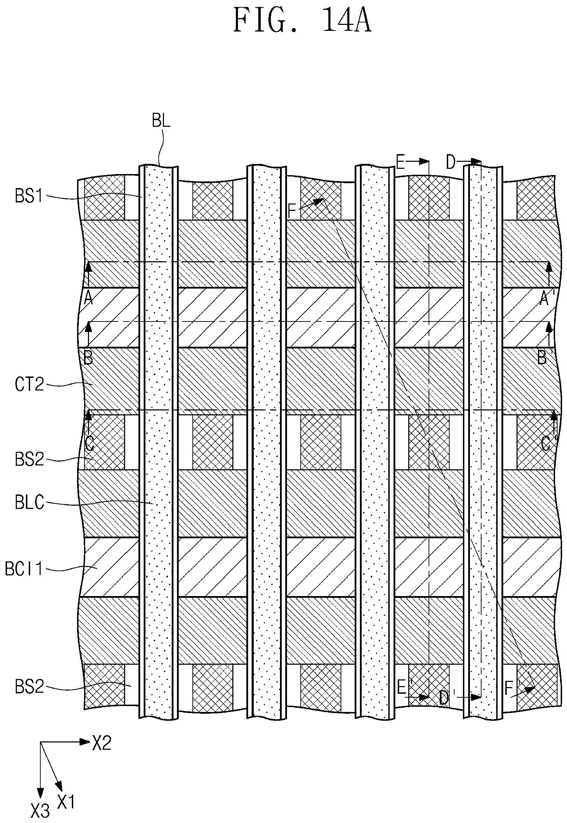

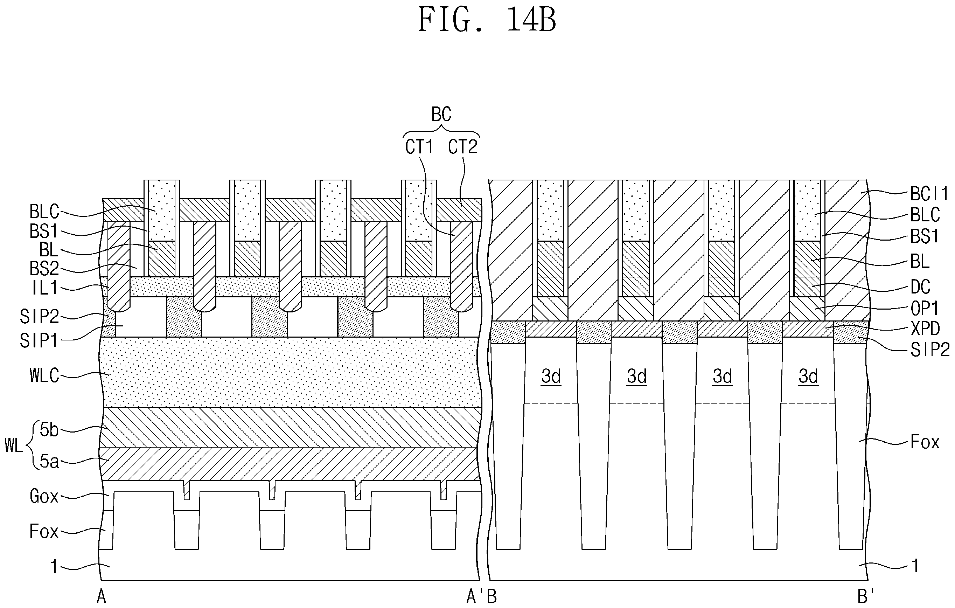

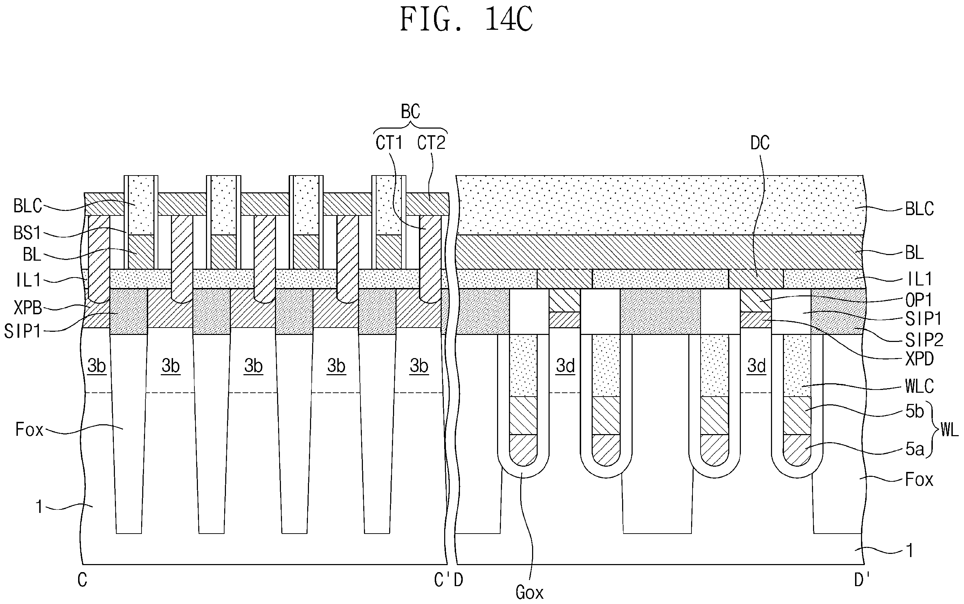

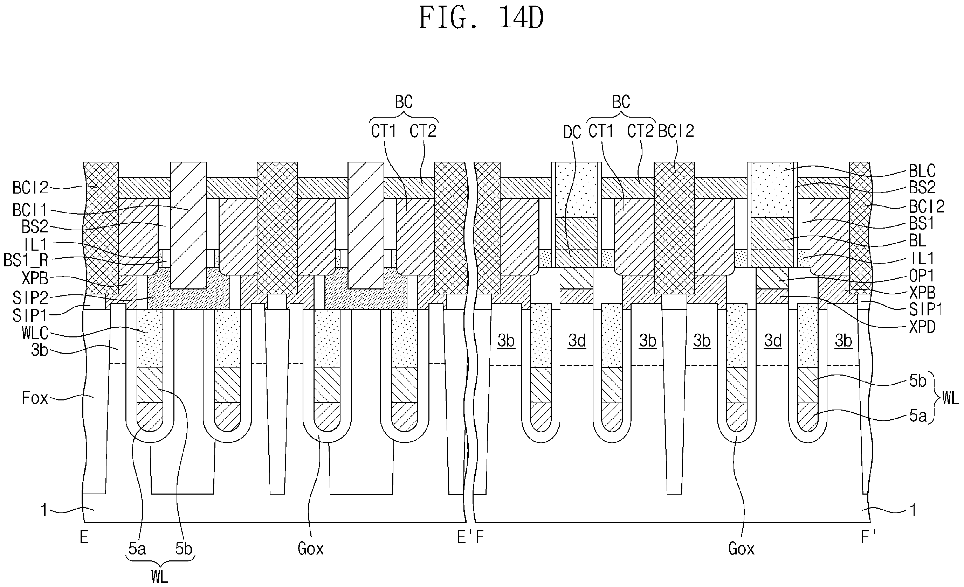

First and second contact separation patterns BCI1 and BCI2 are alternately and repeatedly disposed between the storage node contact structures BC in the third direction X3 (refer to FIGS. 13A and 14A). Referring to FIG. 13A, in the second direction X2, each of the first contact separation patterns BCI1 may have a seventh width WT7, and each of the second contact separation patterns BCI2 may have an eighth width WT8. The eighth width WT8 may be smaller than the seventh width WT7. Each of the first contact separation patterns BCI1 and the second contact separation patterns BCI2 may have a structure of at least one single layer or a multilayer selected from silicon oxide, silicon nitride, and silicon oxynitride.

Referring to FIG. 2E, lower surfaces of the first contact separation patterns BCI1 and BCI2 may be lower than a lower surface of the first contact CT1. The first contact separation pattern BCI1 may be inserted into the second pad separation pattern SIP2. A portion of the second contact separation pattern BCI2 may be inserted into the second conductive pad XPB. The second bit line spacer BS2 may be interposed between the first contact CT1 and the first contact separation pattern BCI1. The first interlayer insulating layer IL1 may be interposed between the first contact CT1 and the first contact separation pattern BCI1 under the second bit line spacer BS2. A first spacer remaining pattern BS1_R may be interposed between the first interlayer insulating layer IL1 and the first contact separation pattern BCI1 under the second bit line spacer BS2. The first spacer remaining pattern BS1_R may be disposed on the second pad separation pattern SIP2. The first spacer remaining pattern BS1_R may include the same material as the first bit line spacer BS1.

Landing pads LP may be disposed on the storage node contact structures BC, respectively. When viewed in a plan view, the landing pads LP may have island shapes spaced apart from each other. Each of the landing pads LP may include a metal such as tungsten. The landing pads LP may be in contact with the second contact CT2. For example, the landing pads LP may directly contact the second contact CT2. The landing pads LP may partially cover upper surfaces of the first and second contact separation patterns BCI1 and BCI2, respectively, as shown in FIG. 2E. The landing pads LP may be arranged in a honeycomb shape.

A landing pad separation pattern LIP may be disposed between the landing pads LP. The landing pad separation pattern LIP may have a structure of at least one single layer or a multilayer selected from, for example, silicon oxide, silicon nitride, and silicon oxynitride. The landing pad separation pattern LIP may pass through a portion of the bit line capping pattern BLC and the first bit line spacer BS1 as shown in FIG. 2C. The landing pad separation pattern LIP may pass through portions of the first and second contact separation patterns BCI1 and BCI2 as shown in FIG. 2E.

Data storage patterns may be disposed on each of the landing pads LP. The data storage patterns may be capacitors including a lower electrode, a dielectric layer, and an upper electrode. In this case, the semiconductor device 100 may be a dynamic random-access memory (DRAM). Alternatively, the data storage patterns may include magnetic tunnel junction patterns. In this case, the semiconductor device 100 may be a magnetic random access memory (MRAM). Alternatively, the data storage patterns may include a phase change material or a variable resistance material. In this case, the semiconductor device 100 may be a phase-change random access memory (PRAM) or a resistive RAM (ReRAM).

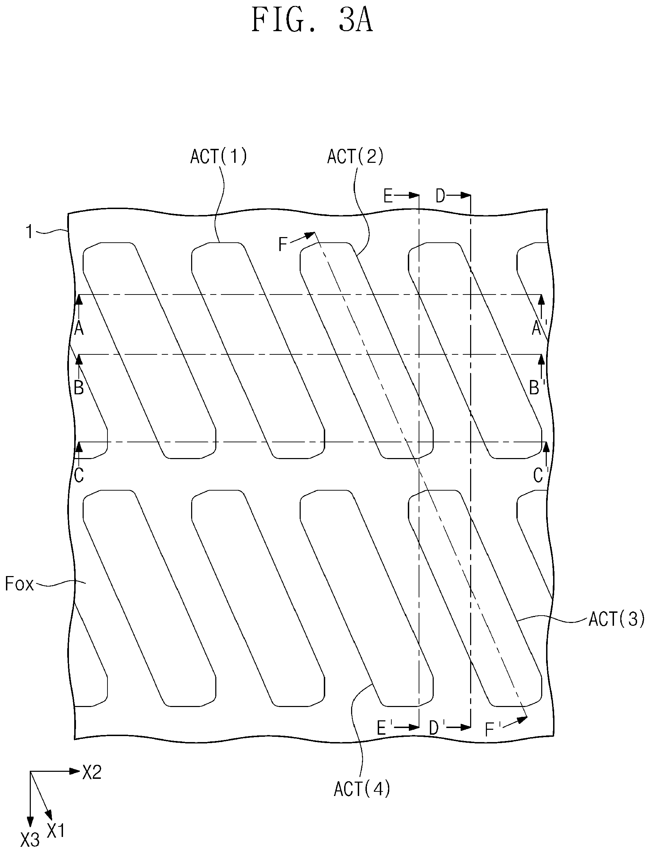

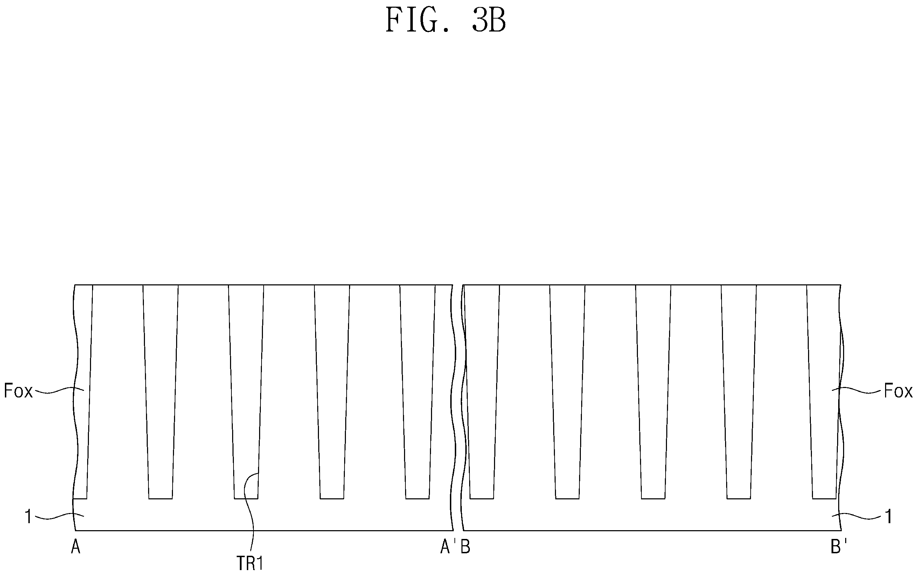

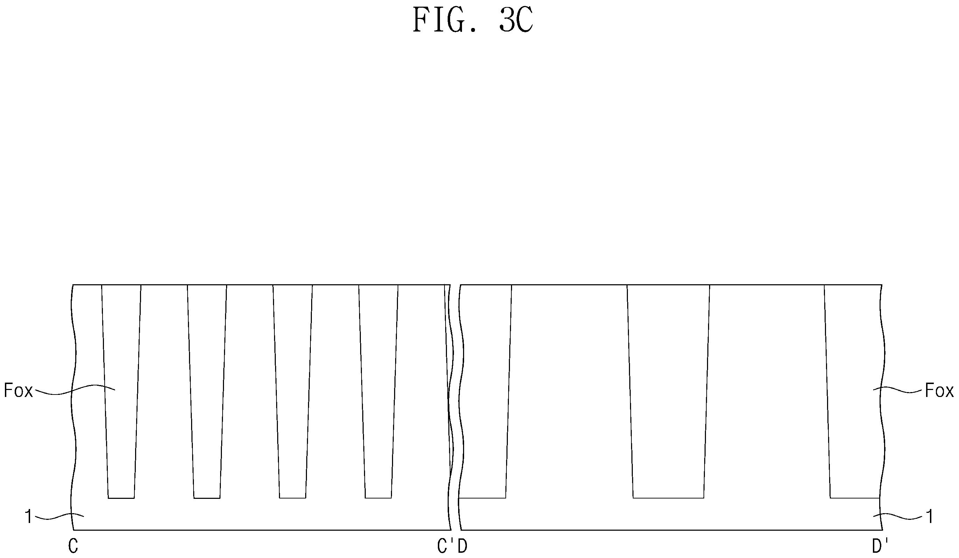

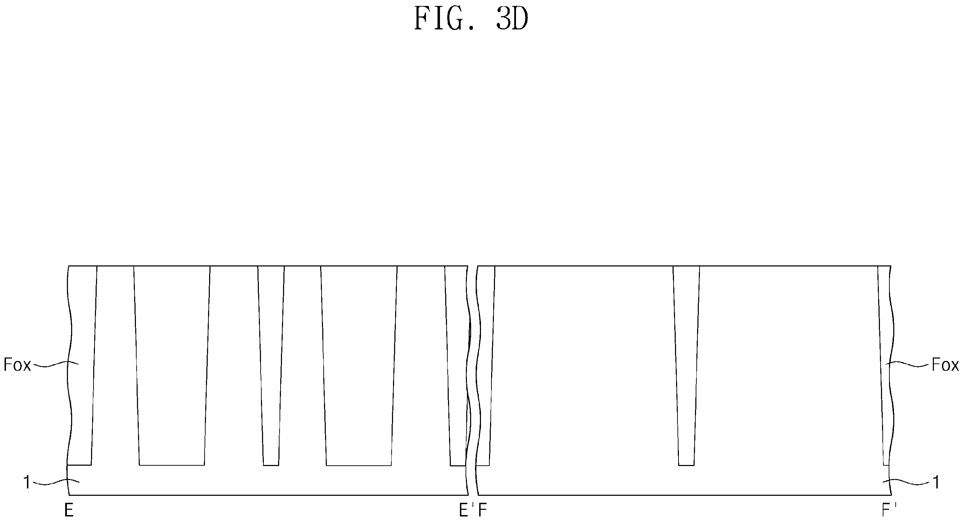

FIGS. 3A to 14A and FIG. 15 are plan views sequentially illustrating a process of manufacturing the semiconductor device of FIG. 1A. FIGS. 3B to 12B and FIG. 14B are cross-sectional views sequentially illustrating a process of manufacturing the semiconductor device of FIGS. 2A and 2B. FIGS. 3C to 12C and FIG. 14C are cross-sectional views sequentially illustrating a process of manufacturing the semiconductor device of FIGS. 2C and 2D. FIGS. 3D to 12D, FIG. 13B, and FIG. 14D are cross-sectional views sequentially illustrating a process of manufacturing the semiconductor device of FIGS. 2E and 2F.

Referring to FIGS. 3A to 3D, device isolation parts Fox may be formed on the substrate 1 to define active regions ACT. The active regions ACT may include first to fourth active regions ACT(1) to ACT(4) sequentially arranged in a clockwise direction. An arrangement/location of the active regions ACT corresponds to that described with reference to FIGS. 1A and 4A. To form the device isolation part Fox, mask patterns are formed on the substrate 1 and the substrate 1 is etched to form trenches TR1. A device isolation layer is deposited on the substrate 1 to fill the trenches TR1 and etched back to form the device isolation part Fox.

The mask patterns may be formed using a Litho Etch Litho Etch (LELE) technique. The mask patterns may include first mask patterns and second mask patterns. The first mask patterns may define positions and shapes of odd-numbered active regions ACT(1) and ACT(3). The second mask patterns may define positions and shapes on even-numbered active regions ACT(2) and ACT(4). The first mask patterns may be formed by a first photolithography process. The second mask patterns may be formed by a second photolithography process. In the present disclosure, since a relationship between the first and second distances DS1 and DS2 illustrated in FIG. 4A is satisfied and the arrangement/position of the active regions ACT is formed as described in FIG. 1A, the second mask patterns may be maintained at a certain distance or more from the first mask patterns even when the second mask patterns are partially misaligned. Accordingly, when the second mask patterns with an increasing misalignment margin are formed, process difficulty may be reduced and scalability may be maximized, thereby reducing process defects. As a result, a yield may be improved and reliability of the semiconductor device 100 may be improved.

Referring to FIGS. 4A to 4D, the active regions ACT and the isolation part Fox may be patterned to form grooves GR1. At this time, etching conditions for the substrate 1 and the device isolation part Fox may be adjusted so that the device isolation part Fox is more easily etched than the substrate 1. As a result, bottom surfaces of the grooves GR1 may be curved. In other words, the bottom surfaces of the grooves GR1 may be rounded. A gate insulating layer Gox may be conformally formed in the grooves GR1. The gate insulating layer Gox may be formed through a thermal oxidation process, a chemical vapor deposition process, and/or an atomic layer deposition process. A first gate conductive layer is deposited to fill the grooves GR1 and etched back to form a first word line pattern 5a. The first word line pattern 5a may fill lower portions of the grooves GR1. A second gate conductive layer is deposited to fill the grooves GR1 and etched back to form a second word line pattern 5b. The second word line pattern 5b may fill a middle portion of the grooves GR1. The first word line pattern 5a and the second word line pattern 5b constitute a word line WL. The second word line pattern 5b may cover the first word line pattern 5a. An insulating layer such as, for example, a silicon nitride layer may be deposited on the substrate 1 to fill the grooves GR1 and then etched to form a word line capping pattern WLC on each of the word lines WL. Dopants may be implanted into the active regions ACT using the word line capping patterns WLC and the device isolation part Fox as a mask to form first and second impurity regions 3d and 3b.

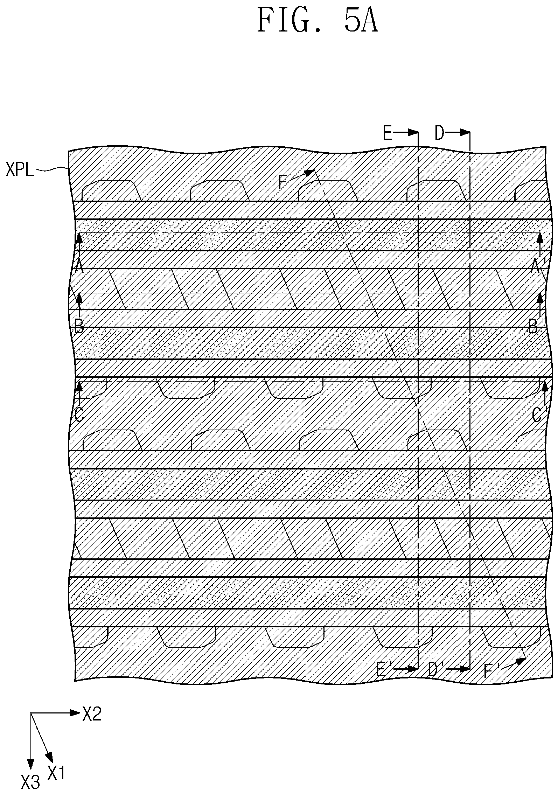

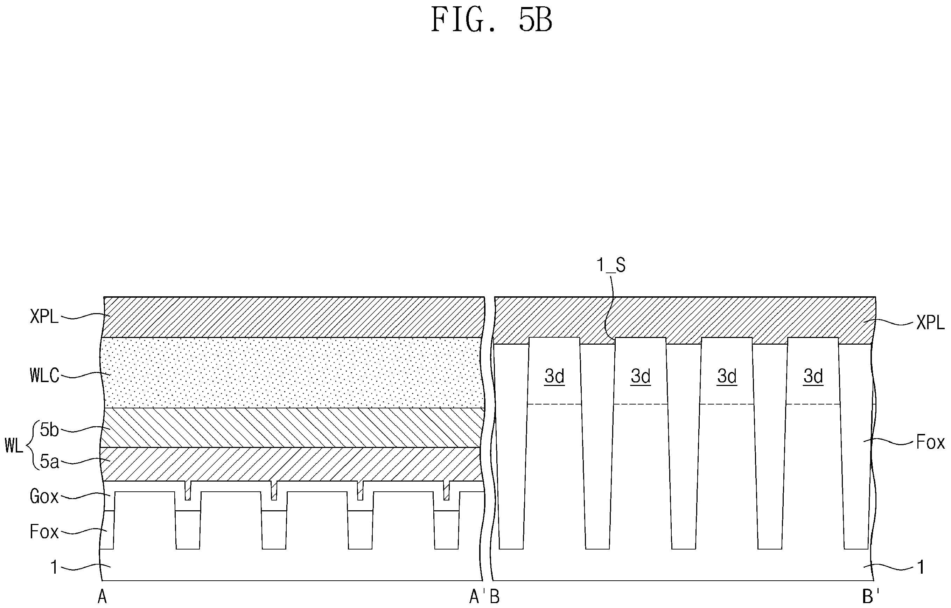

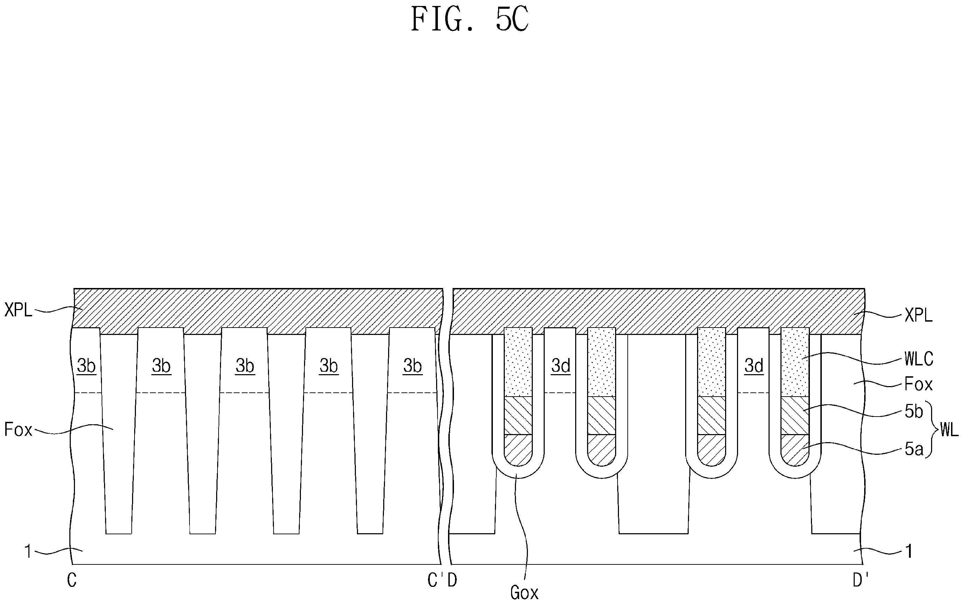

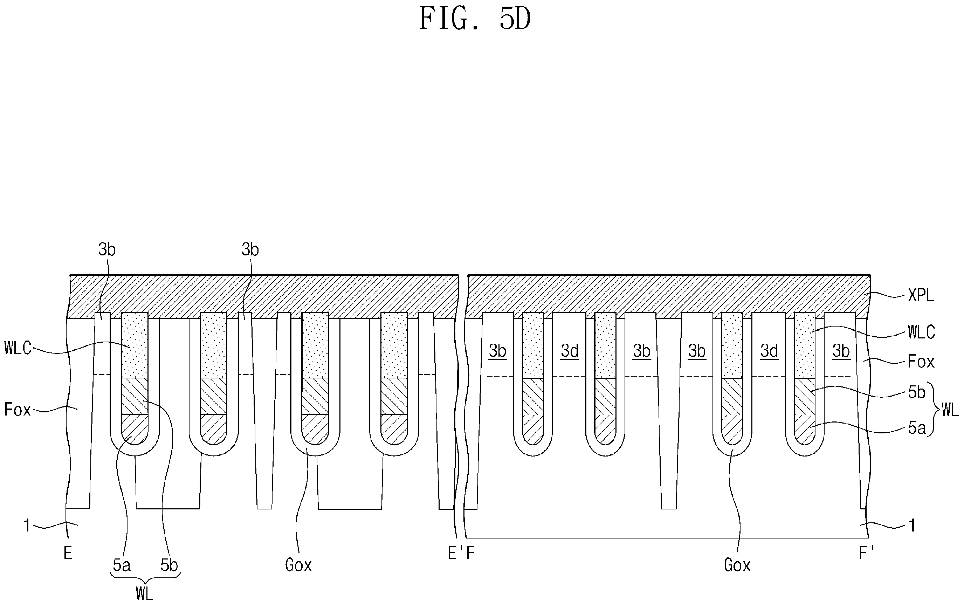

Referring to FIGS. 5A to 5D, a portion of the device isolation part Fox is removed to expose an upper sidewall 1_S of the substrate 1. In this case, a portion of the gate insulating layer Gox may be removed, and upper sidewalls of the word line capping patterns WLC may be exposed. A pad layer XPL is deposited on the entire surface of the substrate 1. The pad layer XPL may also cover the device isolation parts Fox and the word line capping pattern WLC. The pad layer XPL may be a polysilicon layer doped with impurities. The pad layer XPL may be formed by in-situ doping with impurities while depositing a polysilicon layer. The pad layer XPL may be in contact with the upper sidewall 1_S of the substrate 1.

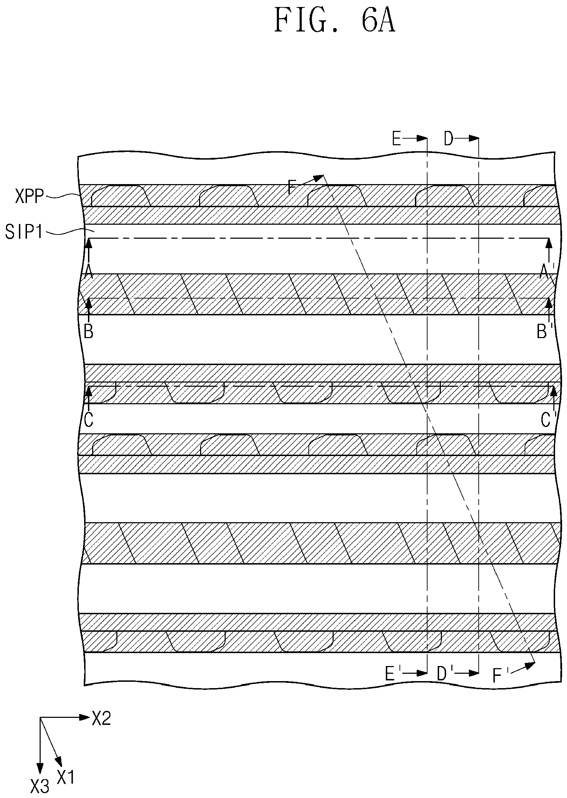

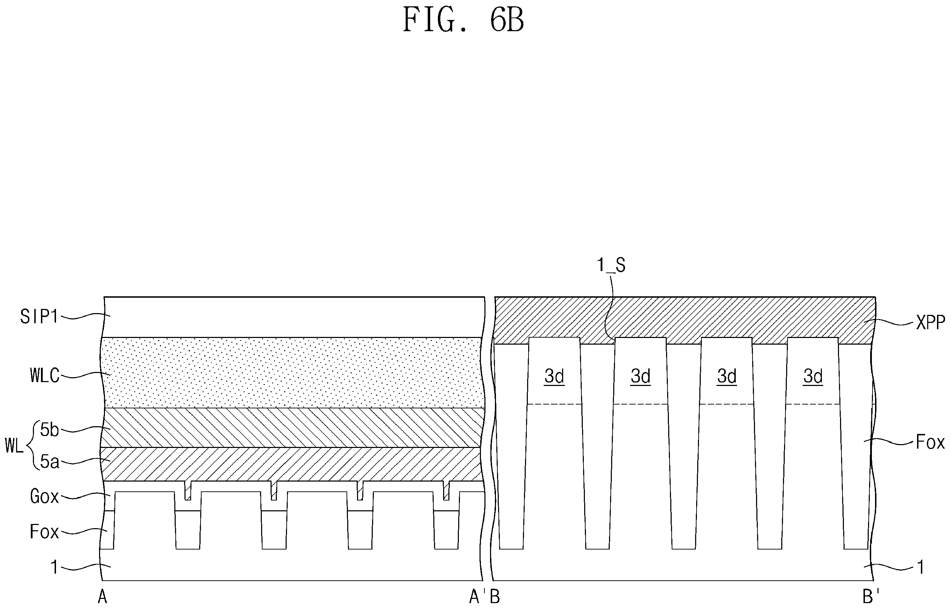

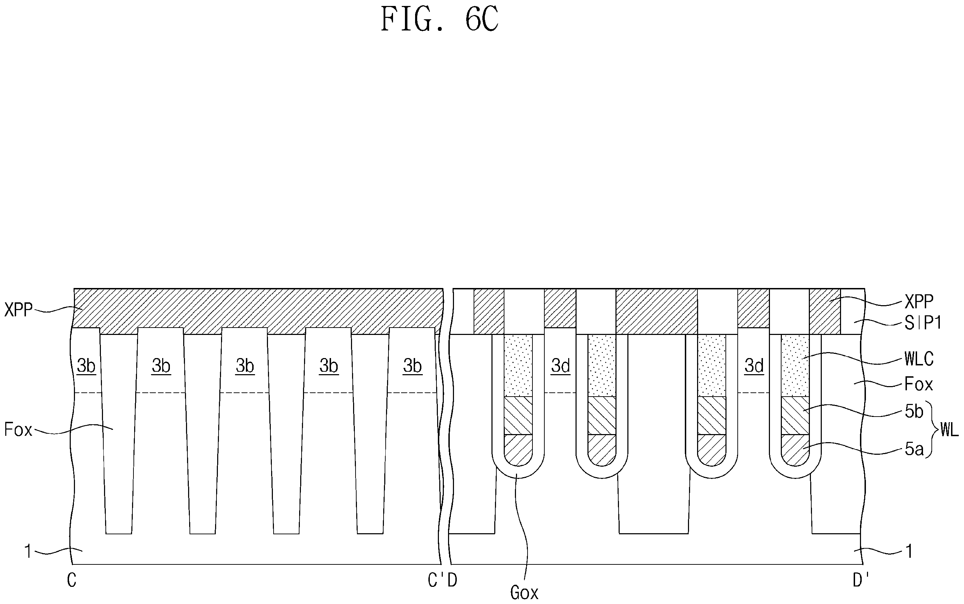

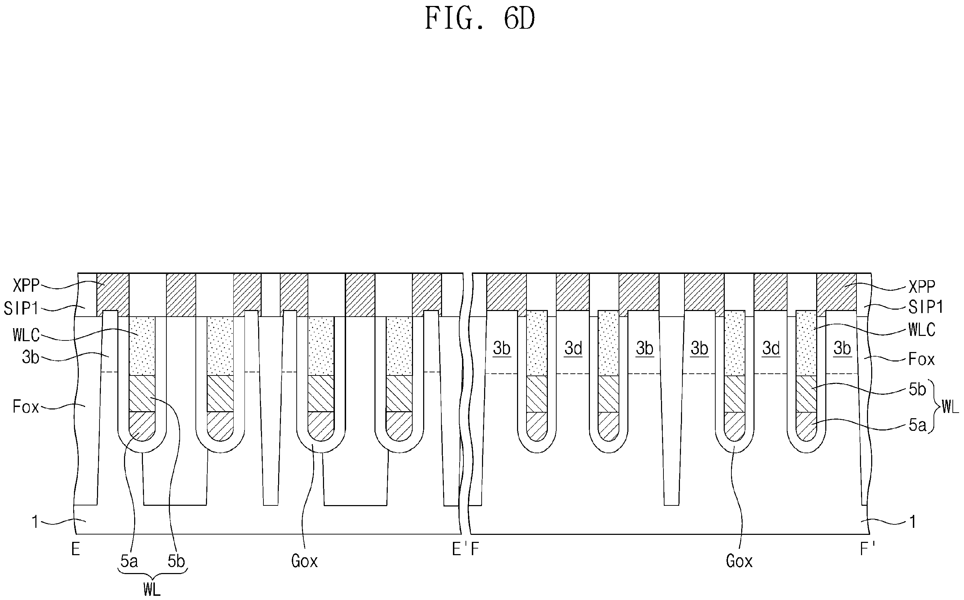

Referring to FIGS. 6A to 6D, preliminary pad patterns XPP are formed by etching the pad layer XPL. Each of the preliminary pad patterns XPP may have a line shape extending in the second direction X2. The preliminary pad patterns XPP may overlap the first and second impurity regions 3d and 3b, respectively. The word line capping patterns WLC may be exposed between preliminary pad patterns XPP. The preliminary pad patterns XPP may overlap a portion of the gate insulating layer Gox. A first pad separation layer is deposited on the substrate 1 and etched back to expose upper surfaces of the preliminary pad patterns XPP, while forming first pad separation patterns SIP1 between the preliminary pad patterns XPP, respectively. The first pad separation patterns SIP1 may overlap the word line capping patterns WLC. Each of the first pad separation patterns SIP1 may have a line shape extending in the second direction X2.

Referring to FIGS. 7A to 7D, the preliminary pad patterns XPP are cut (or etched) in the first direction X1 to form first conductive pads XPD and second conductive pads XPB. Accordingly, each of the first conductive pads XPD and the second conductive pads XPB may be formed to have a trapezoidal shape. The first conductive pads XPD may overlap the first impurity regions 3d. The first conductive pads XPD may be in direct contact with the first impurity regions 3d. The second conductive pads XPB may overlap the second impurity regions 3b. The second conductive pads XPB may be in direct contact with the second impurity regions 3b. When the preliminary pad patterns XPP are etched, the first pad separation patterns SIP1 may also be etched to have a trapezoidal shape. The preliminary pad patterns XPP may be etched so that upper surfaces of the device isolation part Fox and upper surfaces of the word line capping patterns WLC may be partially exposed. A second pad separation layer is filled in portions where the preliminary pad patterns XPP are etched, and etched back to expose upper surfaces of the first conductive pads XPD, second conductive pads XPB, and first pad separation patterns SIP1, while second pad separation patterns SIP2 are formed. The second pad separation patterns SIP2 may have a line shape extending in the first direction X1.

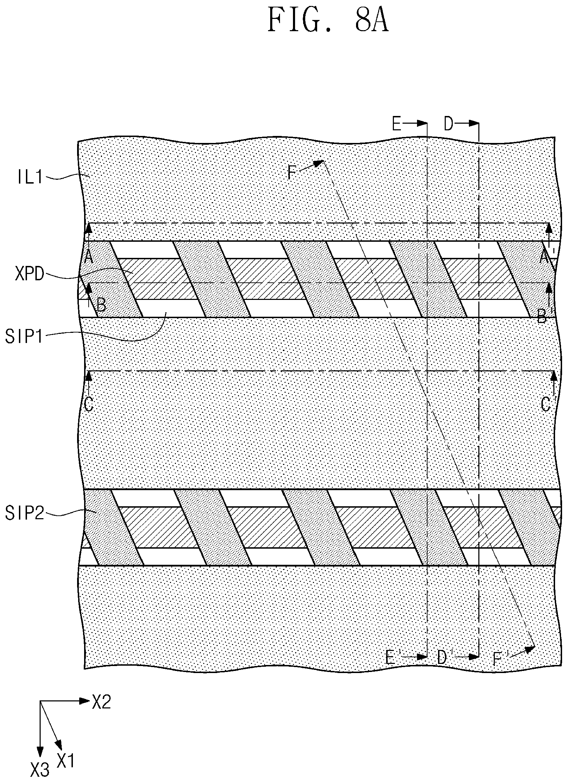

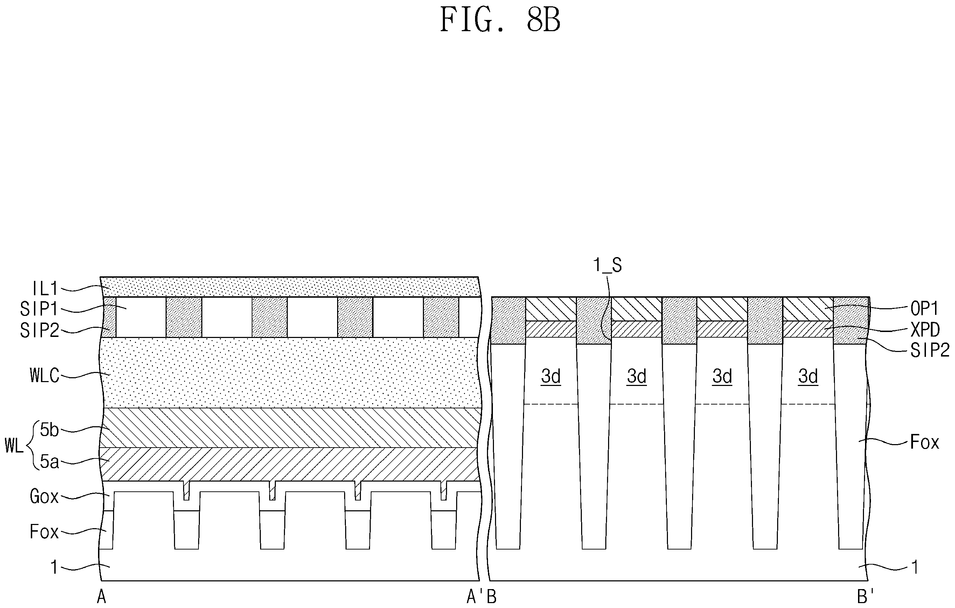

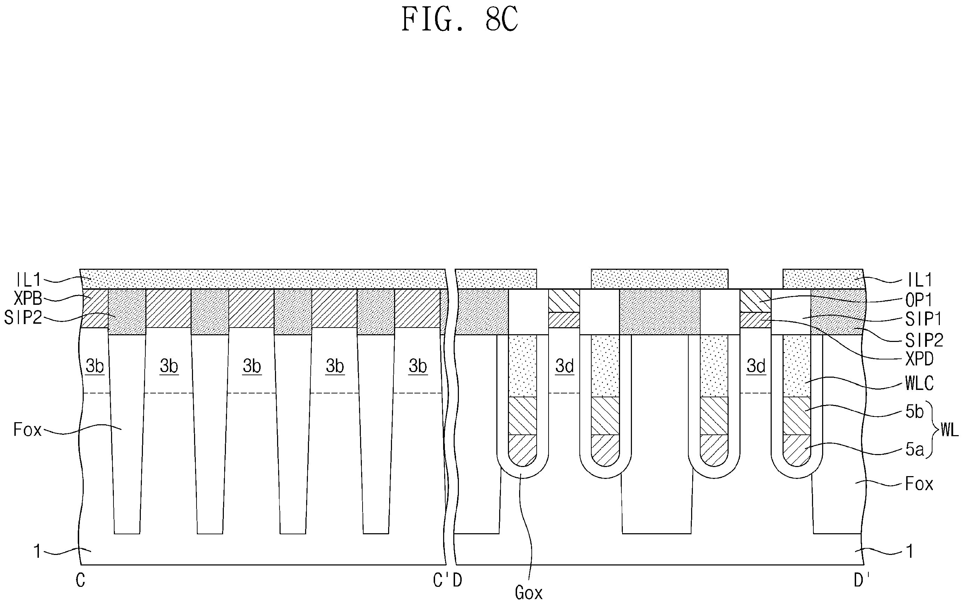

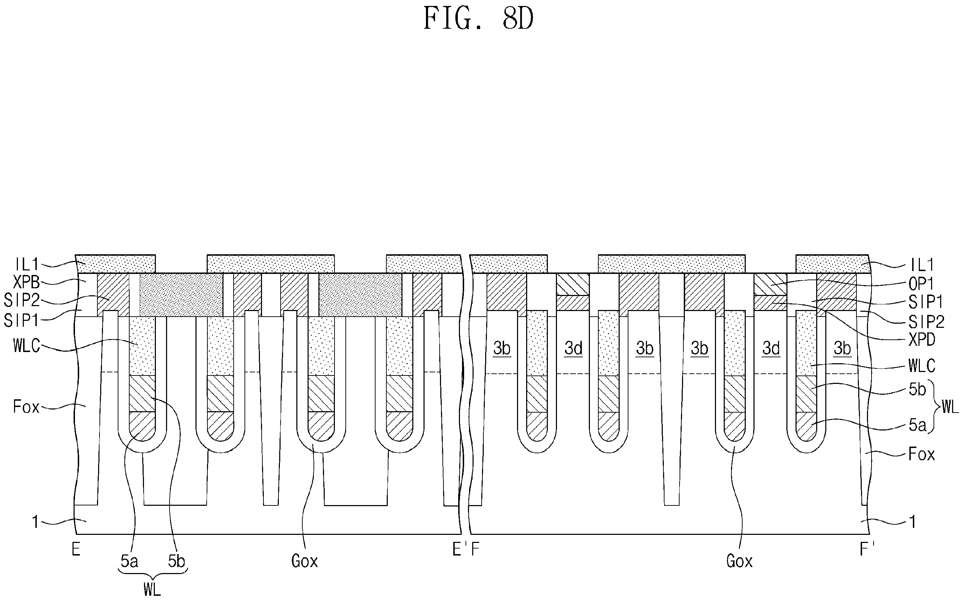

Referring to FIGS. 8A to 8D, first interlayer insulating layers IL1 are formed on the second conductive pads XPB, the first pad separation patterns SIP1, and the second pad separation patterns SIP2. The first interlayer insulating layers IL1 may have a line shape extending in the second direction X2. The first conductive pads XPD, portions of the second pad separation patterns SIP2, and portions of the first pad separation patterns SIP1 may be exposed between the first interlayer insulating layers IL1. A metal layer is deposited on the first interlayer insulating layers IL1 so that the metal layer is in contact with the first conductive pads XPD, and then an annealing process is performed to form first ohmic patterns OP1. A metal of the metal layer may combine with silicon of the first conductive pads XPD to be changed into metal silicide constituting the first ohmic patterns OP1. After the annealing process, the unreacted metal layer is removed, and upper surfaces of the first interlayer insulating layers IL1, the portions of the second pad separation patterns SIP2, and the portions of the first pad separation patterns SIP1 are exposed. In the annealing process, the second pad separation patterns SIP2 are covered with the first interlayer insulating layers IL1, the ohmic pattern is not formed on the second pad separation patterns SIP2.

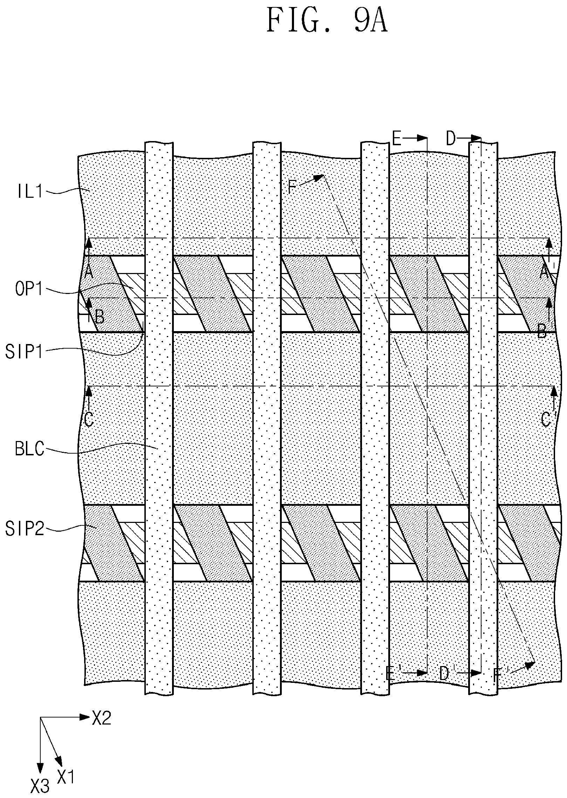

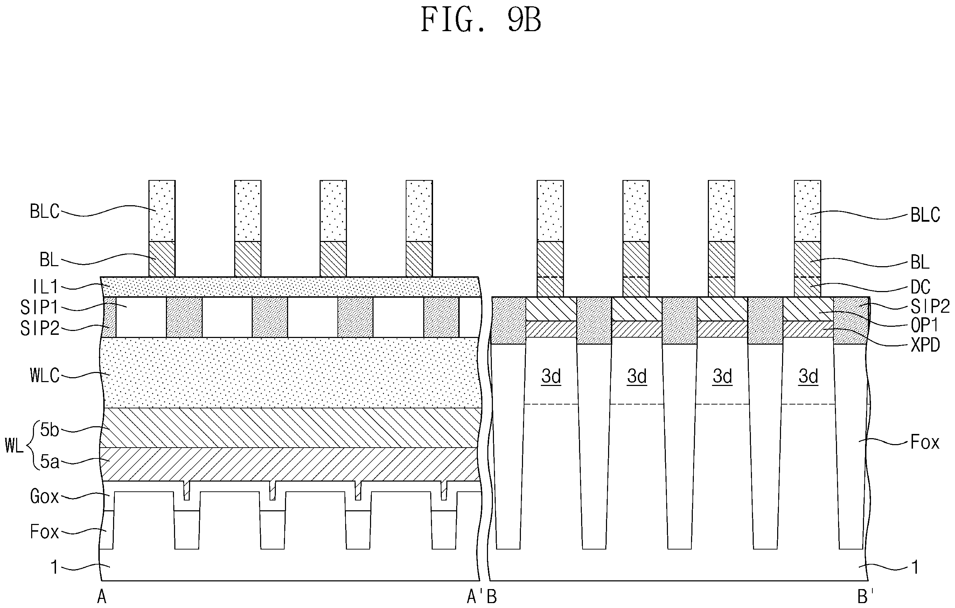

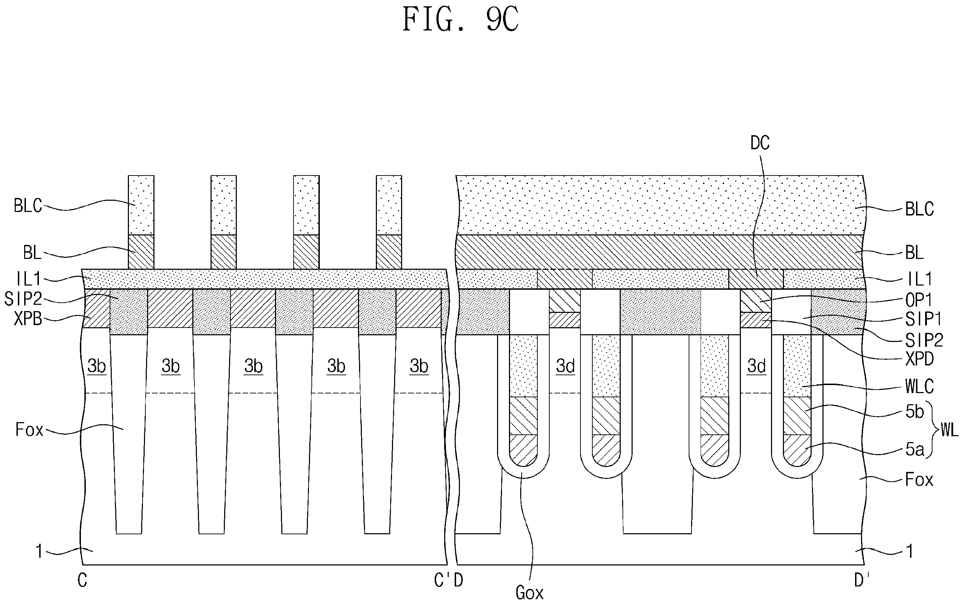

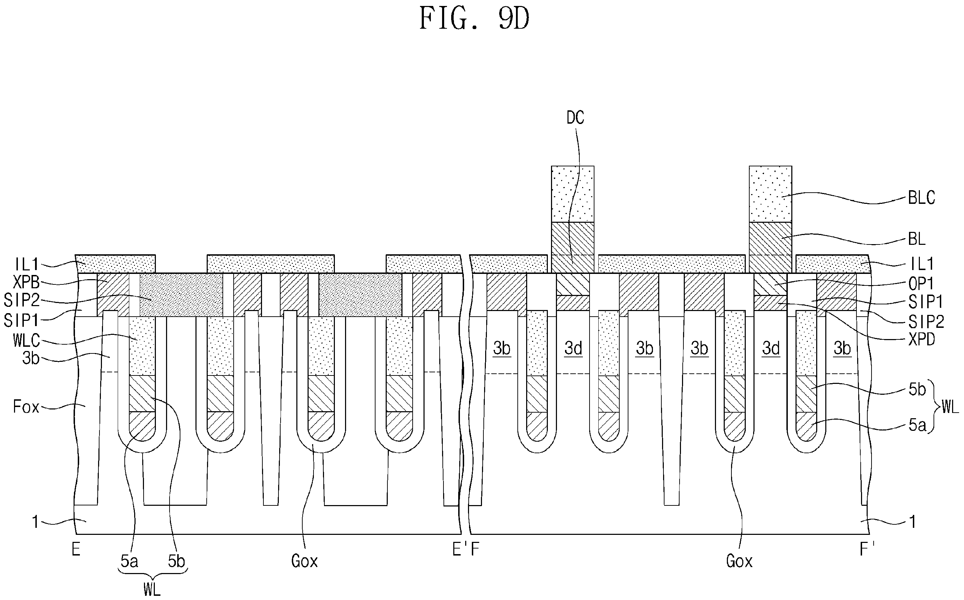

Referring to FIGS. 9A to 9D, a bit line conductive layer on the entire surface of the substrate 1 may be formed to fill a space between the first interlayer insulating layers IL1. A bit line capping layer is formed on the bit line conductive layer. Third mask patterns are formed on the bit line capping layer. The bit line capping layer and the bit line conductive layer are sequentially etched using the third mask patterns as an etch mask to form bit line capping patterns BLC and bit lines BL. A bit line contact DC may be formed under the bit lines BL. When viewed in a plan view, the bit line capping patterns BLC and the bit lines BL may have a line shape extending in the third direction X3. Portion of the first ohmic patterns OP1, portions of the second pad separation patterns SIP2, and portions of the first pad separation patterns SIP1 may be exposed between the bit lines BL.

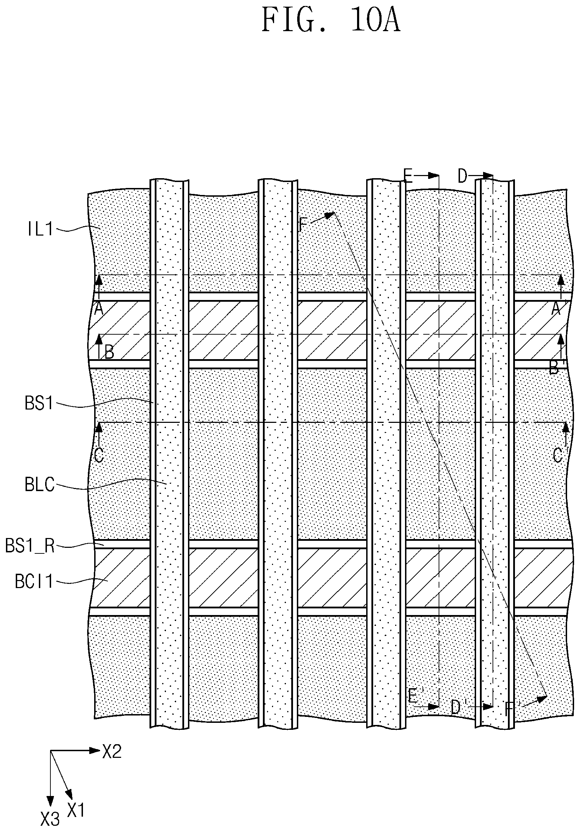

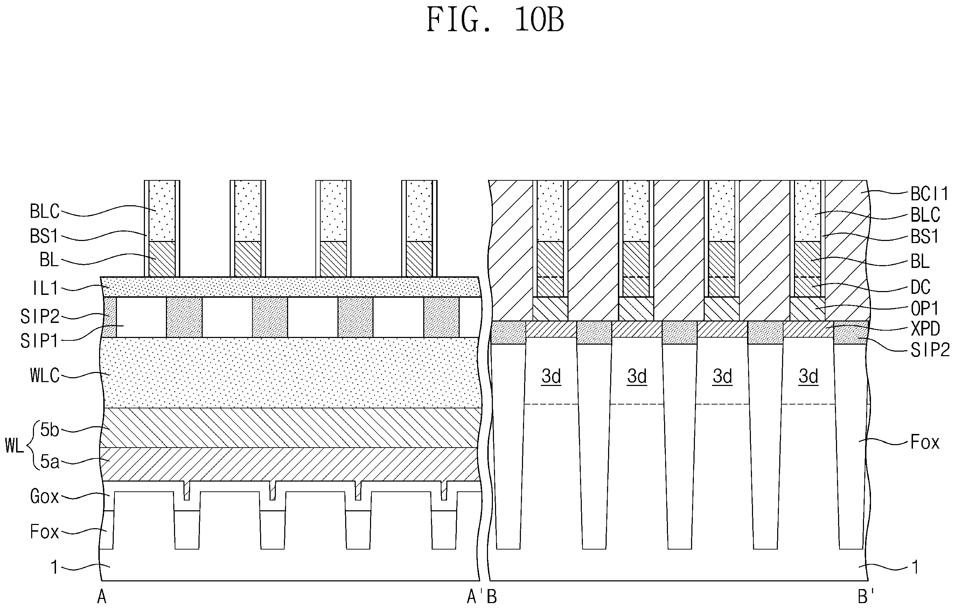

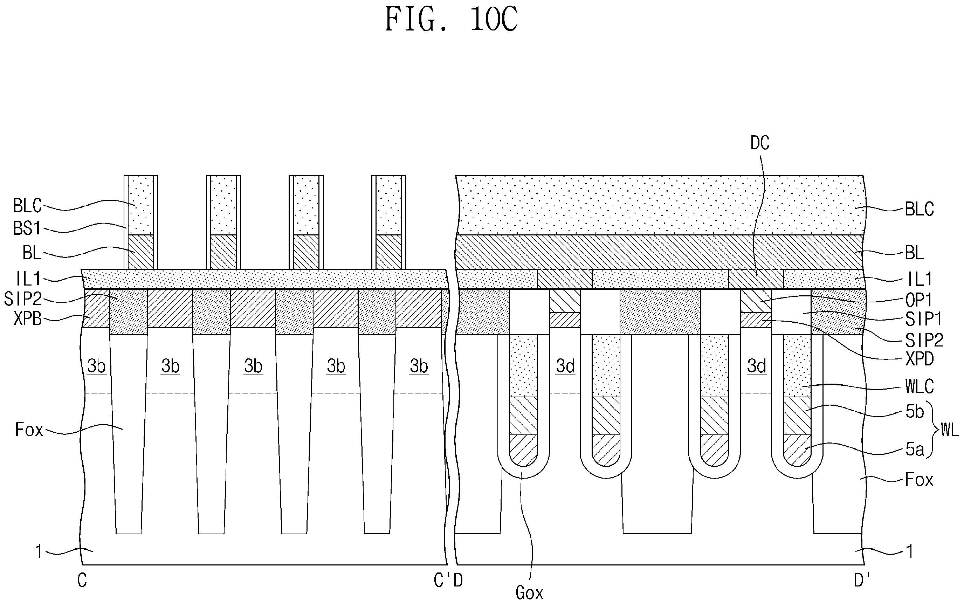

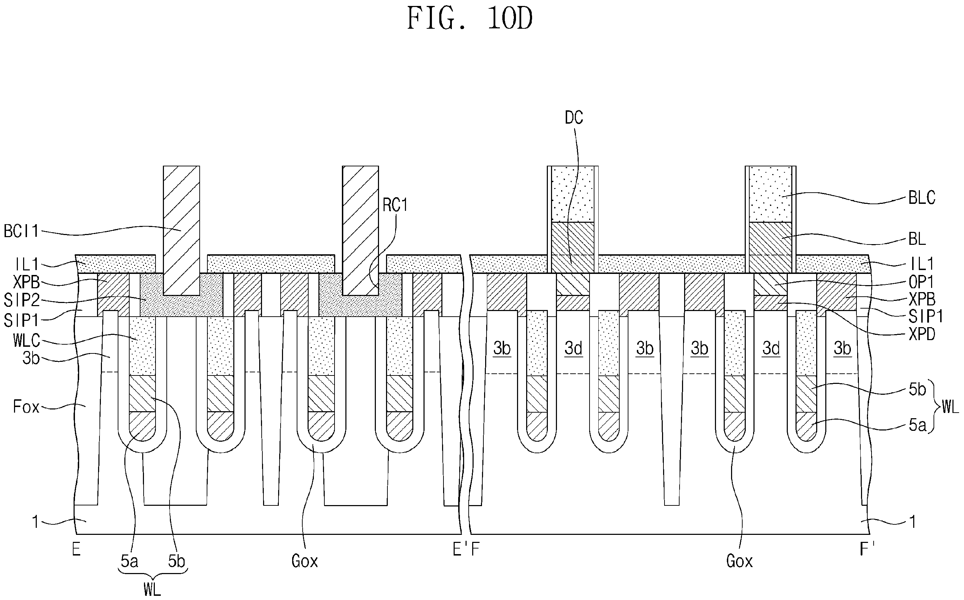

Referring to FIGS. 10A to 10D, a first spacer layer is conformally deposited on the entire surface of the substrate 1 and is anisotropically etched to form a first bit line spacer BS1 that covers sidewalls of the bit line capping patterns BLC and the bit lines BL. As illustrated in the cross section E-E' of FIG. 10D, a portion of the first spacer layer may cover a sidewall of the first interlayer insulating layer IL1 to form a remaining first spacer pattern BS1_R. Portions of the first ohmic patterns OP1 and the second pad separation patterns SIP2 next to the bit lines BL may also be etched by the anisotropic etching process. As a result, a first recess region RC1 may be formed on the second pad separation patterns SIP2 as shown in the cross section E-E' of FIG. 10D. A first contact separation pattern layer is deposited on the entire surface of the substrate 1 and is patterned to form first contact separation patterns BCI1 and to expose upper surfaces of the bit line capping patterns BLC. The first contact separation patterns BCI1 may be arranged in one column in the second direction X2. Some of the first contact separation patterns BCI1 may be disposed in the first recess region RC1.

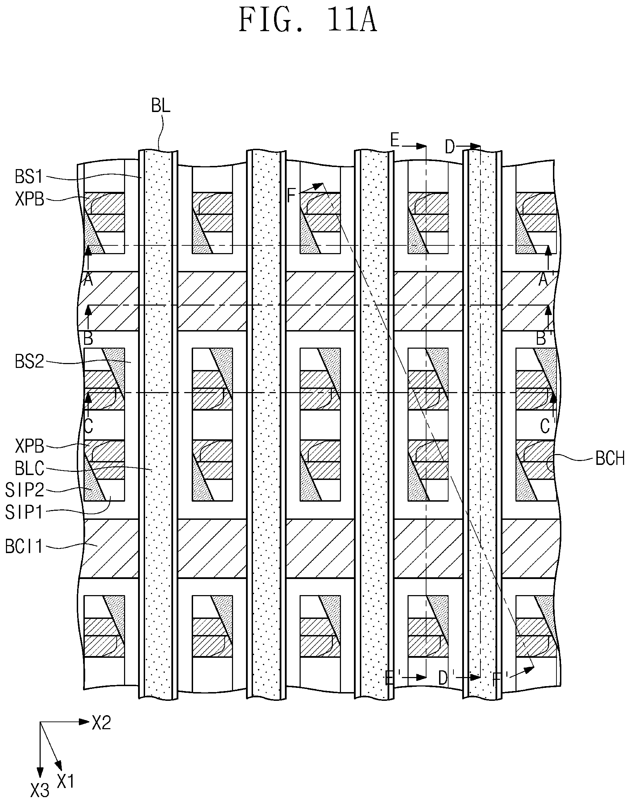

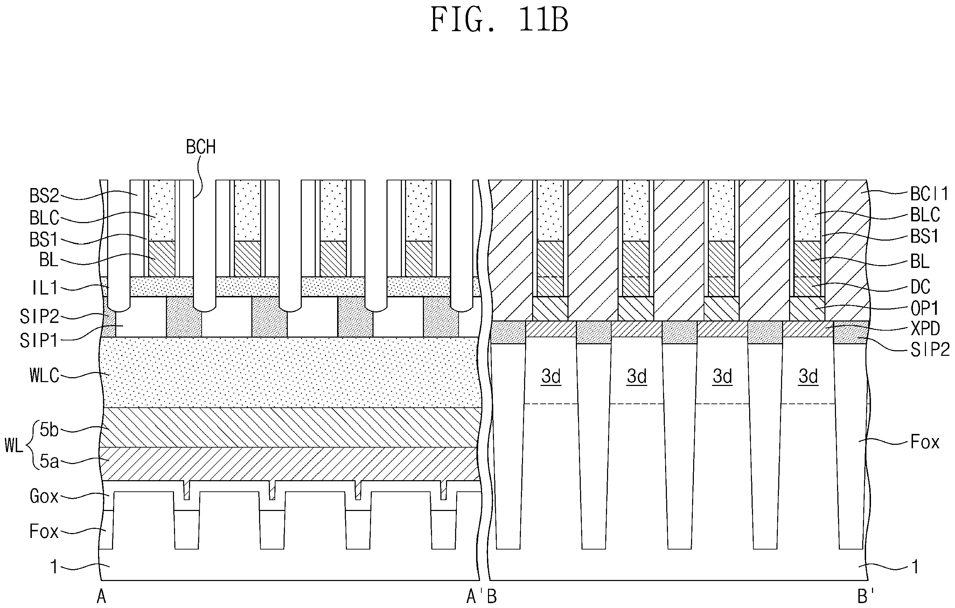

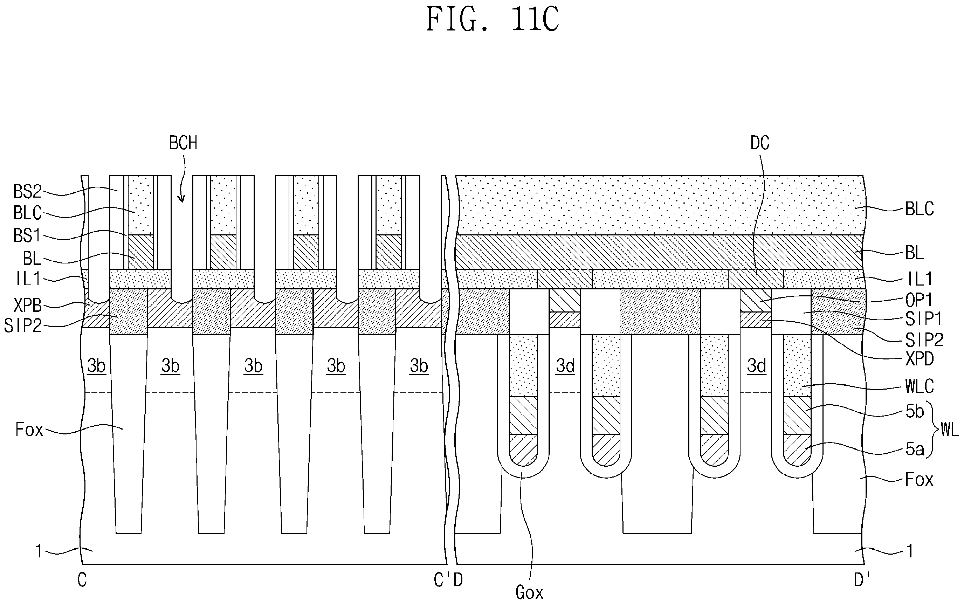

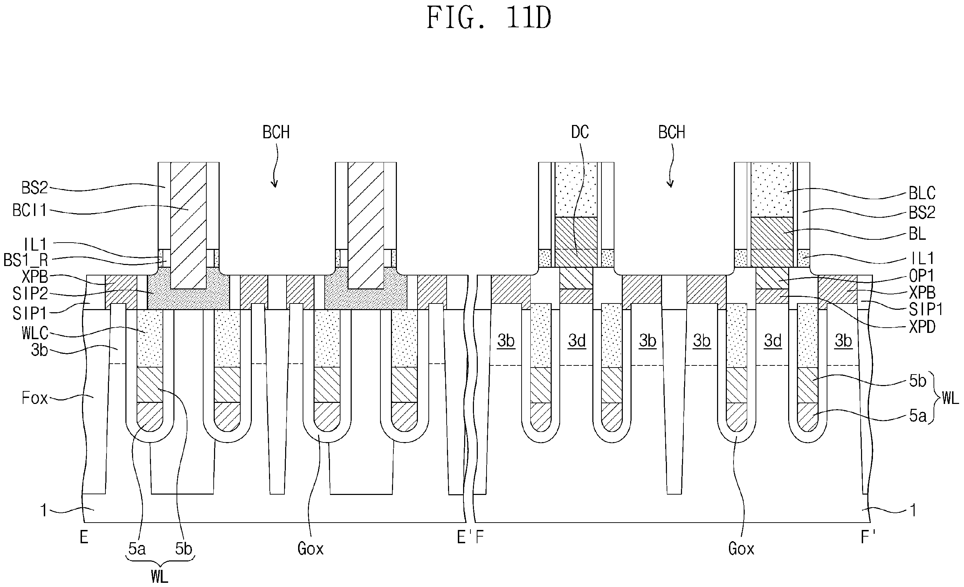

Referring to FIGS. 11A to 11D, a second spacer layer is conformally deposited on the entire surface of the substrate 1 and anisotropically etched to form second bit line spacers BS2 and to expose the first interlayer insulating layer IL1 between the first contact separation patterns BCI1 in the third direction X3. Referring to FIG. 11A, the second bit line spacers BS2 may have a quadrangular closed curve shape when viewed in a plan view. The second bit line spacers BS2 cover sidewalls of the first bit line spacer BS1 and sidewalls of the first contact separation patterns BCI1. The first interlayer insulating layer IL1 is anisotropically etched using the second bit line spacers BS2 as an etch mask to form a contact hole BCH that exposes the second conductive pads XPB under the first interlayer insulating layer IL1. The bottom of the contact hole BCH may be rounded. In this case, portions of the second pad separation patterns SIP2 and portions of the first pad separation patterns SIP1 may also be etched. One contact hole BCH may expose two second conductive pads XPB adjacent in the third direction X3 .

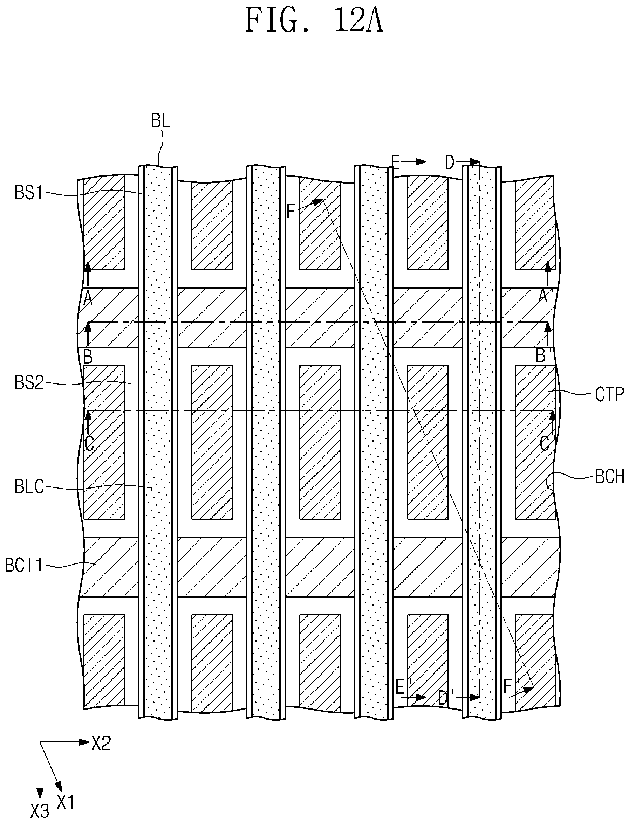

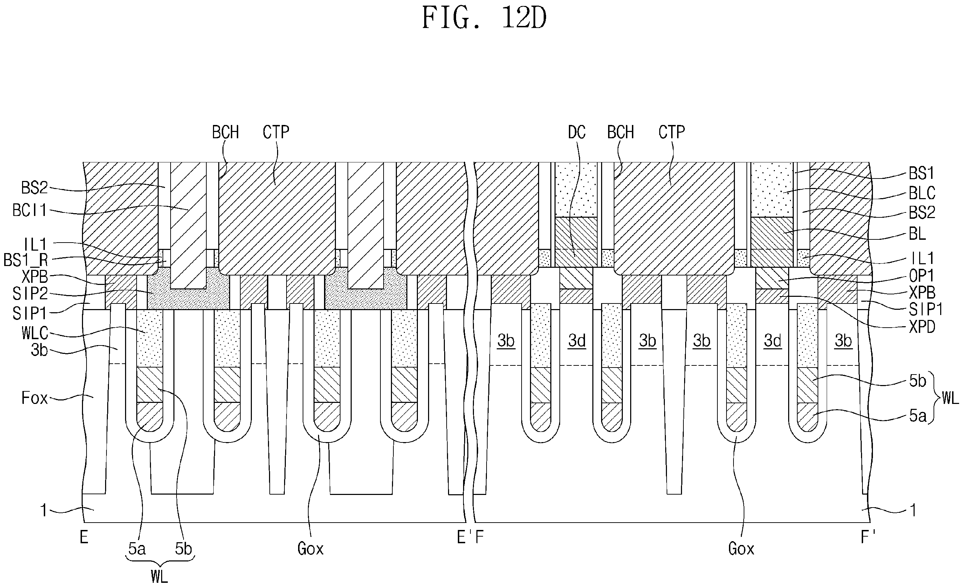

Referring to FIGS. 12A to 12D, a first contact layer is formed on the entire surface of the substrate 1 and is etched back to form a first preliminary contact pattern CTP in the contact hole BCH and to expose upper surfaces of the second bit line spacer BS2, bit line capping patterns BLC, and first contact separation patterns BCI1. The first preliminary contact pattern CTP may be formed of polysilicon doped with impurities. One first preliminary contact pattern CTP may be in contact with two adjacent second conductive pads XPB.

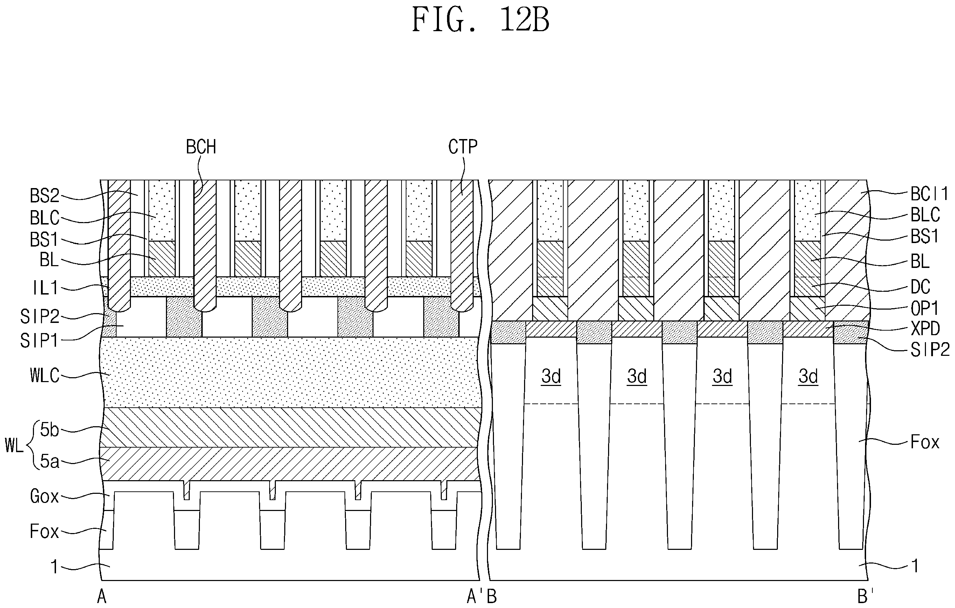

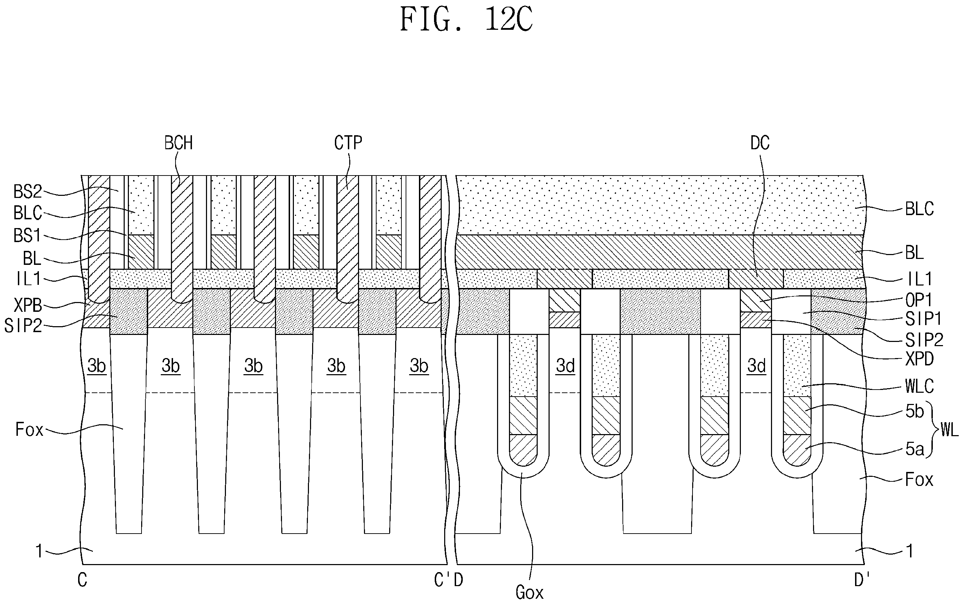

Cross sections of FIG. 13A taken along line A-A' and line B-B' may be the same as cross sections A-A' and B-B' of FIG. 12B, respectively. Cross sections of FIG. 13A taken along line C-C' and line D-D' may be the same as cross sections of FIG. 12C taken along line C-C' and line D-D', respectively.

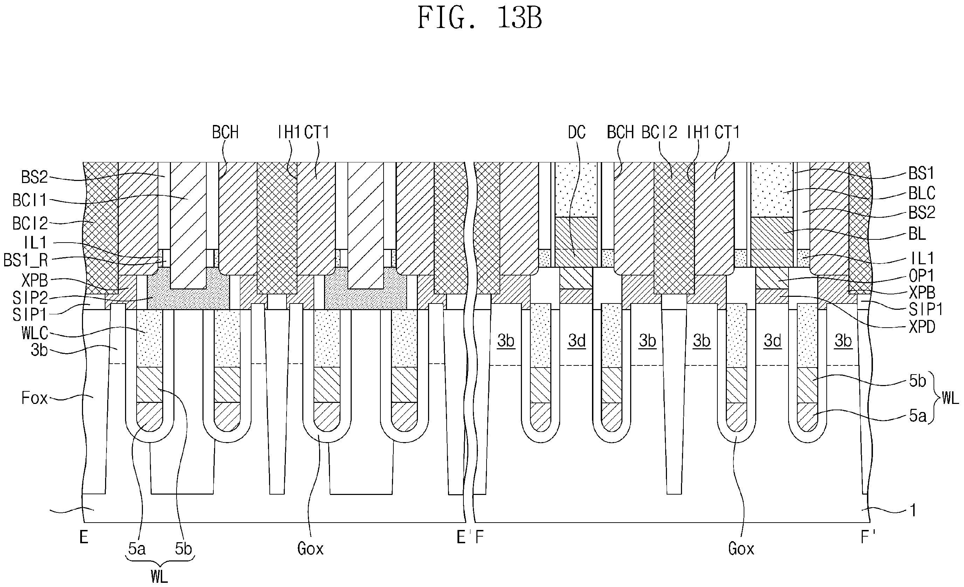

Referring to FIGS. 13A and 13B, the first preliminary contact patterns CTP are anisotropically etched to form first contacts CT1. In this case, one first preliminary contact pattern CTP may be etched to form two first contacts CT1 in one contact hole BCH. A first separation hole IH1 may be formed between the first contacts CT1. A portion of the second conductive pads XPB and a portion of the first pad separation pattern SIP1 may be etched through the anisotropic etching process. A second contact separation pattern layer is deposited on the entire surface of the substrate 1 to fill the first separation hole IH1 and is etched back. Thus, the second contact separation pattern BCI2 is formed in the first separation hole IH1, and upper surfaces of the first contacts CT1, the first contact separation patterns BCI1, and the bit line capping patterns BLC are exposed.

Referring to FIGS. 14A to 14D, upper portions of the first contacts CT1 are removed to expose upper sidewalls of the second bit line spacer BS2. In addition, an upper portion of the second bit line spacer BS2 is removed to expose an upper sidewall of the first bit line spacer BS1. A second contact layer is deposited on the entire surface of the substrate 1 and etched back to form second contacts CT2 on the first contacts CT1. Upper surfaces of the second contacts CT2 are lower than upper surfaces of the first and second contact separation patterns BCI1 and BCI2, and side surfaces of the first and second contact separation patterns BCI1 and BCI2 are exposed. The second contacts CT2 are formed to cover upper surfaces of the first contacts CT1 and an upper surface of the second bit line spacer BS2 and are in contact with an upper side surface of the first bit line spacer BS1. Widths of the second contacts CT2 may be wider than those of the first contacts CT1. One first contact CT1 and the second contact CT2 thereon may form a storage node contact structure BC.

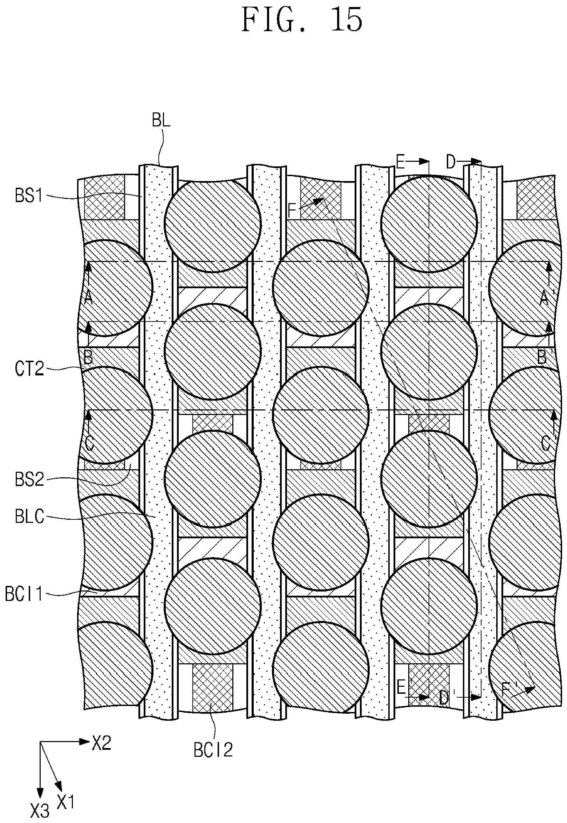

Subsequently, referring to FIGS. 15 and 2A to 2F, a landing pad layer is deposited on the substrate 1 and anisotropically etched to form landing pads LP. The width of the second contacts CT2 may be wider than that of the first contacts CT1, and thus a misalignment margin between the second contacts CT2 and the landing pads LP may be improved. Accordingly, the reliability of the semiconductor device 100 may be improved. Due to the anisotropic etching, the portions of the bit line capping pattern BLC, second contact separation pattern BCI2, and first contact separation pattern BCI1 may also be etched. A landing pad separation pattern LIP is formed between the landing pads LP. As a result, the semiconductor device 100 of FIGS. 1A to 2F may be manufactured.

The method of manufacturing the semiconductor device according to an embodiment of the present disclosure may secure the misalignment margin, thereby reducing process defects and improving yield.

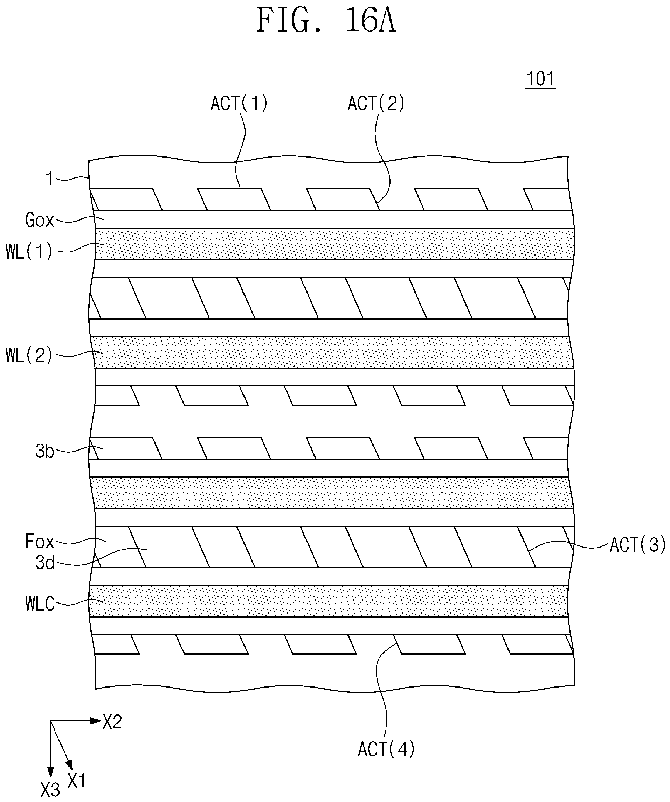

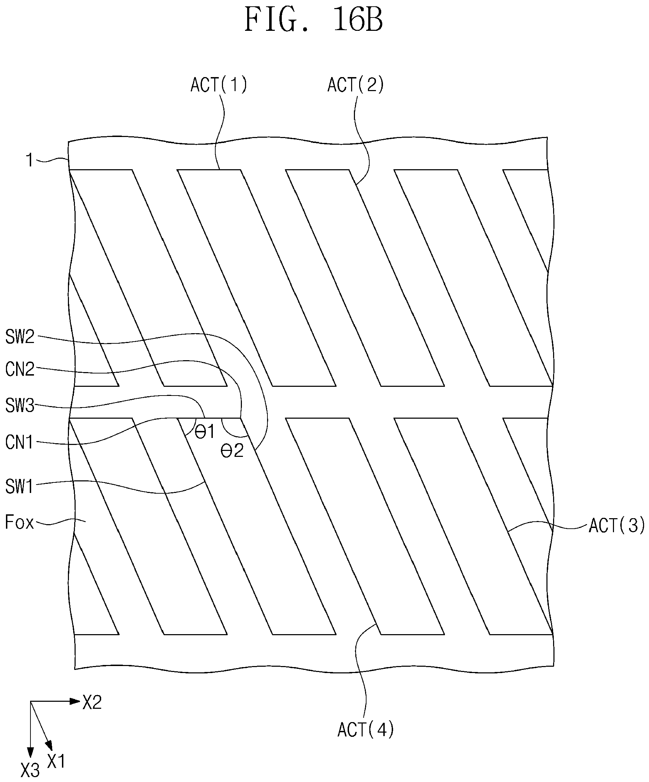

FIG. 16A is a plan view of a semiconductor device according to embodiments of the present disclosure. FIG. 16B is a plan view illustrating an arrangement of active regions of FIG. 16A.

Referring to FIGS. 16A and 16B, in a semiconductor device 101 according to the present embodiment, the each of active regions ACT crossing the word lines WL has angled corners CN1 and CN2 when viewed in a plan view. In other words, the corners CN1 and CN2 of the active regions ACT where the second impurity region 3b is disposed are angled rather than round as illustrated in FIG. 1A. For example, referring to FIG. 16B, each of the active regions ACT has first and second sidewalls SW1 and SW2 that are parallel to each other and opposite to each other in the first direction X1. The active regions ACT have a third sidewall SW3 connecting the first and second sidewalls SW1 and SW2. A first corner CN1 where the first sidewall SW1 and the third sidewall SW3 meet has a first angle θ1. A second corner CN2 where the second sidewall SW2 and the third sidewall SW3 meet has a second angle θ2. The first angle θ1 is an acute angle and the second angle θ2 is an obtuse angle. In other words, the first angle θ1 is less than the second angle θ2

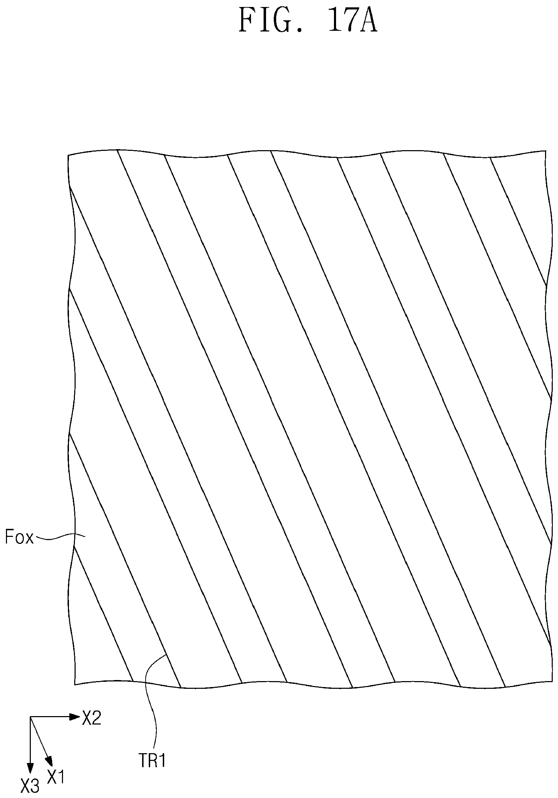

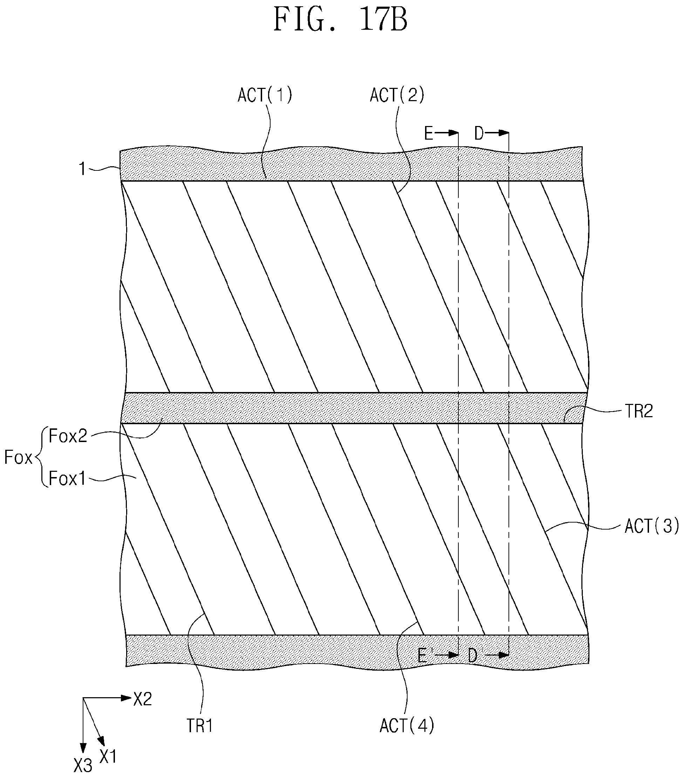

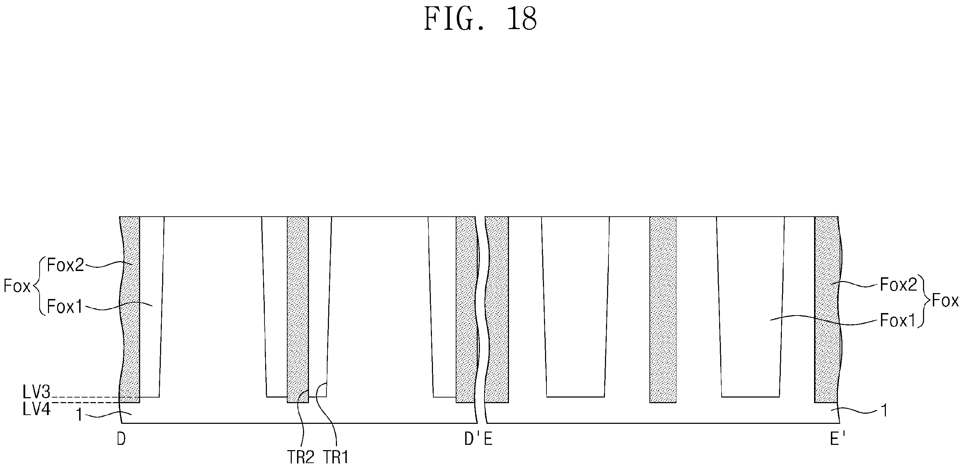

FIGS. 17A and 17B are plan views illustrating a method of manufacturing a semiconductor device having the active region of FIG. 16B. FIG. 18 includes cross-sectional views of FIG. 17B taken along lines D-D' and E-E'.

The device isolation part Fox in the semiconductor device 101 having the structure of the active regions ACT of FIGS. 16A and 16B may have a double structure including a first device isolation part Fox1 and a second device isolation part Fox2 as shown in FIGS. 17B and 18. The first device isolation part Fox1 may have a bar shape elongated in the first direction X1. The second device isolation part Fox2 may have a line shape elongated in the second direction X2. A level LV4 of a lower surface of the second device isolation part Fox2 may be lower than a level LV3 of the first device isolation part Fox1. Each of the first device isolation part Fox1 and the second device isolation part Fox2 may have a structure of at least one single layer or multiple layers selected from silicon oxide, silicon nitride, and silicon oxynitride. Other structures may be the same/similar to those described above.

To manufacture the semiconductor device 101 having the structure of the active regions ACT of FIGS. 16A and 16B, first, referring to FIG. 17A, the substrate 1 is etched to form first trenches TR1. The first device isolation parts Fox1 are formed by filling the first trenches TR1 with an insulating layer. The first device isolation parts Fox1 may be formed to have a line shape extending in the first direction X1.

Referring to FIGS. 17B and 18, the first device isolation parts Fox1 and the substrate 1 are etched to form second trenches TR2. The second device isolation parts Fox2 are formed by filling the second trenches TR2 with an insulating layer. Other manufacturing methods may be the same/similar to those described above.

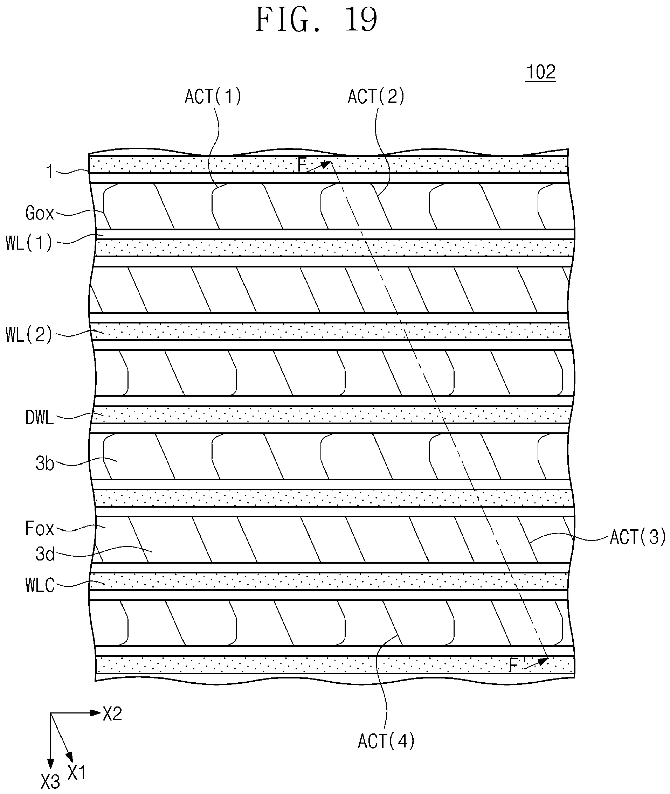

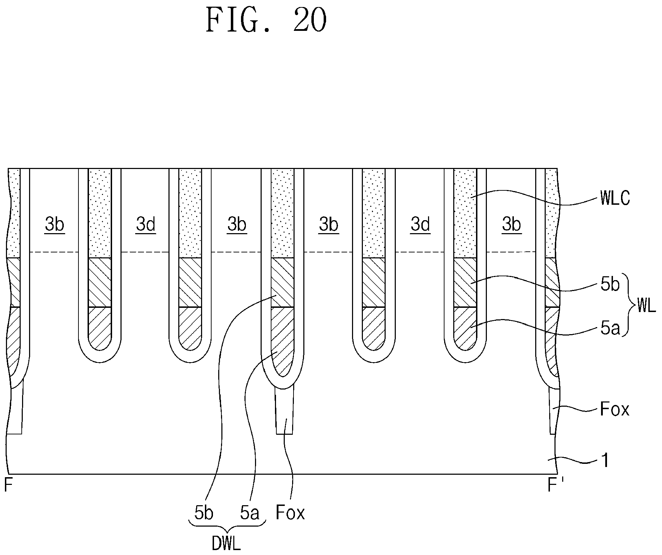

FIG. 19 is a plan view of a semiconductor device according to embodiments of the present disclosure. FIG. 20 is a cross-sectional view of FIG. 19 taken along line F-F'.

Referring to FIGS. 19 and 20, a dummy word line DWL may extend in the second direction X2 and may be interposed between the first and second active regions ACT(1) and ACT(2) and the third and fourth active regions ACT(3) and ACT(4). The dummy word line DWL may be interposed between adjacent second impurity regions 3b. The dummy word line DWL does not actually operate. A ground voltage may be applied to the dummy word line DWL or the dummy word line DWL may be electrically floated. The dummy word line DWL is disposed within the device isolation part Fox. The dummy word line DWL includes a first word line pattern 5a and a second word line pattern 5b sequentially stacked. A word line capping pattern WLC is disposed on the dummy word line DWL. A gate insulating layer Gox is disposed between the dummy word line DWL and the substrate 1. Other structures may be the same/similar to those described above.

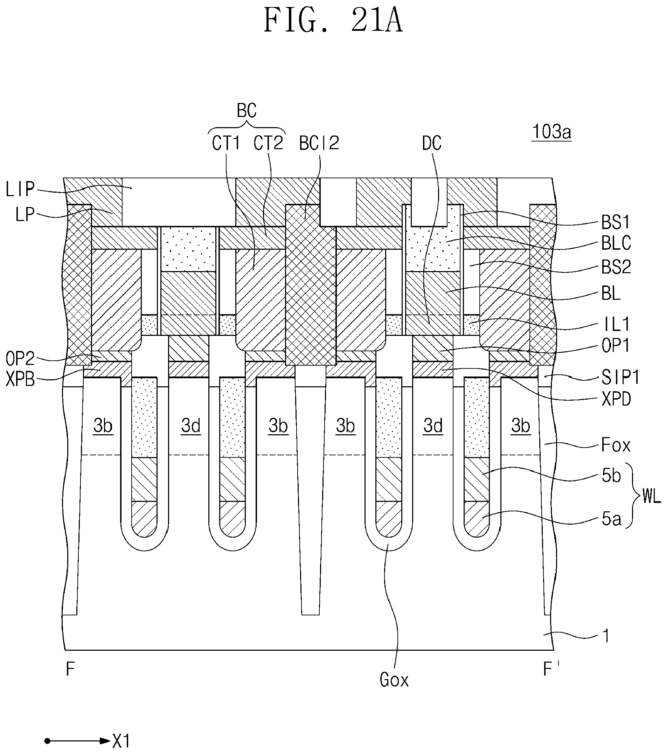

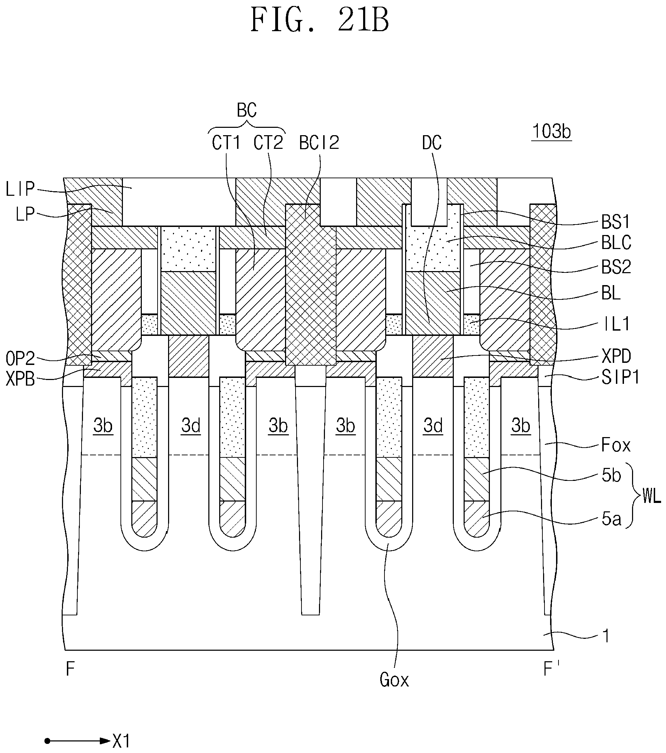

FIGS. 21A and 21B are cross-sectional views of FIG. 1A taken along line F-F' according to embodiments of the present disclosure.

Referring to FIG. 21A, a semiconductor device 103a according to the present embodiment further includes a second ohmic pattern OP2 disposed on the second conductive pad XPB. The second ohmic pattern OP2 may include metal silicide. The second ohmic pattern OP2 may be interposed between the second conductive pad XPB and the first contact CT1. The second ohmic pattern OP2 may be in direct contact with each of the second conductive pad XPB and the first contact CT1. Side surfaces of the second ohmic pattern OP2 and the second conductive pad XPB may be aligned with each other. Other structures may be the same/similar to those described above.

In the semiconductor device 103a according to the present embodiment, after the steps of FIGS. 7A to 7D and before forming the first interlayer insulating layer IL1 of FIGS. 8A to 8D, the first and second conductive pads XPD and XPB may be silicided to simultaneously form the first and second ohmic patterns OP1 and OP2. In FIGS. 8A to 8D, the first ohmic patterns OP1 are not additionally formed. Other manufacturing processes may be the same/similar to those described above.

Referring to FIG. 21B, the semiconductor device 103b according to the present embodiment further includes the second ohmic pattern OP2 disposed on the second conductive pad XPB, and does not include the first ohmic pattern OP1 on the first conductive pad XPD. The first conductive pad XPD may be in direct contact with the bit line contact DC where the first ohmic pattern OP1 is not present. Other structures may be the same/similar to those described.

In the semiconductor device 103a according to the present embodiment, after the steps of FIGS. 7A to 7D and before forming the first interlayer insulating layer IL1 of FIGS. 8A to 8D, upper portions of the second conductive pads XPB are silicided. The second ohmic patterns OP2 may be formed. In FIGS. 8A to 8D, the first ohmic patterns OP1 are not formed. Other manufacturing processes may be the same/similar to those described above.

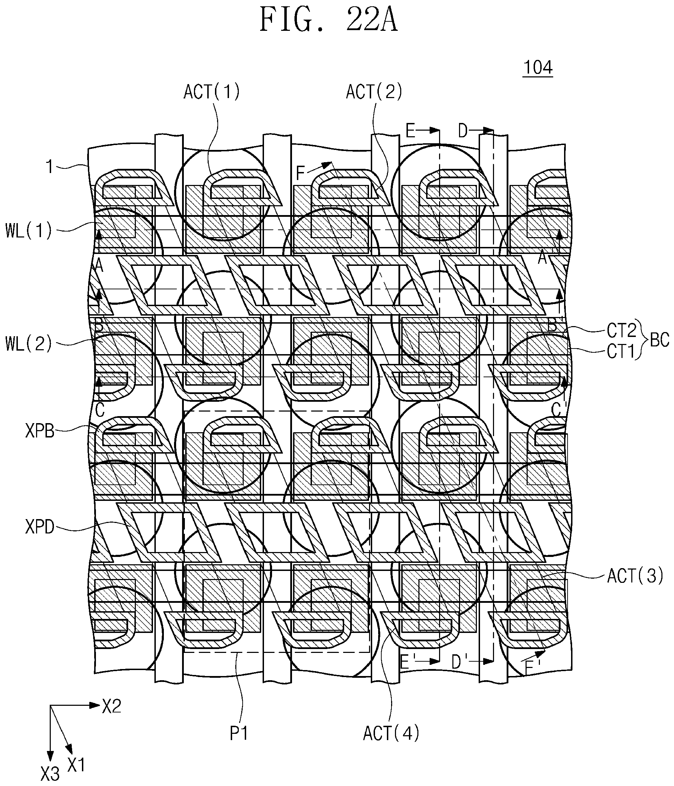

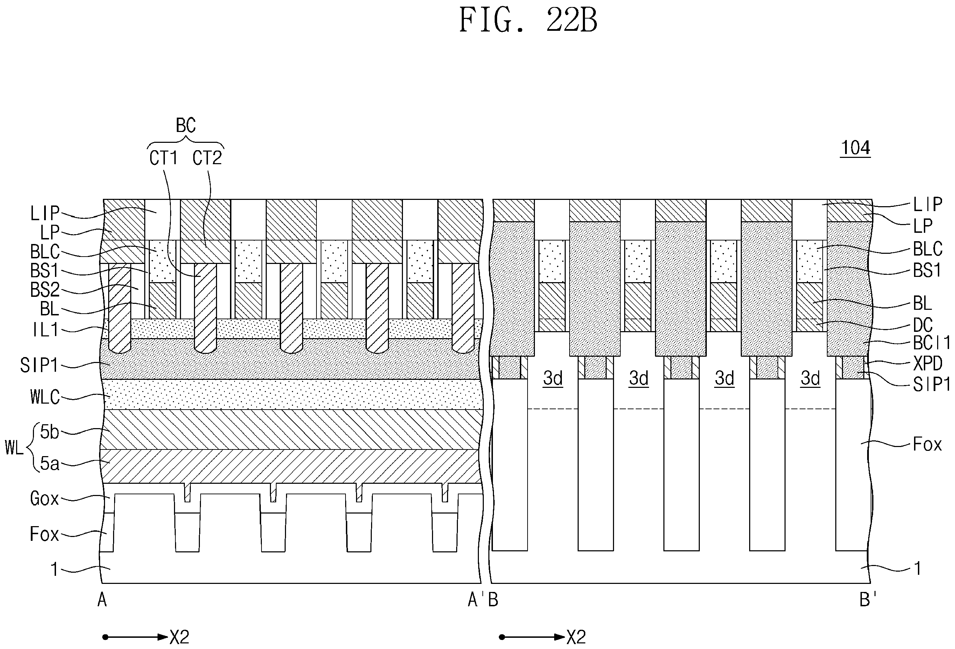

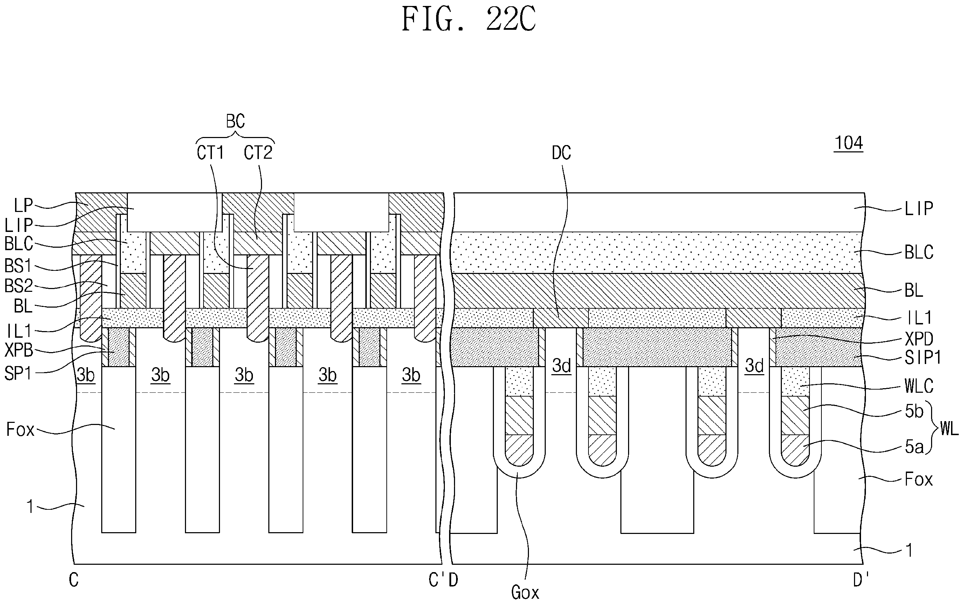

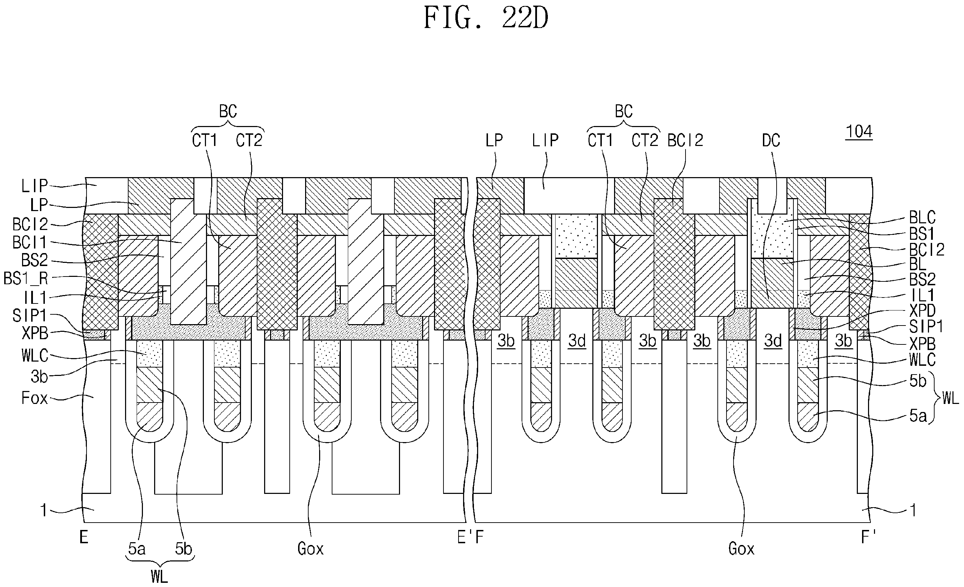

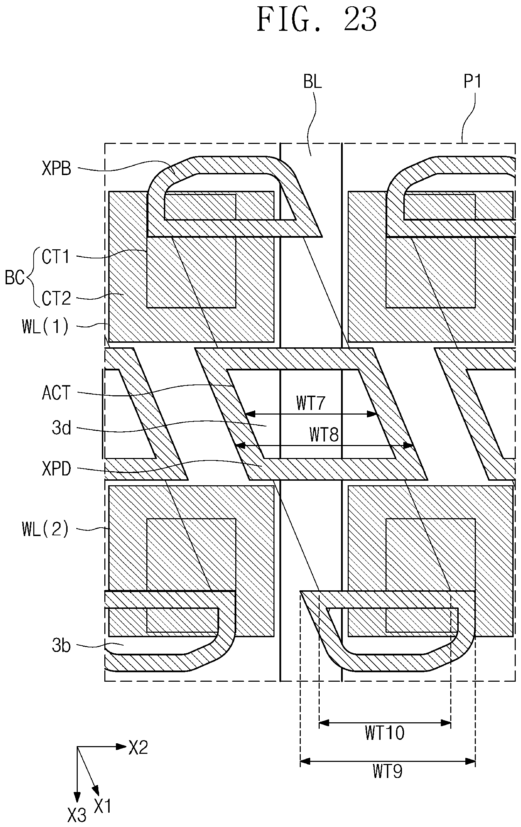

FIG. 22A is a plan view of a semiconductor device according to embodiments of the present disclosure. FIG. 22B is cross-sectional views of FIG. 22A taken along lines A-A' and B-B'. FIG. 22C is cross-sectional views of FIG. 22A taken along line C-C' and line D-D'. FIG. 22D is cross-sectional views of FIG. 22A taken along lines E-E' and F-F'. FIG. 23 is an enlarged view of portion 'P1' of FIG. 22A.

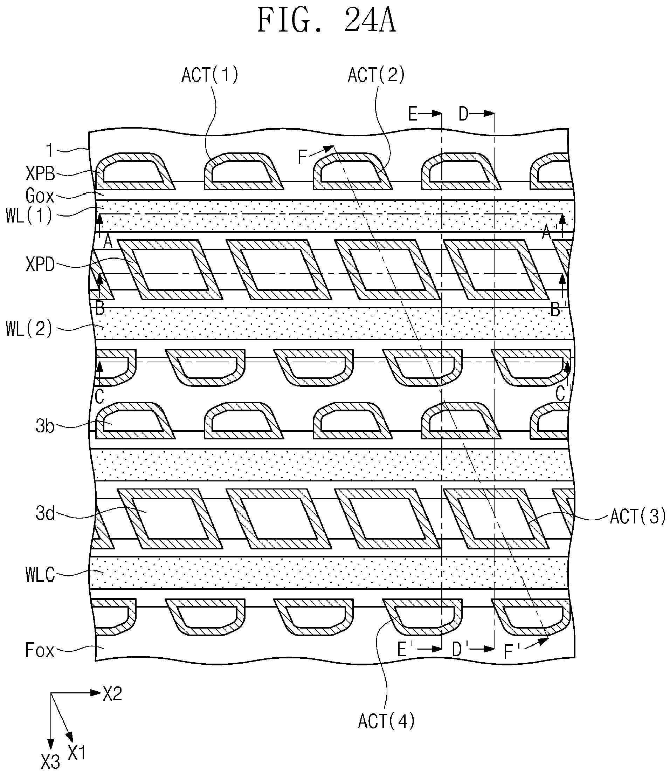

Referring to FIGS. 22A to 22D and FIG. 23, in a semiconductor device 104 according to the present embodiment, when viewed in a plan view, the first conductive pad XPD surrounds the first impurity region 3d and the second conductive pad XPB surrounds the second impurity region 3b (refer to FIG. 24A). The first conductive pad XPD does not cover the upper surface of the first impurity region 3d. The second conductive pad XPB does not cover the upper surface of the second impurity region 3b. The first conductive pad XPD and the second conductive pad XPB are in contact with the side surface of the substrate 1. The first impurity region 3d may have a seventh width WT7 in the second direction X2. The first conductive pad XPD may have an eighth width WT8 greater than the seventh width WT7 in the second direction X2. The second impurity region 3b may have a ninth width WT9 in the second direction X2. The second conductive pad XPB may have a tenth width WT10 greater than the ninth width WT9 in the second direction X2 . The first conductive pad XPD and the second conductive pad XPB may overlap the device isolation part Fox and the gate insulating layer Gox. The first conductive pad XPD and the second conductive pad XPB may be in contact with the upper surfaces of the device isolation part Fox and the gate insulating layer Gox.

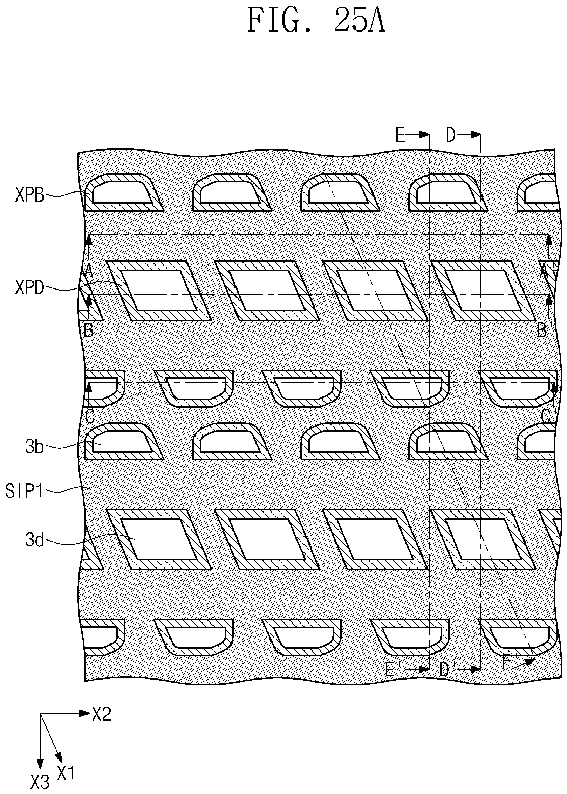

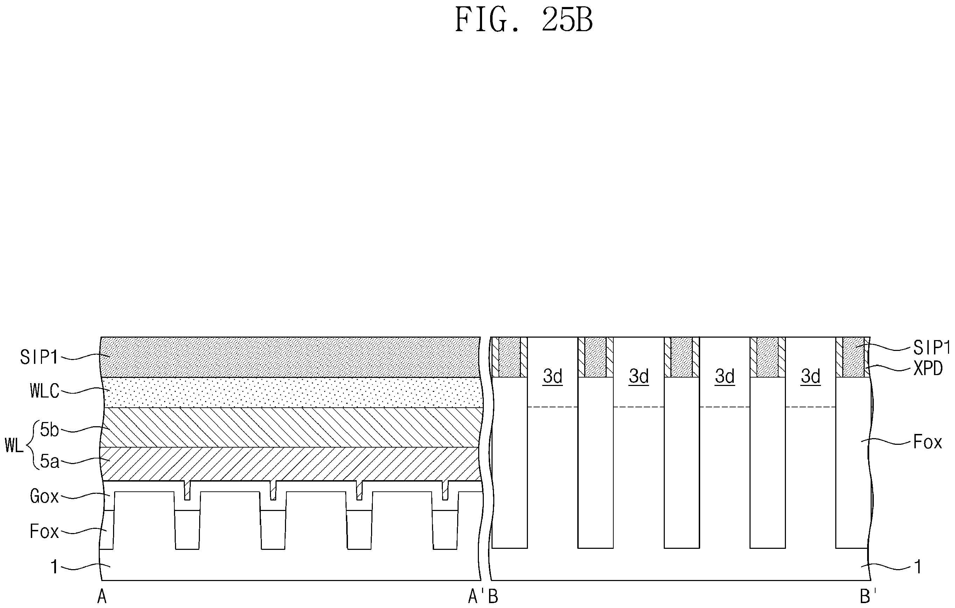

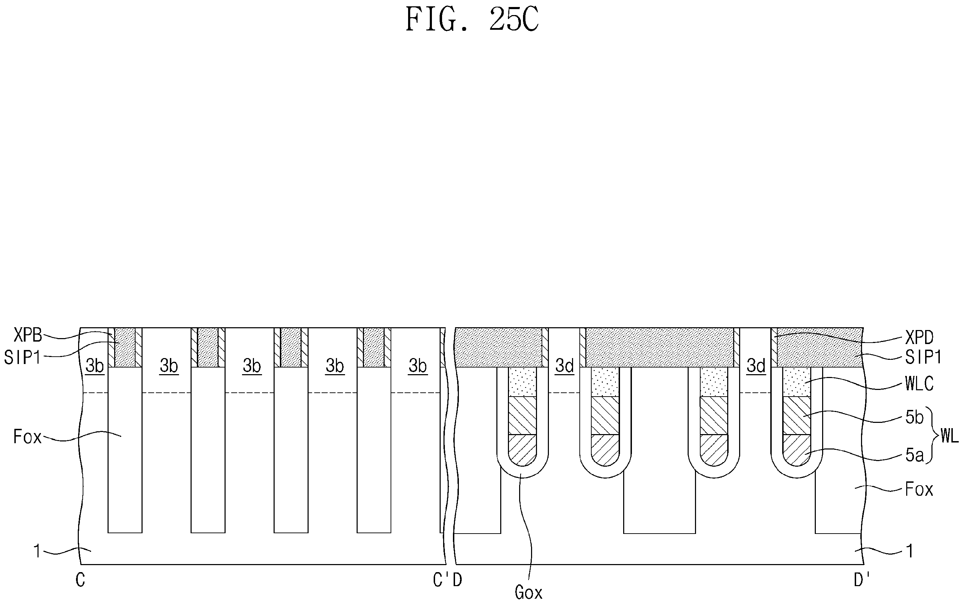

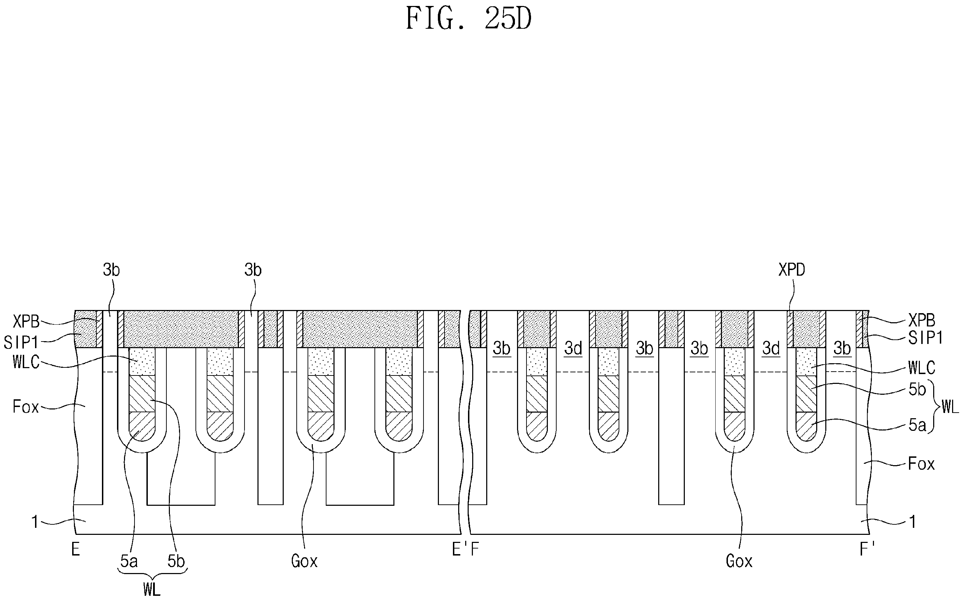

Referring to FIG. 25A, a space between the first conductive pads XPD may be filled with a first pad separation pattern SIP1. A space between the second conductive pads XPB may be filled with the first pad separation pattern SIP1. A space between the first conductive pad XPD and the second conductive pad XPB may also be filled with the first pad separation pattern SIP1. The first pad separation pattern SIP1 extends to cover upper surfaces of the device isolation part Fox, the gate insulating layer Gox, and the word line capping pattern WLC. The first pad separation pattern SIP1 does not cover the upper surface of the substrate 1. The semiconductor device 104 according to the present embodiment does not include the second pad separation pattern SIP2 of FIGS. 2A to 2F.

Referring to FIG. 23, each of the first conductive pad XPD and the second conductive pad XPB may have a hollow closed curve shape when viewed in a plan view. The first conductive pad XPD may have a trapezoidal closed curve shape, and the second conductive pad XPB may have a semicircular closed curve shape. The first and second impurity regions 3d and 3b are expanded due to the first conductive pad XPD and the second conductive pad XPB, and thus a contact area with the bit line contact DC and storage node contact structure BC to be formed later may be increased and a misalignment margin may be increased. As a result, the reliability of the semiconductor device 104 may be improved.

The semiconductor device 104 according to the present embodiment does not include the first ohmic pattern OP1 of FIGS. 2A to 2F. However, ohmic patterns may be additionally disposed on the first and second conductive pads XPD and XPB and on the first and second impurity regions 3d and 3b.

The first conductive pads XPD, the second conductive pads XPB, the first pad separation pattern SIP1, and the substrate 1 may be covered with a first interlayer insulating layer IL1. Bit lines BL are disposed on the first interlayer insulating layer IL1. The bit lines BL may extend in the third direction X3 and may be spaced apart from each other in the second direction X2. The bit lines BL may cross word line capping patterns WLC and word lines WL.

A bit line contact DC may be disposed between the bit lines BL and the first impurity region 3d. The bit line contact DC may be in contact with the first conductive pad XPD. The storage node contact structure BC vertically overlaps the second conductive pad XPB. First and second contact separation patterns BCI1 and BCI2 are alternately and repeatedly disposed between the storage node contact structures BC in the third direction X3. The first contact separation pattern BCI1 may be inserted into the first pad separation pattern SIP1. Other structures may be the same/similar to those described above.

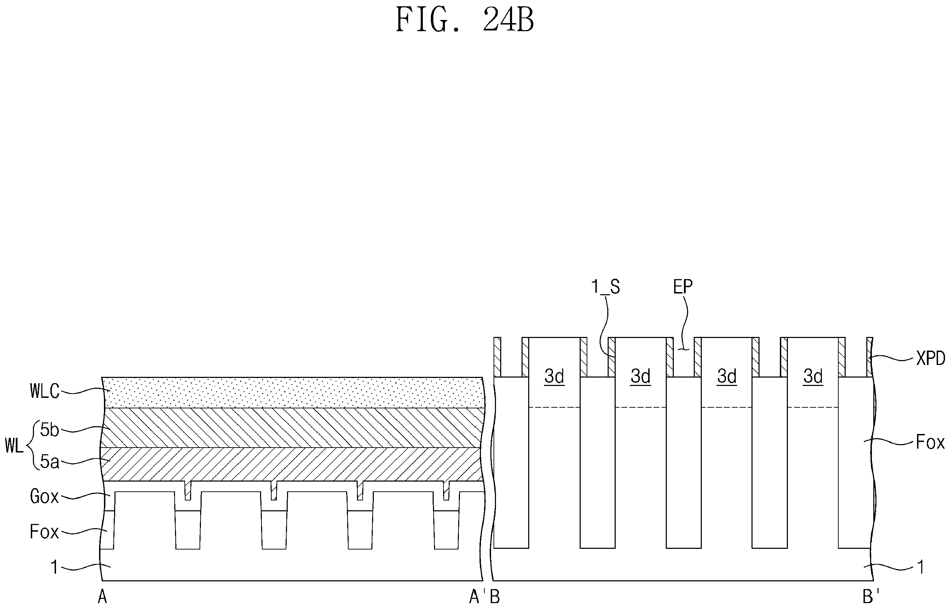

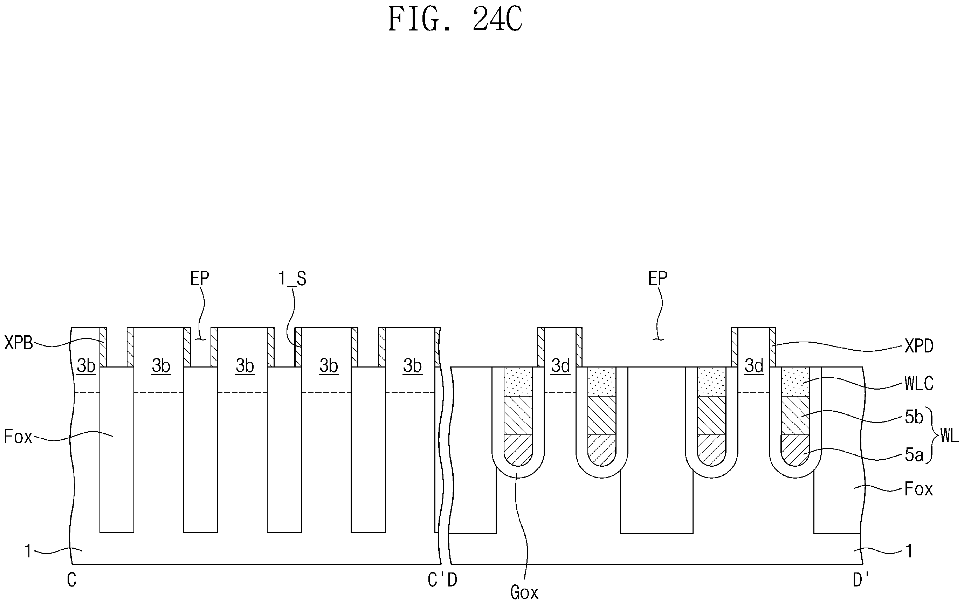

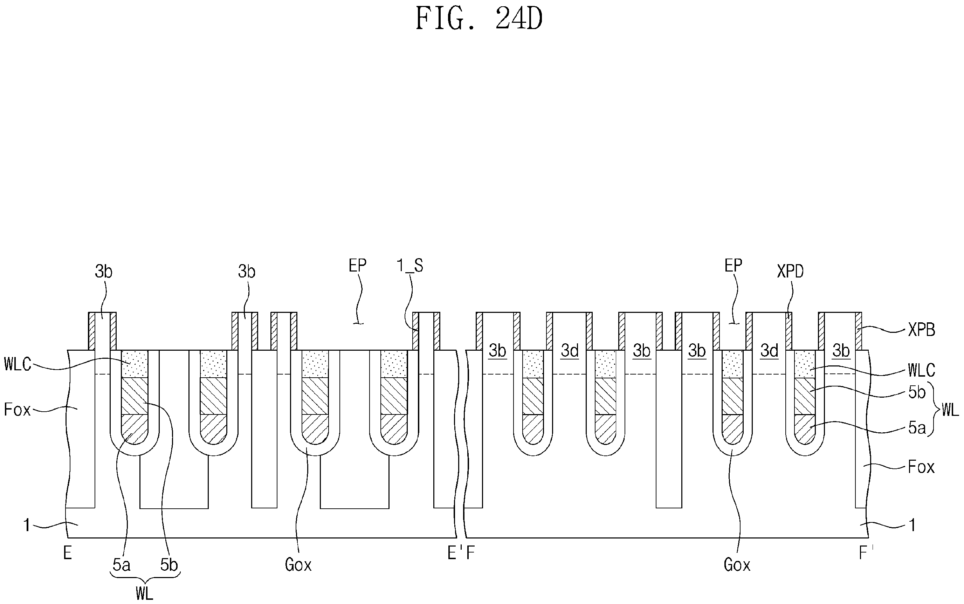

FIGS. 24A to 27A are plan views sequentially illustrating a process of manufacturing the semiconductor device of FIG. 22A. FIGS. 24B to 27B are cross-sectional views sequentially illustrating a process of manufacturing the semiconductor device of FIG. 22B. FIGS. 24C to 27C are cross-sectional views sequentially illustrating a process of manufacturing the semiconductor device of FIG. 22C. FIGS. 24D to 27D are cross-sectional views sequentially illustrating a process of manufacturing the semiconductor device of FIG. 22D.

Referring to FIGS. 24A to 24D, device isolation parts Fox may be formed on the substrate 1 to define active regions ACT. The active regions ACT and the device isolation part Fox may be patterned to form grooves GR1. The grooves GR1 may be located on opposite side of protruded portions of the substrate 1. In this case, etching conditions for the substrate 1 and the device isolation part Fox may be adjusted so that the device isolation part Fox is more easily etched than the substrate 1. As a result, bottom surfaces of the grooves GR1 may be curved. A gate insulating layer Gox may be conformally formed in the grooves GR1. Word lines WL and word line capping patterns WLC are formed in the grooves GR1. Dopants are implanted into the active regions ACT using the word line capping patterns WLC and the device isolation part Fox as a mask to form first and second impurity regions 3d and 3b.

Portions of the device isolation part Fox, gate insulating layer Gox, and word line capping patterns WLC are removed to expose an upper sidewall 1_S of the substrate 1. A pad layer is conformally deposited on the entire surface of the substrate 1 and then anisotropically etched to form first and second conductive pads XPD and XPB. The first and second conductive pads XPD and XPB are spaced apart from each other. Empty spaces EP are formed between the first and second conductive pads XPD and XPB.

Referring to FIGS. 25A to 25D, a pad separation layer is deposited on the entire surface of the substrate 1 to fill the empty spaces EP. The pad separation layer on the first and second conductive pads XPD and XPB is removed by performing an etch-back or planarization polishing process to form pad separation patterns SIP1 filling the empty spaces EP. In this case, upper surfaces of the first and second conductive pads XPD and XPB and the first and second impurity regions 3d and 3b may be exposed.

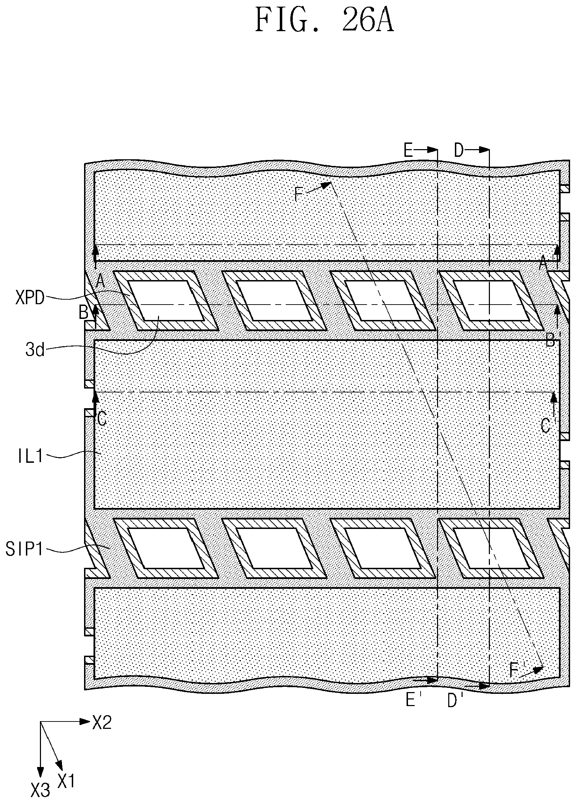

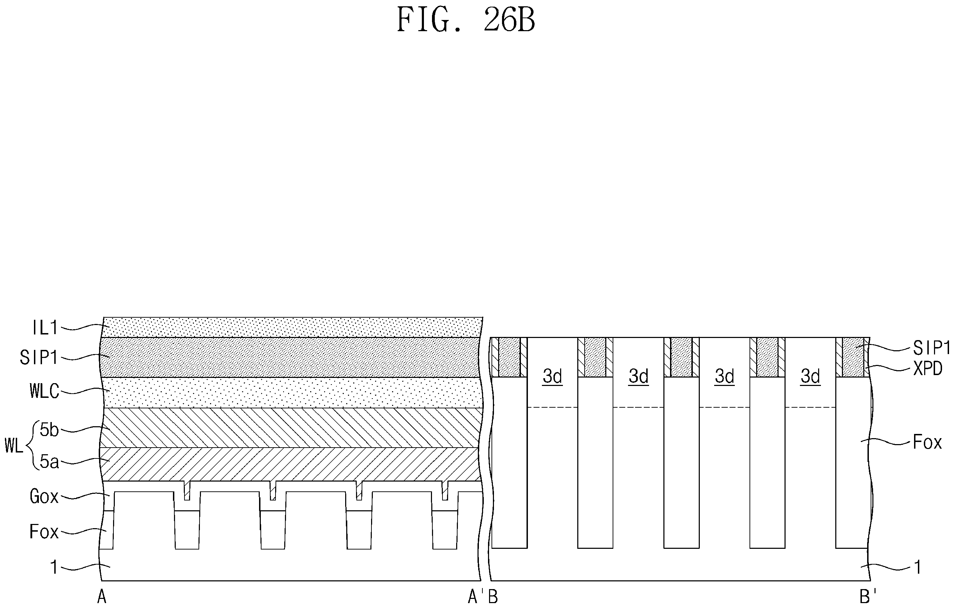

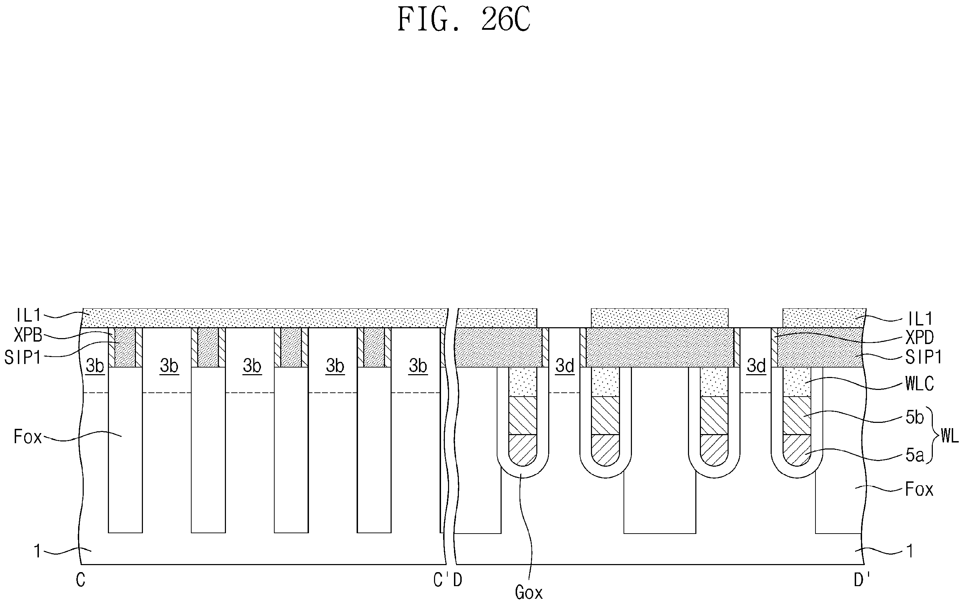

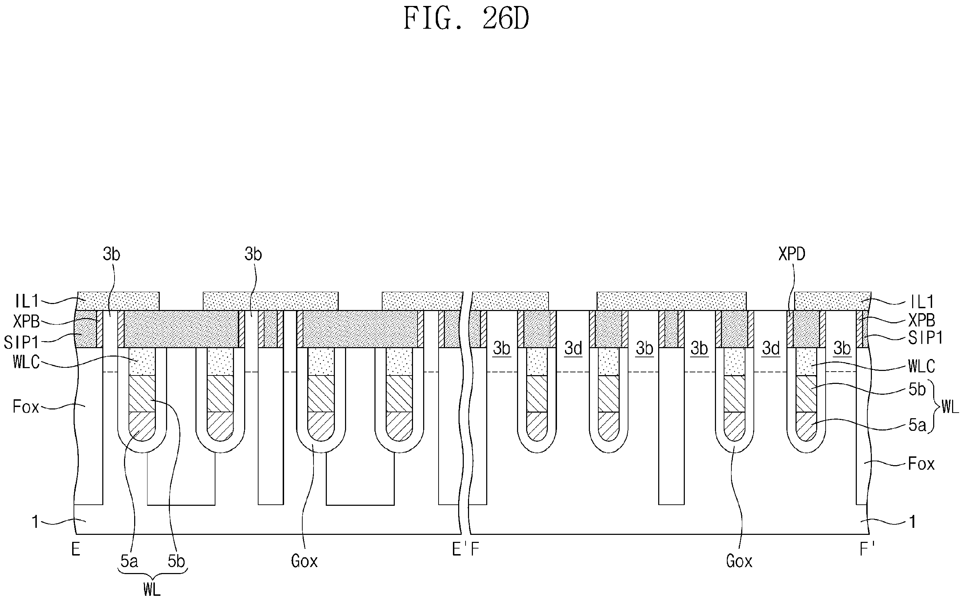

Referring to FIGS. 26A to 26D, first interlayer insulating layers IL1 are formed on the second conductive pads XPB and the first pad separation patterns SIP1. The first interlayer insulating layers IL1 may have a line shape extending in the second direction X2. Portions of the first conductive pads XPD, first impurity regions 3d, and first pad separation patterns SIP1 may be exposed between the first interlayer insulating layers IL1.

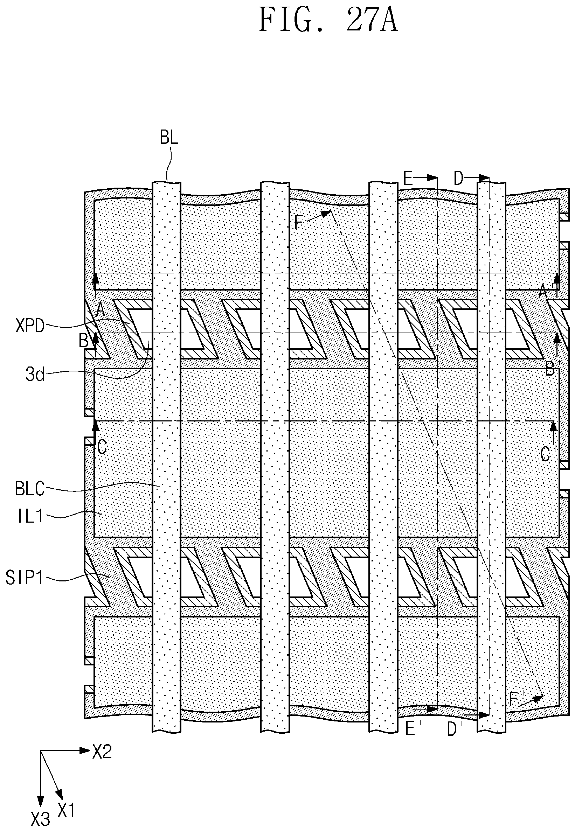

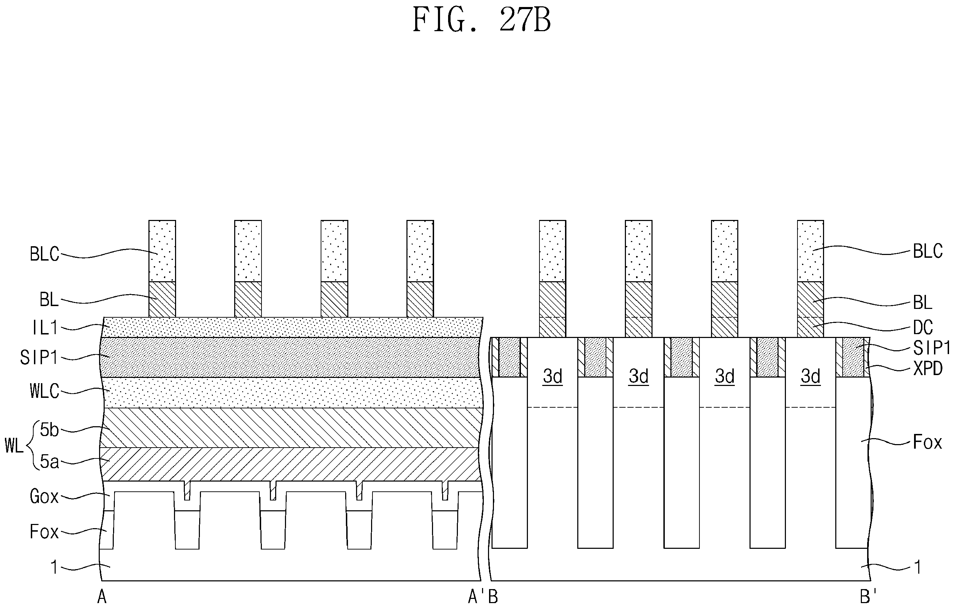

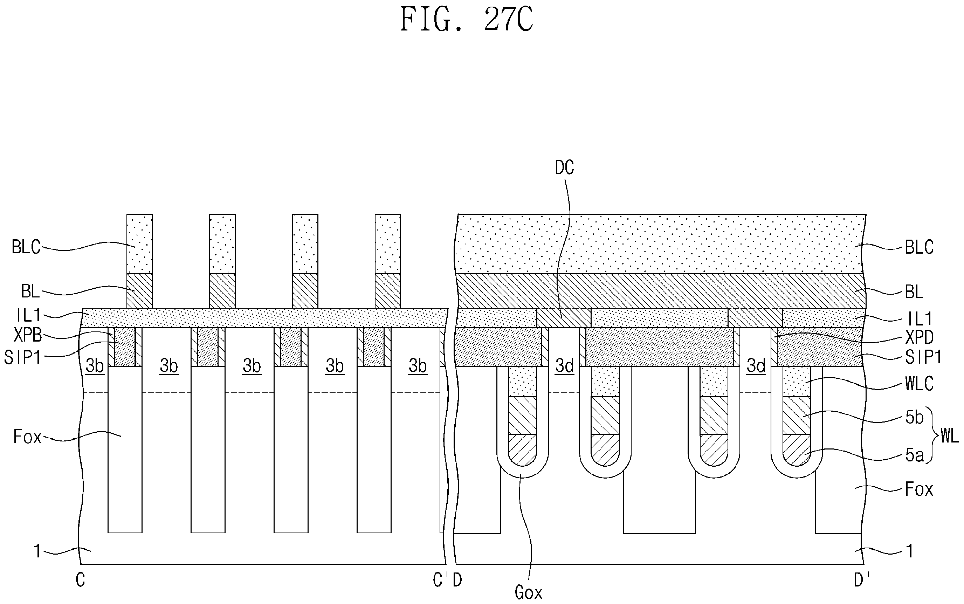

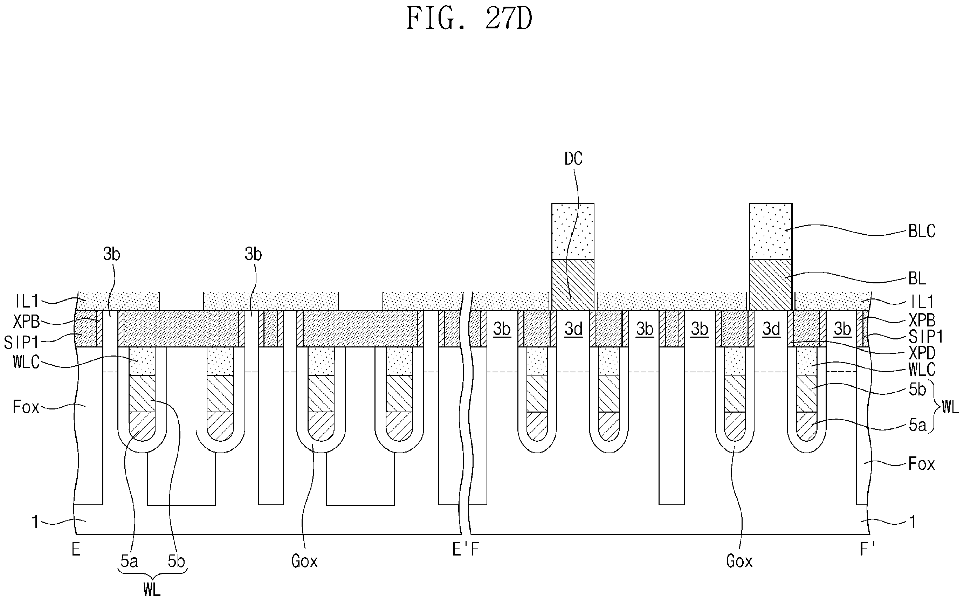

Referring to FIGS. 27A to 27D, a bit line conductive layer on the entire surface of the substrate 1 may be formed to fill a space between the first interlayer insulating layers IL1. A bit line capping layer is formed on the bit line conductive layer. Third mask patterns are formed on the bit line capping layer. The bit line capping layer and the bit line conductive layer are sequentially etched using the third mask patterns as an etch mask to form bit line capping patterns BLC and bit lines BL. A bit line contact DC may be formed under the bit lines BL. When viewed in a plan view, the bit line capping patterns BLC and the bit lines BL may have a line shape extending in the third direction X3. Portions of the first conductive pads XPD, first impurity regions 3d, and first pad separation patterns SIP1 may be exposed between the bit lines BL. Subsequently, the processes described above may be performed.

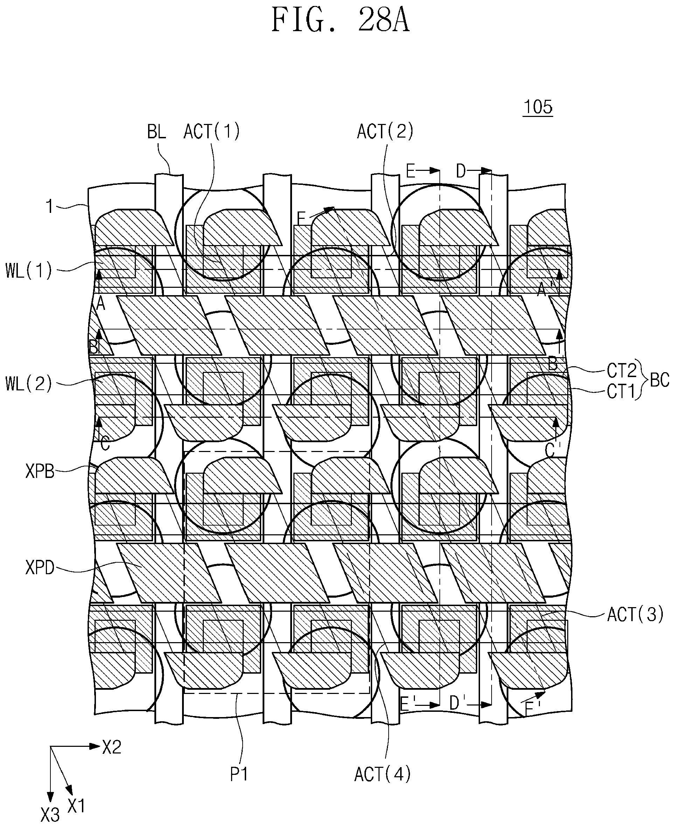

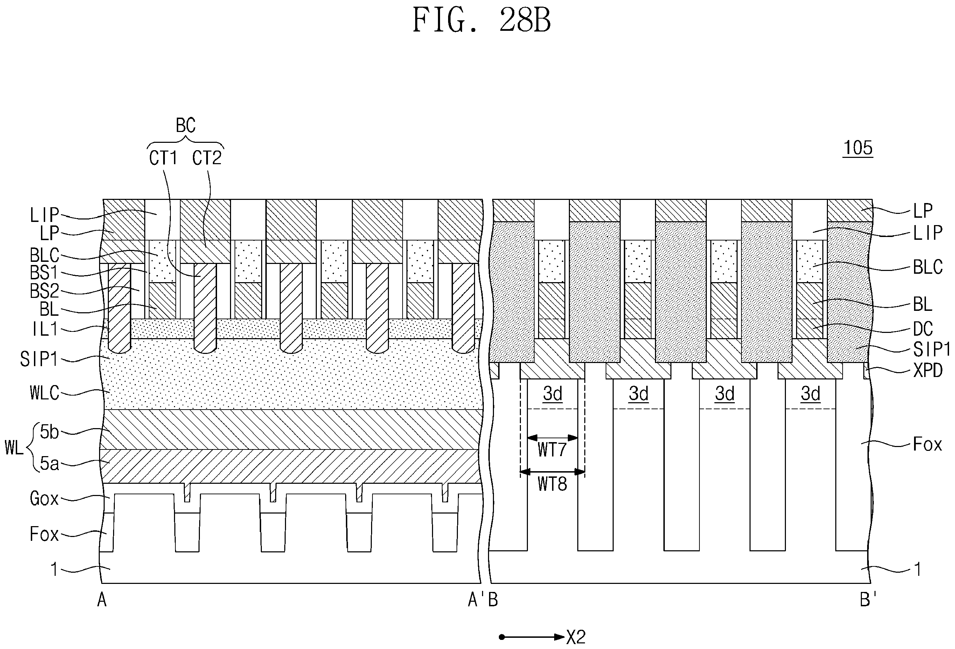

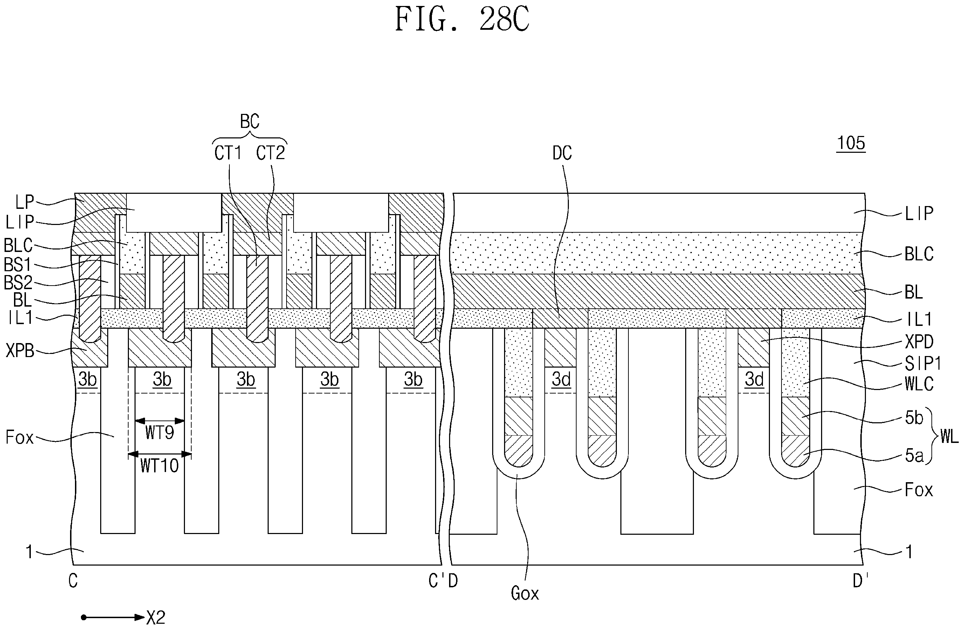

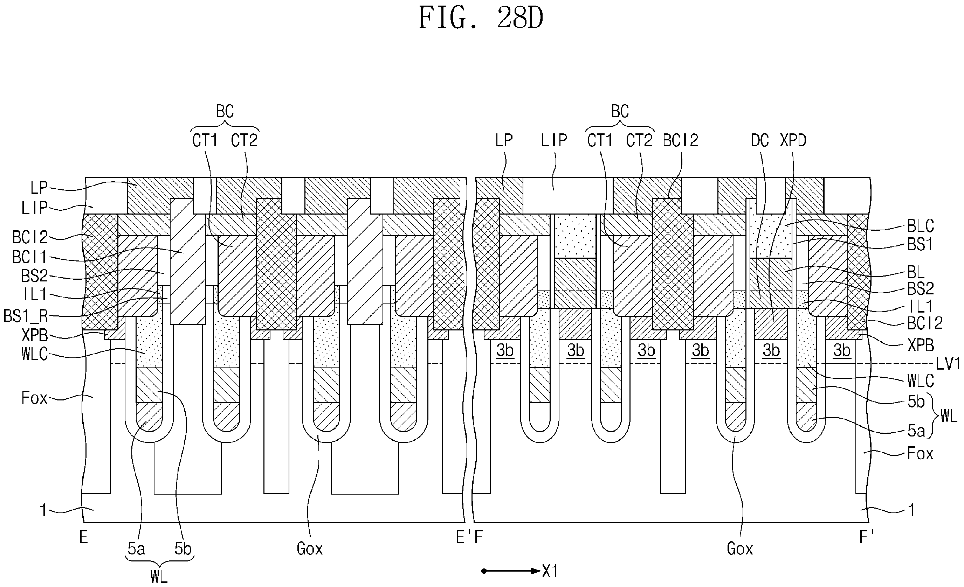

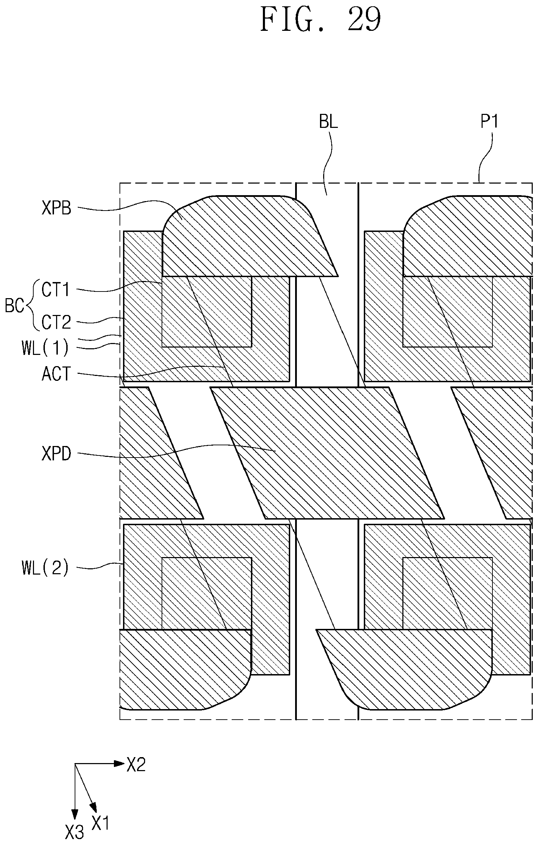

FIG. 28A is a plan view of a semiconductor device according to embodiments of the present disclosure. FIG. 28B is cross-sectional views of FIG. 28A taken along lines A-A' and B-B'. FIG. 28C includes cross-sectional views of FIG. 28A taken along lines C-C' and D-D'. FIG. 28D includes cross-sectional views of FIG. 28A taken along lines E-E' and F-F'. FIG. 29 is an enlarged view of'P1' portion 'P1' of FIG. 28A.

Referring to FIGS. 28A to 28D and 29, in a semiconductor device 105 according to the present embodiment, the first conductive pad XPD covers the first impurity region 3d, and the second conductive pad XPB covers the second impurity region 3d. The upper surface of the device isolation part Fox is higher than the upper surface of the substrate 1. The first impurity region 3d may have a seventh width WT7 in the second direction X2. The first conductive pad XPD may have an eighth width WT8 greater than the seventh width WT7 in the second direction X2. The second impurity region 3b may have a ninth width WT9 in the second direction X2. The second conductive pad XPB may have a tenth width WT10 greater than the ninth width WT9 in the second direction X2. Accordingly, a contact area between a bit line contact DC and a storage node contact structure BC to be formed later may be increased, and a misalignment margin may be increased. As a result, reliability of the semiconductor device 105 may be improved.

The first conductive pad XPD and the second conductive pad XPB may overlap the device isolation part Fox and the gate insulating layer Gox. The first conductive pad XPD and the second conductive pad XPB may be in contact with upper surfaces of the device isolation part Fox and gate insulating layer Gox.

The semiconductor device 105 according to the present embodiment does not include the first and second pad separation patterns SIP1 and SIP2 of FIGS. 2A to 2F. The device isolation part Fox is disposed between the first conductive pads XPD adjacent to each other in the second direction X2. The device isolation part Fox is disposed between the second conductive pads XPB adjacent to each other in the second direction X2. A word line capping pattern WLC is disposed between the first conductive pad XPD and the second conductive pad XPB adjacent to each other in the first direction X1.

The first conductive pads XPD, the second conductive pads XPB, and the device isolation part Fox may be covered with a first interlayer insulating layer IL1. Bit lines BL are disposed on the first interlayer insulating layer IL1. The bit lines BL may extend in the third direction X3 and may be spaced apart from each other in the second direction X2. The bit lines BL may cross word line capping patterns WLC and word lines WL.

A bit line contact DC may be disposed between the bit lines BL and the first impurity region 3d. The bit line contact DC may be in contact with the first conductive pad XPD. The bit line contact DC may also be in contact with the gate insulating layer Gox. The storage node contact structure BC vertically overlaps the second conductive pad XPB. First and second contact separation patterns BCI1 and BCI2 are alternately and repeatedly disposed between the storage node contact structures BC in the third direction X3. The first contact separation pattern BCI1 may be inserted into the device isolation part Fox. Other structures may be the same/similar to those described above.

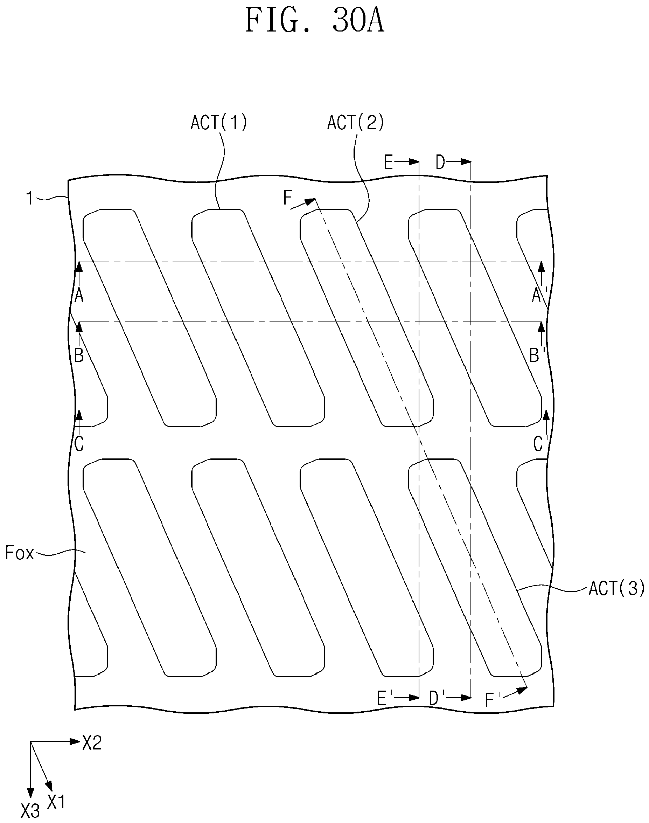

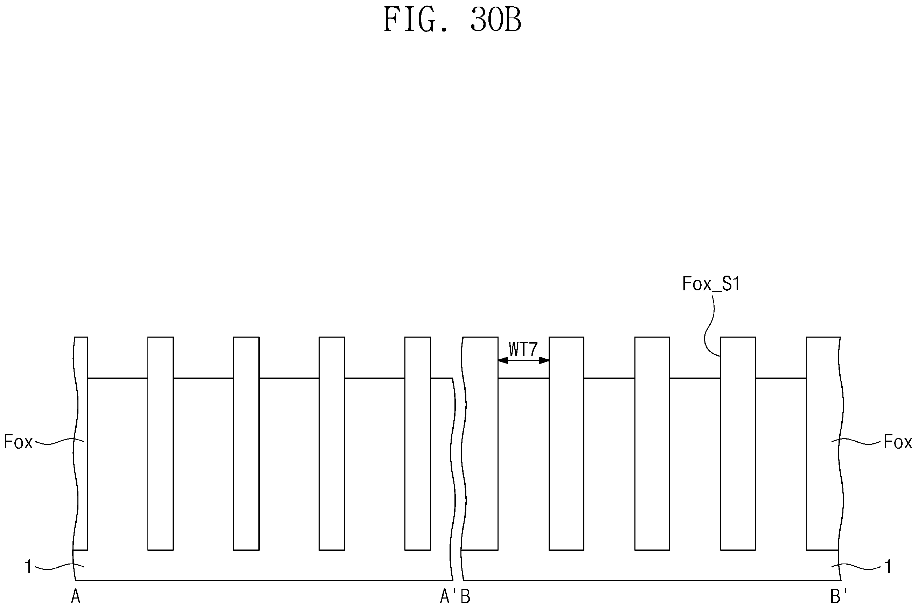

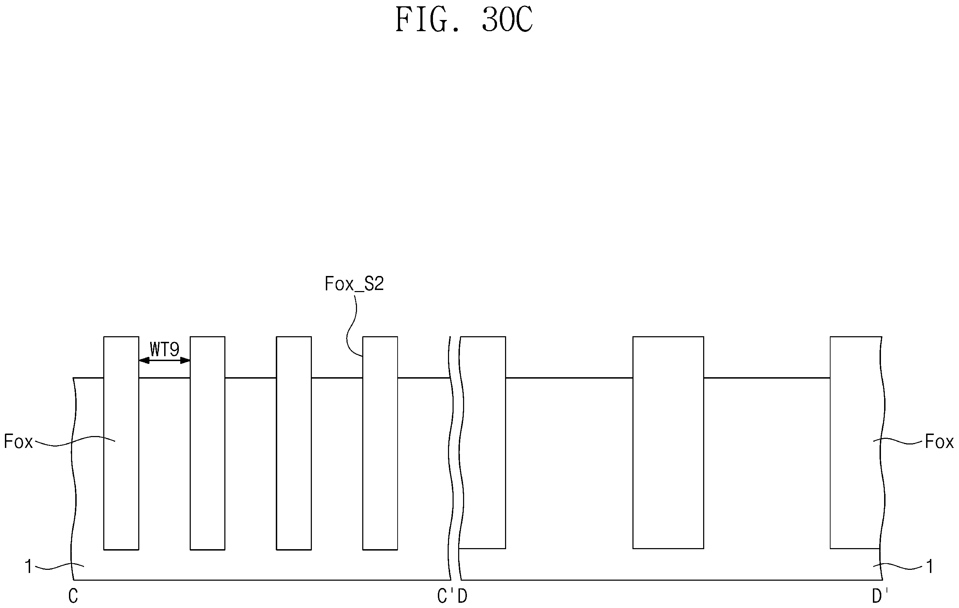

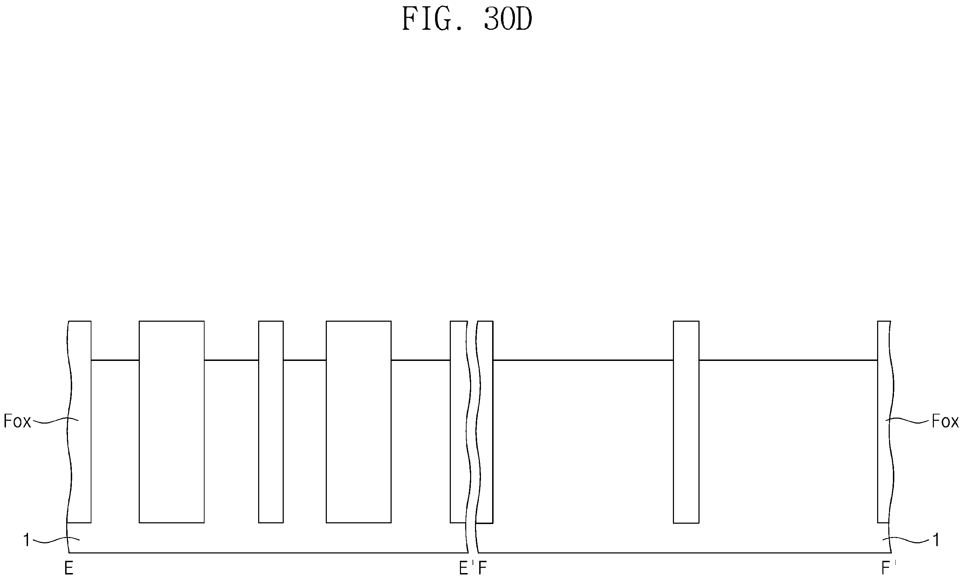

FIGS. 30A to 34A are plan views sequentially illustrating a process of manufacturing the semiconductor device of FIG. 28A. FIGS. 30B to 34B are cross-sectional views sequentially illustrating a process of manufacturing the semiconductor device of FIG. 28B. FIGS. 30C to 34C are cross-sectional views sequentially illustrating a process of manufacturing the semiconductor device of FIG. 28C. FIGS. 30D to 34D are cross-sectional views sequentially illustrating a process of manufacturing the semiconductor device of FIG. 28D.

Referring to FIGS. 30A to 30D, device isolation parts Fox may be formed on the substrate 1 to define active regions ACT. A portion of the substrate 1 is removed to expose upper sidewalls Fox_S1 and Fox_S2 of the device isolation part Fox. For example, in the cross section B-B' of FIG. 30B, a distance between the first upper sidewalls Fox_S1 of the device isolation part Fox may be equal to the seventh width WT7. In the cross section C-C' of FIG. 30C, a distance between the second upper sidewalls Fox_S2 of the device isolation part Fox may be equal to the ninth width WT9.

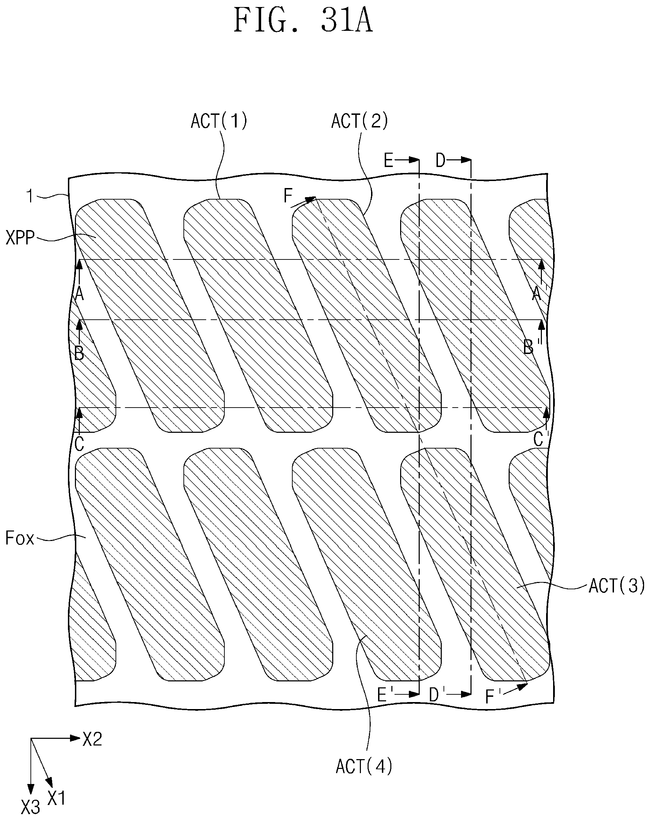

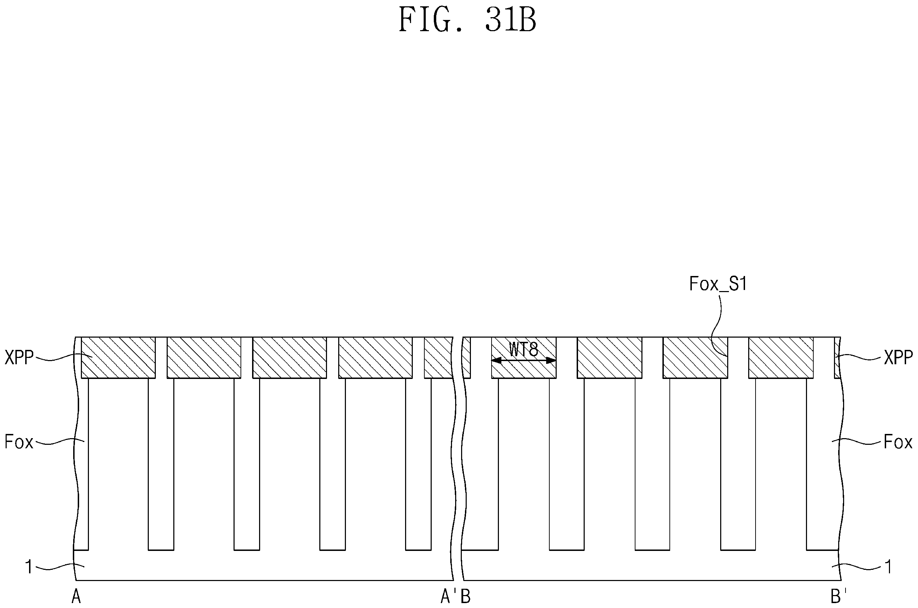

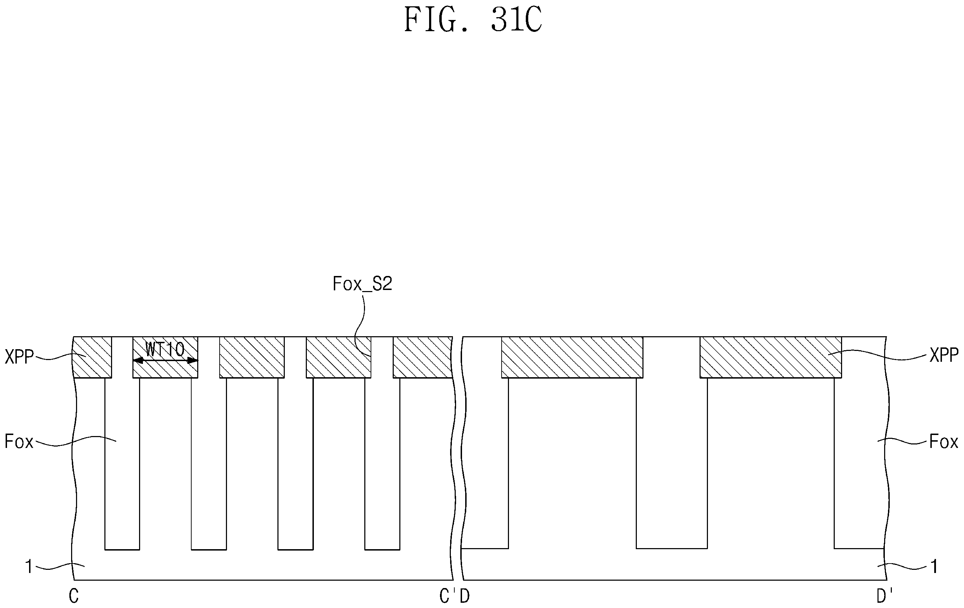

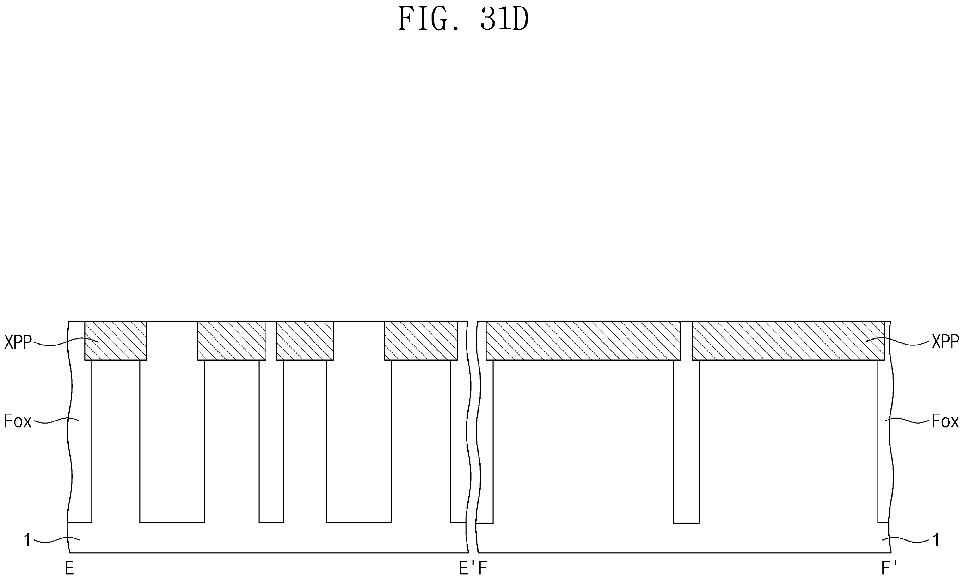

Referring to FIGS. 31A to 31D, an isotropic etching process is performed to remove side portions of the device isolation part Fox to widen a space between upper portions of the device isolation part Fox. Accordingly, a gap between the first upper sidewalls Fox_S1 of the device isolation part Fox in the cross section B-B' of FIG. 31B may be widened to an eighth width WT8 greater than the seventh width WT7. In addition, in the cross section C-C' of FIG. 31C, a gap between the second upper sidewalls Fox_S2 of the device isolation part Fox may be widened to a tenth width WT10 greater than the ninth width WT9. A pad layer is deposited on the entire surface of the substrate 1 to fill a space between upper portions of the device isolation part Fox. An etch-back or planarization polishing process is performed on the pad layer to remove the pad layer on the device isolation part Fox, and thus a preliminary pad pattern XPP is formed. The preliminary pad pattern XPP may have the same planar shape as the active regions ACT. The preliminary pad pattern XPP may be disposed on protruded portions of the substrate 1 between the device isolation part Fox.

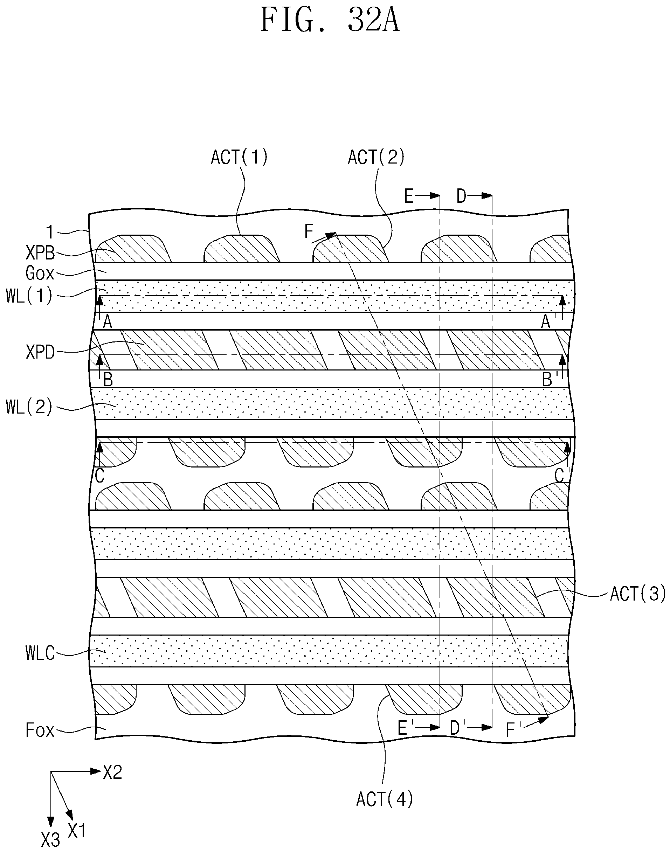

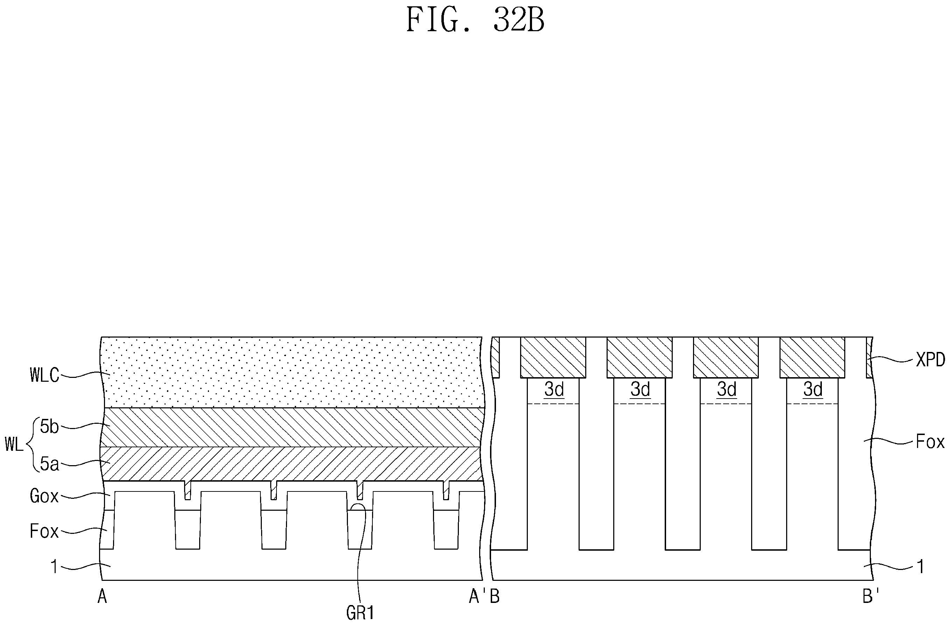

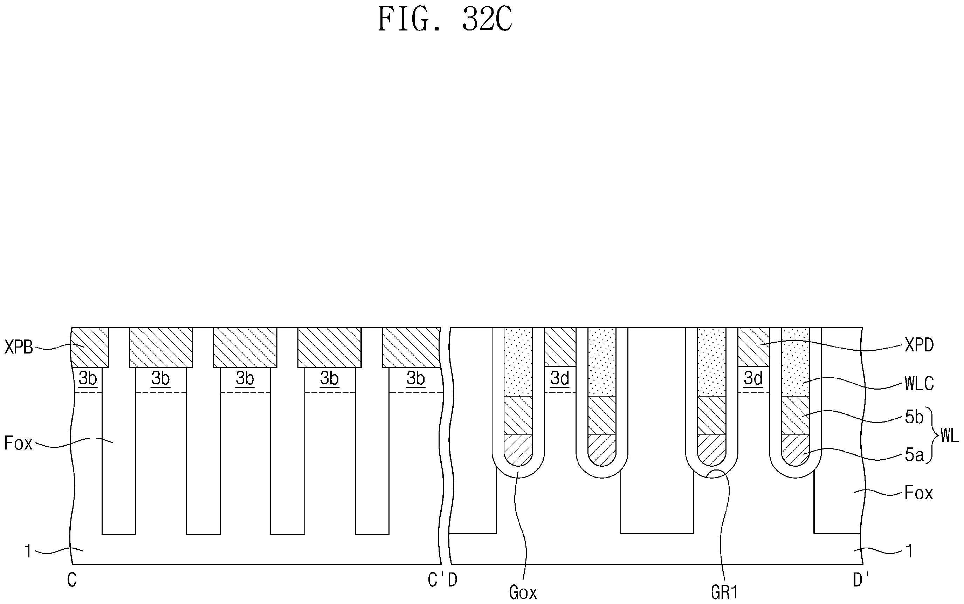

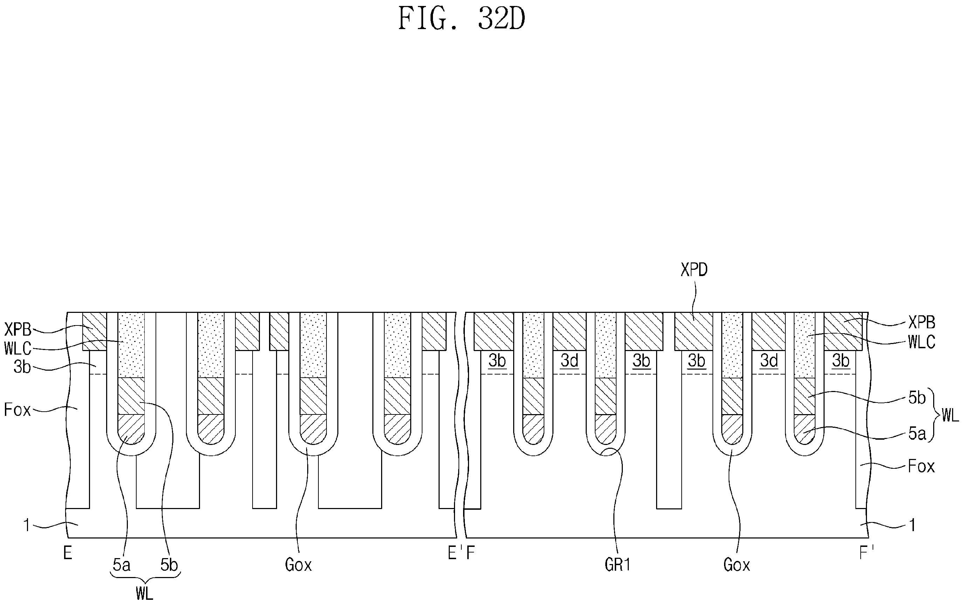

Referring to FIGS. 32A to 32D, the preliminary pad pattern XPP, the substrate 1 and the device isolation part Fox may be patterned to form grooves GR1. The preliminary pad pattern XPP may be patterned to form first and second conductive pads XPD and XPB. Etching conditions for the substrate 1 and the device isolation part Fox may be adjusted so that the device isolation part Fox is more easily etched than the substrate 1. As a result, bottom surfaces of the grooves GR1 may be curved. A gate insulating layer Gox may be conformally formed in the grooves GR1 . Word lines WL and word line capping patterns WLC are formed in the grooves GR1. Dopants are implanted into the active regions ACT using the word line capping patterns WLC and the device isolation part Fox as a mask to form first and second impurity regions 3d and 3b. The first and second impurity regions 3d and 3b may be disposed between adjacent grooves GR1.

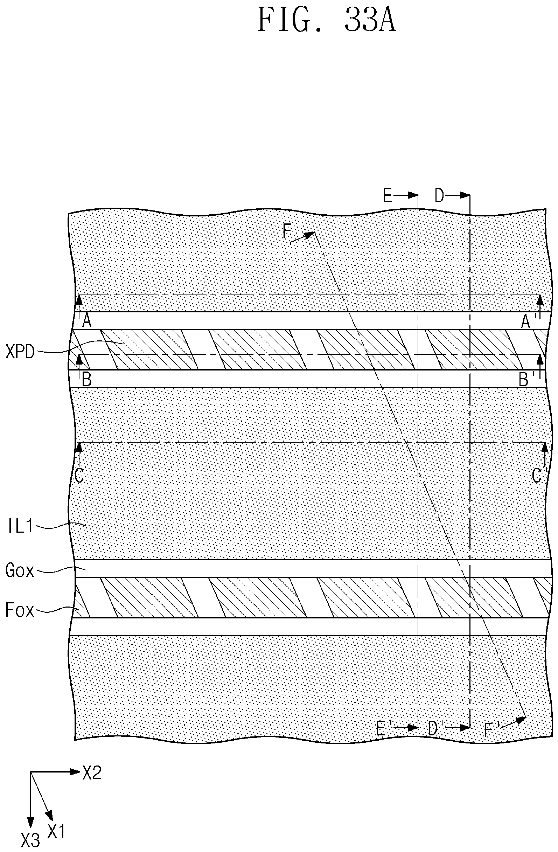

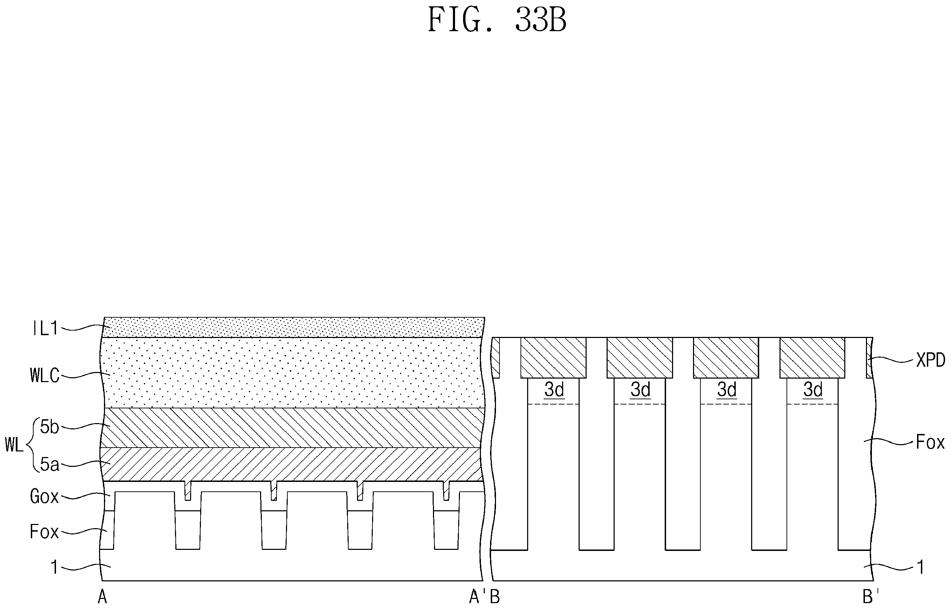

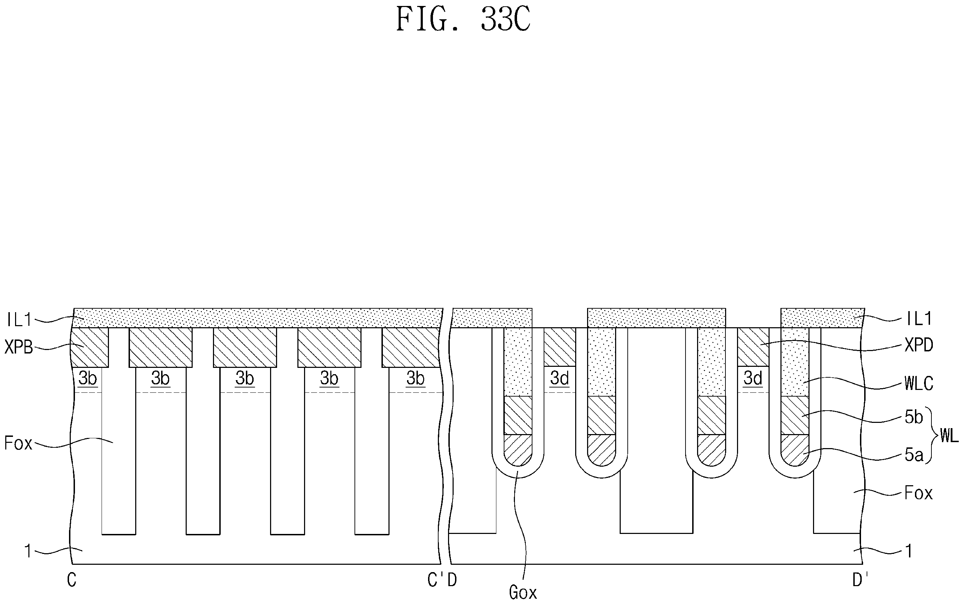

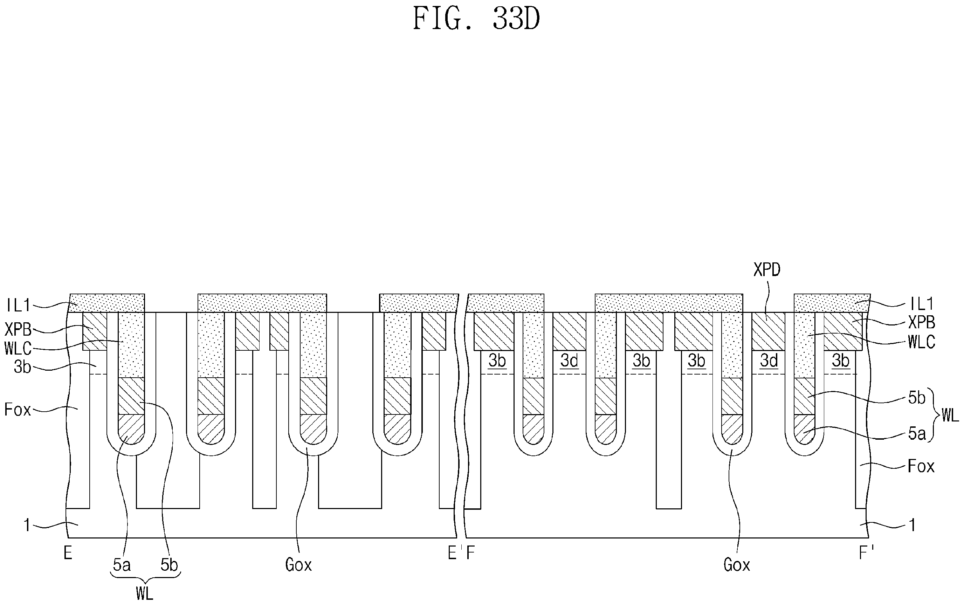

Referring to FIGS. 33A to 33D, first interlayer insulating layers IL1 are formed on the second conductive pads XPB and the first pad separation patterns SIP1. The first interlayer insulating layers IL1 are further formed on the word line capping patterns WLC. The first interlayer insulating layers IL1 may have a line shape extending in the second direction X2. Portions of the first conductive pads XPD, first impurity regions 3d, gate insulating layer Gox, and device isolation part Fox may be exposed between the first interlayer insulating layers IL1.

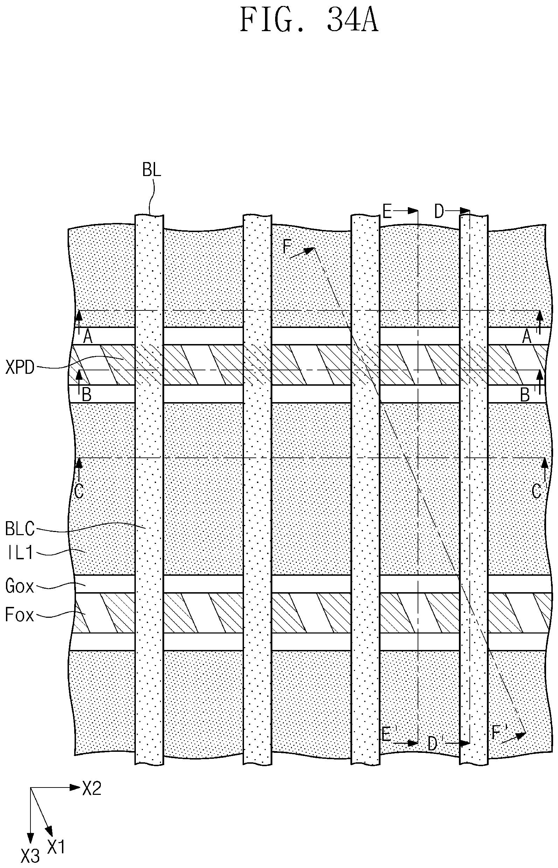

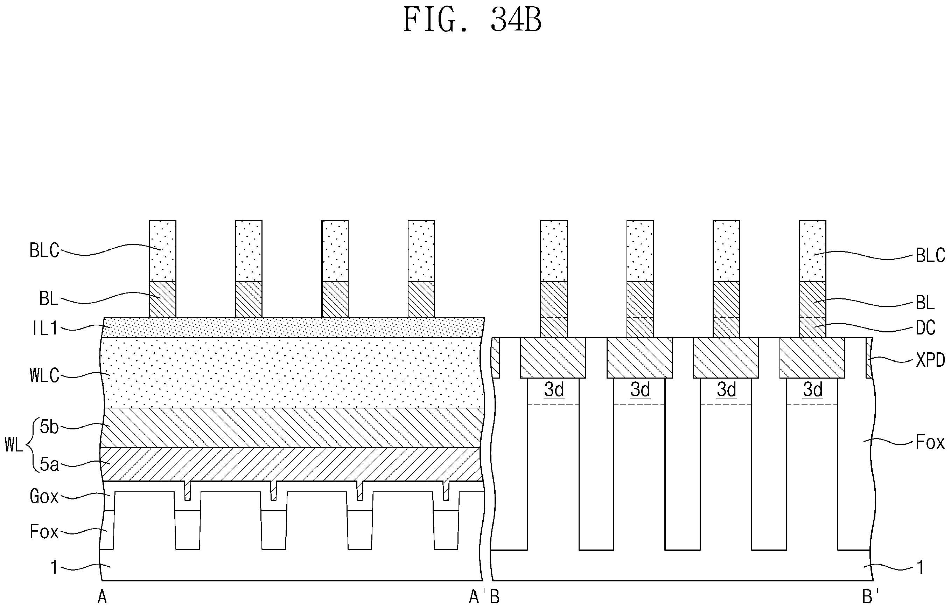

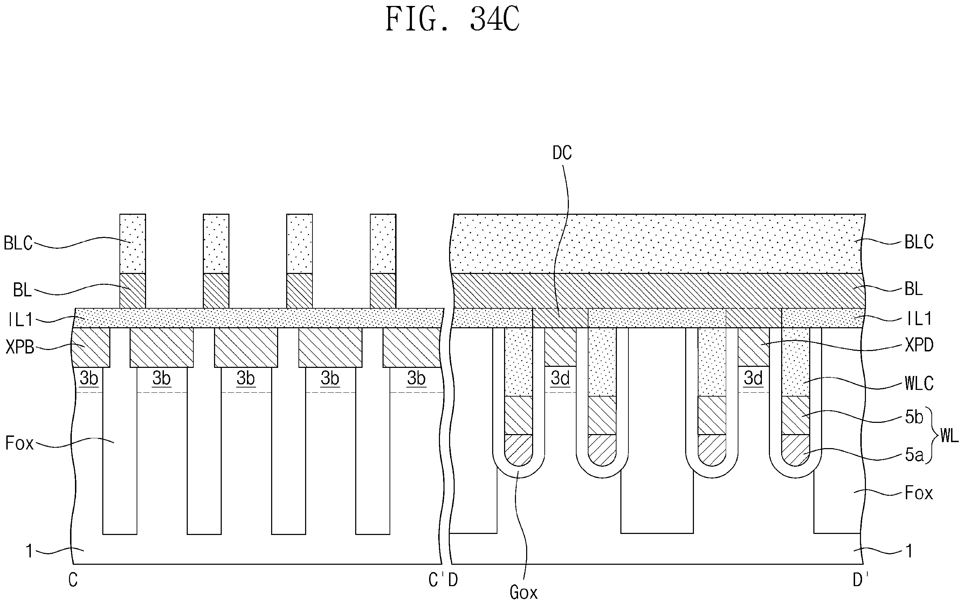

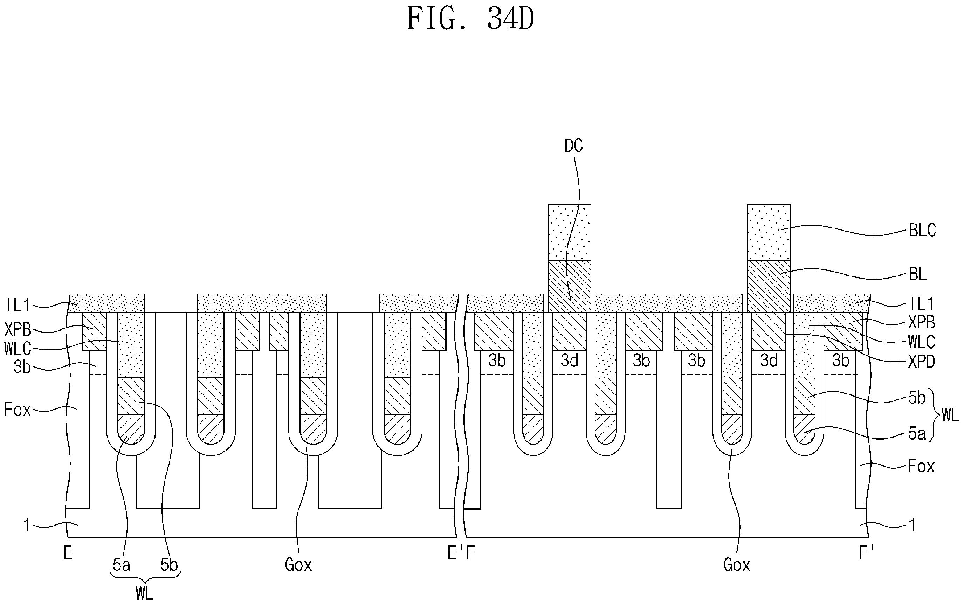

Referring to FIGS. 34A to 34D, a bit line conductive layer may be formed on the entire surface of the substrate 1 to fill a space between the first interlayer insulating layers IL1. A bit line capping layer is formed on the bit line conductive layer. Third mask patterns are formed on the bit line capping layer. The bit line capping layer and the bit line conductive layer are sequentially etched using the third mask patterns as an etch mask to form bit line capping patterns BLC and bit lines BL. A bit line contact DC may be formed under the bit lines BL. When viewed in a plan view, the bit line capping patterns BLC and the bit lines BL may have a line shape extending in the third direction X3. Portions of the first conductive pads XPD, first impurity regions 3d, and device isolation part Fox may be exposed between the bit lines BL. Subsequently, the processes described above may be performed.

The semiconductor device according to embodiments of the present disclosure has the array of the active regions with the improved misalignment margin. In addition, the conductive pads which are in contact with the bit line contact and the storage node contact structures, respectively, may be provided, thereby improving the misalignment margin. Accordingly, the reliability of the semiconductor device may be improved.

While embodiments are described above, a person skilled in the art may understand that many modifications and variations may be made thereto without departing from the spirit and scope of the present disclosure set forth in the following claims. Accordingly, the example embodiments of the present disclosure should be considered in all respects as illustrative and not restrictive. The embodiments of Figs. 1A to 34D may be combined with each other.

## Claims

1. A semiconductor device comprising:
a device isolation part disposed on a substrate to define first, second, third and fourth active regions sequentially arranged in a clockwise direction, the first to fourth active regions extending in a first direction, and the device isolation part extending in a second direction intersecting the first direction and being interposed between the first and second active regions and the third and fourth active regions;
first and second word lines crossing the first and second active regions in the second direction and being adjacent to each other in a third direction intersecting the first and second directions;
a first impurity region disposed in the first active region between the first and second word lines;
a second impurity region disposed in the first active region at one side of the first word line and spaced apart from the first impurity region;
a first conductive pad in contact with the first impurity region;
a second conductive pad in contact with the second impurity region;
a bit line disposed on the first conductive pad and extending in the third direction;
a storage node contact structure disposed on the second conductive pad; and
a landing pad disposed on the storage node contact structure.

2. The semiconductor device of claim 1, wherein the device isolation part includes:
a first device isolation part interposed between the first and second active regions and extending in the first direction; and
a second device isolation part interposed between the first and fourth active regions and between the second and third active regions and extending in the second direction.

3. The semiconductor device of claim 1, further comprising a dummy word line disposed in the device isolation part between the first and fourth active regions and between the second and third active regions,
wherein the dummy word line is electrically grounded or floated.

4. The semiconductor device of claim 1, wherein the storage node contact structure includes:
a first contact contacting the second conductive pad and having a first width; and
a second contact disposed on the first contact and having a second width greater than the first width.

5. The semiconductor device of claim 4, further comprising:
a first interlayer insulating pattern interposed between the bit line and the second conductive pad;
a bit line capping pattern on the bit line;
a first bit line spacer covering the bit line capping pattern and sidewalls of the bit line; and
a second bit line spacer covering a lower sidewall of the first bit line spacer and exposing an upper sidewall of the first bit line spacer,
wherein the first contact is spaced apart from the first bit line spacer, and
wherein the second contact is in contact with an upper end of the second bit line spacer and the first bit line spacer.

6. The semiconductor device of claim 5, wherein the storage node contact structure is provided in plural,
wherein the semiconductor device further includes:
first, second and third storage node contact structures spaced apart from each other in the third direction;
a first contact separation pattern interposed between the first and second storage node contact structures; and
a second contact separation pattern interposed between the second and third storage node contact structures, and
wherein the second bit line spacer is interposed between the first contact separation pattern and the first storage node contact structure, and is in contact with the first storage node contact structure.

7. The semiconductor device of claim 1, further comprising a gate insulating layer interposed between the first word line and the substrate,
wherein the second conductive pad overlaps the gate insulating layer, and
wherein the storage node contact structure overlaps the first word line.

8. The semiconductor device of claim 1, wherein, when viewed in a plan view, each of the first to fourth active regions includes:
first and second sidewalls parallel to each other in the first direction;
a third sidewall connecting the first and second sidewalls;
a first corner where the first sidewall and the third sidewall meet; and
a second corner where the second sidewall and the third sidewall meet,
wherein the first sidewall and the third sidewall form an acute angle with each other, and
wherein the second sidewall and the third sidewall form an obtuse angle with each other.

9. The semiconductor device of claim 1, wherein at least one of the first conductive pad and the second conductive pad includes:
a first silicon pattern in contact with the substrate; and
a first ohmic pattern on the first silicon pattern.

10. The semiconductor device of claim 1, further comprising a bit line contact disposed between the bit line and the first conductive pad,
wherein the bit line contact has a first width in the third direction, and
wherein the first conductive pad has a second width in the third direction, the second width being smaller than the first width.

11. The semiconductor device of claim 1, wherein the first conductive pad is provided in plural and disposed on the first and second active regions,
wherein the semiconductor device further includes:
a first pad separation pattern disposed between the first conductive pad and the second conductive pad; and
a second pad separation pattern interposed between the first conductive pad on the first active region and the first conductive pad on the second active region.

12. The semiconductor device of claim 11, wherein the first pad separation pattern is in contact with a first sidewall of the substrate,
wherein the second conductive pad is in contact with a second sidewall of the substrate, and
wherein the first sidewall is spaced apart from the second sidewall.

13. The semiconductor device of claim 12, wherein the substrate further includes a third sidewall adjacent to the second sidewall, and
wherein the second conductive pad is in contact with the third sidewall.

14. The semiconductor device of claim 1, wherein an upper surface of the device isolation part is lower than an upper surface of the substrate to expose a first sidewall and a second sidewall of the substrate,
wherein the first conductive pad is in contact with the first sidewall of the substrate and surrounds the first impurity region when viewed in a plan view, and
wherein the second conductive pad is in contact with the second sidewall of the substrate and surrounds the second impurity region when viewed in a plan view.

15. The semiconductor device of claim 1, wherein the first conductive pad is in contact with an upper surface of the first impurity region, and
wherein the second conductive pad is in contact with an upper surface of the second impurity region.
